# EUROPEAN PATENT APPLICATION

(11) **EP 4 001 477 A1**
(43) Date of publication of application: **25.05.2022**
(21) Application number: 20841024.1
(22) Date of filing: 17.07.2020
(51) Int. Cl.: C30B 29/06, C30B 11/00, H01L 31/036, H01L 31/068

(54) **SILICON INGOT, SILICON BLOCK, SILICON SUBSTRATE, SILICON INGOT PRODUCTION METHOD, AND SOLAR CELL**

(30) Priority: 18.07.2019 JP 2019132730
(71) Applicant: Kyocera Corporation, Kyoto-shi Kyoto 612-8501 (JP)
(72) Inventor: OGASHIWA Youhei, Kyoto-shi, Kyoto 612-8501 (JP)
(74) Representative: Viering, Jentschura & Partner mbB Patent- und Rechtsanwälte
(86) International application number: PCT/JP2020/027856
(87) International publication number: WO 2021/010468

(57) **Abstract**

An ingot having a first surface, a second surface opposite to the first surface, and a third surface connecting the first surface and the second surface in a first direction includes a first mono-like crystalline portion, a first intermediate portion including a mono-like crystalline section, a second mono-like crystalline portion, a second intermediate portion including a mono-like crystalline section, and a third mono-like crystalline portion. The first mono-like crystalline portion, the first intermediate portion, and the second mono-like crystalline portion are adjacent to one another in sequence in a second direction perpendicular to the first direction. The first mono-like crystalline portion, the second intermediate portion, and the third mono-like crystalline portion are adjacent to one another in sequence in a third direction perpendicular to the first direction and crossing the second direction. The first mono-like crystalline portion and the second mono-like crystalline portion have a greater width than the first intermediate portion in the second direction. The first mono-like crystalline portion and the third mono-like crystalline portion have a greater width than the second intermediate portion in the third direction. Boundaries between the first mono-like crystalline portion and the first intermediate portion and between the second mono-like crystalline portion and the first intermediate portion, and boundaries between the first mono-like crystalline portion and the second intermediate portion and between the third mono-like crystalline portion and the second intermediate portion each include a coincidence boundary.

## Description

### FIELD

The present disclosure relates to a silicon ingot, a silicon block, a silicon substrate, a manufacturing method for a silicon ingot, and a solar cell.

### BACKGROUND

Solar cells using polycrystalline silicon substrates (polycrystalline silicon solar cells) have relatively high conversion efficiency and are easy to mass-manufacture.

Such polycrystalline silicon substrates used in polycrystalline silicon solar cells are obtained typically by manufacturing a silicon ingot by casting, cutting the ingot into blocks, and then slicing the blocks. In casting, a bulk of polycrystalline silicon is grown in a mold upward from the bottom using silicon melt.

Mono-like casting has been developed as a type of casting (refer to, for example, Japanese Patent No. 5486190 and Dongli Hu; Shuai Yuan; Liang He; Hongrong Chen; Yuepeng Wan; Xuegong Yu; Deren Yang, Higher Quality Mono-like Cast Silicon with Induced Grain Boundaries. Solar Energy Materials and Solar Cells 2015, 140, 121-125.). In mono-like casting, crystal grains are grown upward from a seed crystal placed on the bottom of a mold using silicon melt. The resulting silicon grains inherit the crystal orientation of the seed crystal to be a crystal like a monocrystal (mono-like crystal). A solar cell including a substrate of this mono-like crystalline silicon is expected to achieve higher conversion efficiency than polycrystalline silicon solar cells.

### BRIEF SUMMARY

A silicon ingot, a silicon block, a silicon substrate, a manufacturing method for a silicon ingot, and a solar cell are described.

A silicon ingot according to one aspect of the present disclosure has a first surface, a second surface opposite to the first surface, and a third surface extending in a first direction and connecting the first surface and the second surface. The silicon ingot includes a first mono-like crystalline portion, a first intermediate portion including one or more mono-like crystalline sections, a second mono-like crystalline portion, a second intermediate portion including one or more mono-like crystalline sections, and a third mono-like crystalline portion. The first mono-like crystalline portion, the first intermediate portion, and the second mono-like crystalline portion are adjacent to one another in sequence in a second direction perpendicular to the first direction. The first mono-like crystalline portion, the second intermediate portion, and the third mono-like crystalline portion are adjacent to one another in sequence in a third direction perpendicular to the first direction and crossing the second direction. A first width of the first mono-like crystalline portion and a second width of the second mono-like crystalline portion each are greater than a third width of the first intermediate portion in the second direction. A fourth width of the first mono-like crystalline portion and a fifth width of the third mono-like crystalline portion each are greater than a sixth width of the second intermediate portion in the third direction. A boundary between the first mono-like crystalline portion and the first intermediate portion, a boundary between the second mono-like crystalline portion and the first intermediate portion, a boundary between the first mono-like crystalline portion and the second intermediate portion, and a boundary between the third mono-like crystalline portion and the second intermediate portion each include a coincidence boundary.

A silicon block according to one aspect of the present disclosure has a fourth surface, a fifth surface opposite to the fourth surface, and a sixth surface extending in a first direction and connecting the fourth surface and the fifth surface. The silicon block includes a fifth mono-like crystalline portion, a fifth intermediate portion including one or more mono-like crystalline sections, a sixth mono-like crystalline portion, a sixth intermediate portion including one or more mono-like crystalline sections, and a seventh mono-like crystalline portion. The fifth mono-like crystalline portion, the fifth intermediate portion, and the sixth mono-like crystalline portion are adjacent to one another in sequence in a second direction perpendicular to the first direction. The fifth mono-like crystalline portion, the sixth intermediate portion, and the seventh mono-like crystalline portion are adjacent to one another in sequence in a third direction perpendicular to the first direction and crossing the second direction. A thirteenth width of the fifth mono-like crystalline portion and a fourteenth width of the sixth mono-like crystalline portion each are greater than a fifteenth width of the fifth intermediate portion in the second direction. A sixteenth width of the fifth mono-like crystalline portion and a seventeenth width of the seventh mono-like crystalline portion each are greater than an eighteenth width of the sixth intermediate portion in the third direction. A boundary between the fifth mono-like crystalline portion and the fifth intermediate portion, a boundary between the sixth mono-like crystalline portion and the fifth intermediate portion, a boundary between the fifth mono-like crystalline portion and the sixth intermediate portion, and a boundary between the seventh mono-like crystalline portion and the sixth intermediate portion each include a coincidence boundary.

A silicon substrate according to one aspect of the present disclosure has a seventh surface, an eighth surface opposite to the seventh surface, and a ninth surface extending in a first direction and connecting the seventh surface and the eighth surface. The silicon substrate includes a ninth mono-like crystalline portion, a ninth intermediate portion including one or more mono-like crystalline sections, a tenth mono-like crystalline portion, a tenth intermediate portion including one or more mono-like crystalline sections, and an eleventh mono-like crystalline portion. The ninth mono-like crystalline portion, the ninth intermediate portion, and the tenth mono-like crystalline portion are adjacent to one another in sequence in a second direction perpendicular to the first direction. The ninth mono-like crystalline portion, the tenth intermediate portion, and the eleventh mono-like crystalline portion are adjacent to one another in sequence in a third direction perpendicular to the first direction and crossing the second direction. A twenty-fifth width of the ninth mono-like crystalline portion and a twenty-sixth width of the tenth mono-like crystalline portion each are greater than a twenty-seventh width of the ninth intermediate portion in the second direction. A twenty-eighth width of the ninth mono-like crystalline portion and a twenty-ninth width of the eleventh mono-like crystalline portion each are greater than a thirtieth width of the tenth intermediate portion in the third direction. A boundary between the ninth mono-like crystalline portion and the ninth intermediate portion, a boundary between the tenth mono-like crystalline portion and the ninth intermediate portion, a boundary between the ninth mono-like crystalline portion and the tenth intermediate portion, and a boundary between the eleventh mono-like crystalline portion and the tenth intermediate portion each include a coincidence boundary.

A manufacturing method for a silicon ingot according to one aspect of the present disclosure includes preparing, arranging, pouring or melting, and unidirectionally solidifying. The preparing includes preparing a mold having an opening being open in a first direction. The arranging includes arranging, on a bottom of the mold, a first seed crystal of monocrystalline silicon, a first intermediate seed crystal including one or more silicon monocrystals and having a less width than the first seed crystal in a second direction perpendicular to the first direction, and a second seed crystal of monocrystalline silicon having a greater width than the first intermediate seed crystal in the second direction adjacent to one another in sequence in the second direction, and arranging, on the bottom of the mold, the first seed crystal, a second intermediate seed crystal including one or more silicon monocrystals and having a less width than the first seed crystal in a third direction perpendicular to the first direction and crossing the second direction, and a third seed crystal of monocrystalline silicon having a greater width than the second intermediate seed crystal in the third direction adjacent to one another in sequence in the third direction. The pouring or melting includes pouring silicon melt into the mold containing the first seed crystal, the second seed crystal, the third seed crystal, the first intermediate seed crystal, and the second intermediate seed crystal heated to a temperature around a melting point of silicon, or melting, in the mold, a silicon lump into silicon melt on the first seed crystal, the second seed crystal, the third seed crystal, the first intermediate seed crystal, and the second intermediate seed crystal. The unidirectionally solidifying includes unidirectionally solidifying the silicon melt upward from the bottom of the mold. The first seed crystal, the second seed crystal, the third seed crystal, the first intermediate seed crystal, and the second intermediate seed crystal are arranged to allow each of a first rotation angle relationship, a second rotation angle relationship, a third rotation angle relationship, and a fourth rotation angle relationship to be a rotation angle relationship of silicon monocrystals corresponding to a coincidence boundary. The first rotation angle relationship is a rotation angle relationship of silicon monocrystals between the first seed crystal and the first intermediate seed crystal about an imaginary axis parallel to the first direction. The second rotation angle relationship is a rotation angle relationship of silicon monocrystals between the second seed crystal and the first intermediate seed crystal about an imaginary axis parallel to the first direction. The third rotation angle relationship is a rotation angle relationship of silicon monocrystals between the first seed crystal and the second intermediate seed crystal about an imaginary axis parallel to the first direction. The fourth rotation angle relationship is a rotation angle relationship of silicon monocrystals between the third seed crystal and the second intermediate seed crystal about an imaginary axis parallel to the first direction.

A solar cell according to one aspect of the present disclosure includes the silicon substrate described above and an electrode on the silicon substrate.

### BRIEF DESCRIPTION OF DRAWINGS

FIG. 1 is an imaginary cross-sectional view of an example first manufacturing apparatus.
FIG. 2 is an imaginary cross-sectional view of an example second manufacturing apparatus.
FIG. 3 is a flowchart of an example manufacturing process of a silicon ingot performed using the first manufacturing apparatus.
FIG. 4 is an imaginary cross-sectional view of an example mold and its surrounding parts included in the first manufacturing apparatus, with the inner wall of the mold coated with a mold release.
FIG. 5A is an imaginary cross-sectional view of the mold and its surrounding parts included in the first manufacturing apparatus, with seed crystals placed on the bottom of the mold, and FIG. 5B is a plan view of the mold in the first manufacturing apparatus, with the seed crystals placed on the bottom of the mold.
FIG. 6 is a diagram describing ∑ values.
FIG. 7A is diagram illustrating example preparation of seed crystals, and FIG. 7B is a perspective view of an example seed crystal.
FIG. 8 is an imaginary cross-sectional view of the first manufacturing apparatus, with its crucible containing silicon lumps.
FIG. 9 is an imaginary cross-sectional view of the first manufacturing apparatus, with silicon melt being poured into the mold from the crucible.
FIG. 10 is an imaginary cross-sectional view of the first manufacturing apparatus, with the silicon melt solidifying unidirectionally in the mold.
FIG. 11 is a flowchart of an example manufacturing process of a silicon ingot performed using the second manufacturing apparatus.
FIG. 12 is an imaginary cross-sectional view of the second manufacturing apparatus, with the inner wall of a mold coated with a mold release.
FIG. 13A is an imaginary cross-sectional view of the second manufacturing apparatus, with seed crystals placed on the bottom of the mold, and FIG. 13B is a plan view of the mold in the second manufacturing apparatus, with the seed crystals placed on the bottom of the mold.
FIG. 14 is an imaginary cross-sectional view of the second manufacturing apparatus, with the mold containing silicon lumps.
FIG. 15 is an imaginary cross-sectional view of the second manufacturing apparatus, with the silicon lumps melted in the mold.
FIG. 16 is an imaginary cross-sectional view of the second manufacturing apparatus, with the silicon melt solidifying unidirectionally in the mold.
FIG. 17A is a cross-sectional view of a silicon ingot according to a first embodiment taken along line XVIIa-XVIIa in FIG. 17B, and FIG. 17B is a cross-sectional view of the silicon ingot according to the first embodiment taken along line XVIIb-XVIIb in FIG. 17A.
FIG. 18A is a cross-sectional view of a silicon block according to the first embodiment taken along line XVIIIa-XVIIIa in FIG. 18B, and FIG. 18B is a cross-sectional view of the silicon block according to the first embodiment taken along line XVIIIb-XVIIIb in FIG. 18A.
FIG. 19A is a front view of the silicon block, showing an example position at which the silicon block is cut, and FIG. 19B is a plan view of the silicon block, showing an example position at which the silicon block is cut.
FIG. 20A is a front view of an example first small silicon block, and FIG. 20B is a plan view of the first small silicon block.
FIG. 21A is a front view of an example silicon substrate according to the first embodiment, and FIG. 21B is a plan view of the silicon substrate according to the first embodiment.
FIG. 22 is a plan view of an example solar cell element, showing its light receiving surface.
FIG. 23 is a plan view of the solar cell element, showing its non-light receiving surface.
FIG. 24 is an imaginary cross-sectional view of the solar cell element taken along line XXIV-XXIV in FIGs. 22 and 23.
FIG. 25 is a plan view of seed crystals arranged on the bottom of a mold in a second embodiment.
FIG. 26A is a cross-sectional view of a silicon ingot according to the second embodiment taken along line XXVIa-XXVIa in FIG. 26B, and FIG. 26B is a cross-sectional view of the silicon ingot according to the second embodiment taken along line XXVIb-XXVIb in FIG. 26A.
FIG. 27A is a cross-sectional view of a silicon block according to the second embodiment taken along line XXVIIa-XXVIIa in FIG. 27B, and FIG. 27B is a cross-sectional view of the silicon block according to the second embodiment taken along line XXVIIb-XXVIIb in FIG. 27A.
FIG. 28A is a front view of a silicon substrate according to the second embodiment, and FIG. 28B is a plan view of the silicon substrate according to the second embodiment.
FIG. 29 is a plan view of seed crystals arranged on the bottom of a mold in a third embodiment.
FIG. 30A is a graph showing the measured ratio between Σ5 coincidence boundaries and Σ29 coincidence boundaries identified in a portion of the silicon ingot according to the first embodiment at a height of 5% of the total length, and FIG. 30B is a graph showing the measured ratio between Σ5 coincidence boundaries and Σ29 coincidence boundaries identified in a portion of the silicon ingot according to the first embodiment at a height of 50% of the total length.

### DETAILED DESCRIPTION

Solar cells using polycrystalline silicon substrates (polycrystalline silicon solar cells) have relatively high conversion efficiency and are suited to mass-manufacturing. Silicon is obtained from, for example, silicon oxide found in large quantities on the earth. Polycrystalline silicon substrates are also relatively easy to produce by, for example, slicing silicon blocks cut out from a silicon ingot obtained by casting. Polycrystalline silicon solar cells thus have a large share of the total solar cell production for many years.

Monocrystalline silicon substrates used in solar cells are expected to have higher conversion efficiency than polycrystalline silicon substrates.

A silicon ingot having a portion of a crystal similar to a monocrystal (mono-like crystal) may thus be manufactured by mono-like casting in which crystal grains are grown upward from a seed crystal placed on the bottom of a mold using silicon melt. The mono-like crystal inherits the crystal orientation of the seed crystal and grows unidirectionally. The mono-like crystal is allowed to include, for example, a certain number of dislocations or grain boundaries.

In the same manner as common casting, mono-like casting tends to have, for example, distortions and defects originating from the side walls of the mold during manufacture of a silicon ingot. The silicon ingot is likely to contain many defects at its periphery. Thus, the periphery of the silicon ingot may be cut off to form a silicon block, which is then sliced into high-quality silicon substrates having fewer defects. To reduce the ratio of the periphery to be cut off from the silicon ingot, the silicon ingot may be upsized to increase the areas of its bottom surface and the upper surface. This improves, for example, the productivity of the silicon ingot.

However, for example, the seed crystal to be placed on the bottom of the mold is not easily upsized. To upsize a silicon ingot, multiple seed crystals may be arranged on the bottom of the mold to grow silicon mono-like crystals upward from the bottom in the mold using silicon melt.

However, for example, many defects can occur in portions of the silicon mono-like crystals grown upward from the boundaries at which multiple seed crystals abut against one another and the surroundings of the boundaries. This may cause many defects and thus deteriorate the quality of the silicon ingot, the silicon block, and the silicon substrate.

The inventor of the present disclosure and others have developed a technique for improving the quality of the silicon ingot, the silicon block, the silicon substrate, and the solar cell.

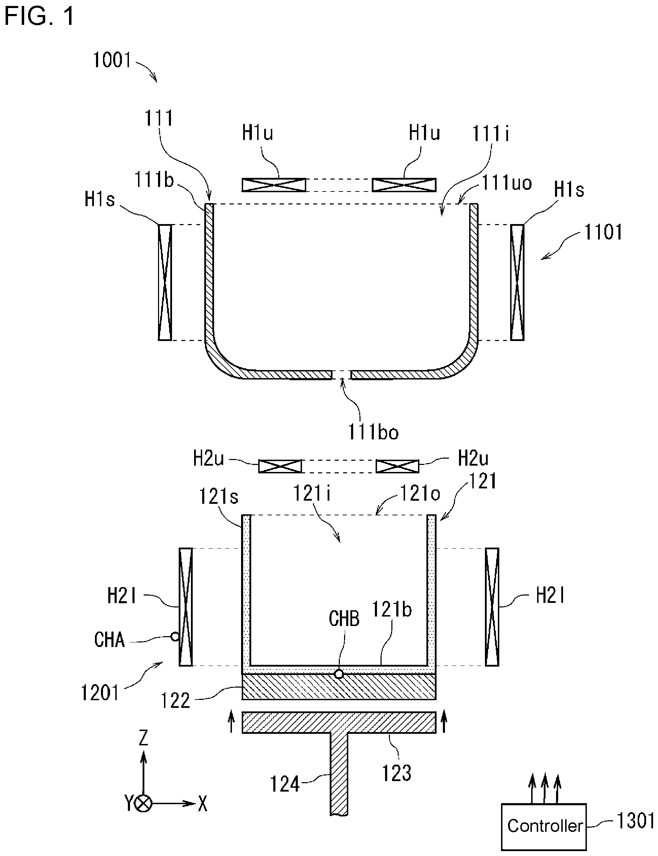

Embodiments of the present disclosure will now be described with reference to the drawings. Throughout the drawings, components with the same structures and functions are given the same reference numerals and will not be described repeatedly. The drawings are schematic. A right-handed XYZ coordinate system is defined in FIGs. 1, 2, 4 to 5B, 8 to 10, and 12 to 29. In the XYZ coordinate system, the positive Z-direction is parallel to the height of a mold 121, silicon ingots In1 and In1A, and silicon blocks Bk1 and Bk1A and to the thickness of silicon substrates 1 and 1A. In the XYZ coordinate system, the positive X-direction is parallel to the width of each of the mold 121, the silicon ingots In1 and In1A, the silicon blocks Bk1 and Bk1A, and the silicon substrates 1 and 1A. The positive Y-direction is orthogonal to both the positive X-direction and the positive Z-direction.

### 1. First Embodiment

### 1-1. Manufacturing Apparatus for Silicon Ingot

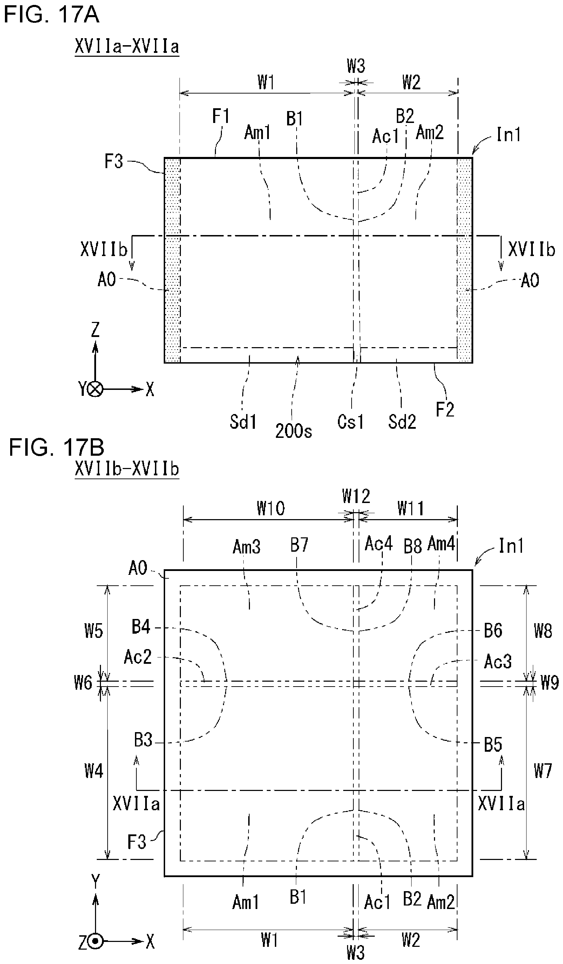

A manufacturing apparatus for an ingot of silicon (silicon ingot) In1 (refer to FIGs. 17A and 17B) according to a first embodiment includes, for example, a manufacturing apparatus 1001 operable in a first manner (first manufacturing apparatus) and a manufacturing apparatus 1002 operable in a second manner (second manufacturing apparatus). The first manufacturing apparatus 1001 and the second manufacturing apparatus 1002 are both used to manufacture a silicon ingot In1 having a portion of a crystal similar to a monocrystal (mono-like crystalline portion) by mono-like casting, in which crystal grains are grown from a seed crystal assembly placed on a bottom 121b of a mold 121.

### 1-1-1. First Manufacturing Apparatus

The first manufacturing apparatus 1001 will now be described with reference to FIG. 1. With the first manufacturing apparatus 1001, a silicon ingot is manufactured by solidifying, in the mold 121, molten silicon liquid (silicon melt) poured from a crucible 111 into the mold 121 (pouring method).

As shown in FIG. 1, the first manufacturing apparatus 1001 includes, for example, an upper unit 1101, a lower unit 1201, and a controller 1301.

The upper unit 1101 has, for example, the crucible 111, a first upper heater H1u, and a side heater H1s. The lower unit 1201 includes, for example, the mold 121, a mold holder 122, a cooling plate 123, a rotational shaft 124, a second upper heater H2u, a lower heater H2l, a first temperature measurer CHA, and a second temperature measurer CHB. The crucible 111 and the mold 121 are formed from, for example, a material unlikely to melt, deform, decompose, and react with silicon at temperatures at or above the melting point of silicon. Impurity content is reduced in the material.

The crucible 111 includes, for example, a body 111b. The overall shape of the body 111b is substantially a bottomed cylinder. The crucible 111 has, for example, a first internal space 111i and an upper opening (first upper opening) 111uo. The first internal space 111i is surrounded by the body 111b. The first upper opening 111uo connects the first internal space 111i to an upper space outside the crucible 111. The body 111b also has a lower opening 111bo through the bottom of the body 111b. The body 111b is formed from, for example, quartz glass. The first upper heater H1u is, for example, directly above the first upper opening 111uo and is annular as viewed in plan. The side heater H1s surrounds, for example, the side surface of the body 111b and is annular as viewed in plan.

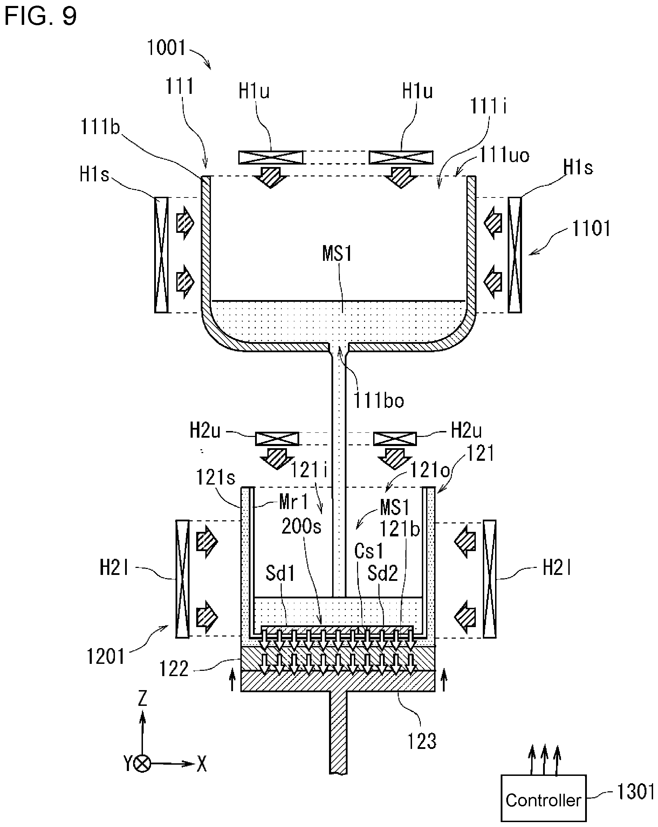

For example, to manufacture the silicon ingot In1 with the first manufacturing apparatus 1001, multiple lumps of solid silicon (silicon lumps) as the material of the silicon ingot In1 are placed in the first internal space 111i of the crucible 111 in the upper unit 1101 through the first upper opening 111u0. The silicon lumps may contain silicon in powder form (silicon powder). The silicon lumps placed in the first internal space 111i is melted by heating with the first upper heater H1u and the side heater H1s. For example, silicon lumps on the lower opening 111bo melted by heating cause silicon melt MS1 (refer to FIG. 9) in the first internal space 111i to be poured into the mold 121 in the lower unit 1201 through the lower opening 111bo. In one example, the upper unit 1101 may not have the lower opening 111bo in the crucible 111. In this case, the crucible 111 may be tilted to cause the silicon melt MS1 to be poured into the mold 121 from the crucible 111.

The overall shape of the mold 121 is a bottomed tube. The mold 121 includes, for example, a bottom 121b and a side wall 121s. The mold 121 has, for example, a second internal space 121i and an upper opening (second upper opening) 121o. The second internal space 121i is surrounded by the bottom 121b and the side wall 121s. The second upper opening 121o connects the second internal space 121i to an upper space outside the mold 121. In other words, the second upper opening 121o is open in the positive Z-direction as a first direction. The second upper opening 121o is, for example, at an end of the mold 121 in the positive Z-direction. The bottom 121b and the second upper opening 121o are, for example, square. Each of the bottom 121b and the second upper opening 121o is, for example, about 300 to 800 millimeters (mm) on a side. The second upper opening 121o can receive the silicon melt MS1 poured into the second internal space 121i from the crucible 111. The side wall 121s and the bottom 121b are formed from, for example, silica. The side wall 121s may include, for example, a combination of a carbon fiber-reinforced carbon composite and felt as a heat insulating material.

As shown in FIG. 1, the second upper heater H2u is, for example, directly above the second upper opening 121o in the mold 121 and is looped. Being looped includes being circular, triangular, quadrangular, or polygonal. For example, the lower heater H2l is looped and surrounds a portion of the side wall 121s of the mold 121 from the bottom to the top in the positive Z-direction. The lower heater H2l may be divided into multiple sections for separate temperature control.

The mold holder 122 holds the mold 121 from, for example, below and is in close contact with the bottom 121b of the mold 121. The mold holder 122 may be formed from, for example, a material with high thermal conductivity such as graphite. The mold holder 122 and the side wall 121s of the mold 121 may be, for example, separated from each other by a heat insulator. In this case, for example, the mold holder 122 may conduct more heat from the bottom 121b than from the side wall 121s to the cooling plate 123. The heat insulator may be formed from, for example, a heat insulating material such as felt.

The cooling plate 123 is raised or lowered as the rotational shaft 124 is rotated, for example. For example, the cooling plate 123 is raised as the rotational shaft 124 is rotated and comes in contact with the lower surface of the mold holder 122. For example, the cooling plate 123 is lowered as the rotational shaft 124 is rotated and separates from the lower surface of the mold holder 122. In other words, the cooling plate 123 can be, for example, in contact with and separate from the lower surface of the mold holder 122. The cooling plate 123 coming in contact with the lower surface of the mold holder 122 is referred to as contacting. The cooling plate 123 may include, for example, a hollow metal plate or another structure through which water or gas circulates. For example, during manufacture of the silicon ingot In1 using the first manufacturing apparatus 1001, the cooling plate 123 may be placed into contact with the lower surface of the mold holder 122 to remove heat from the silicon melt MS 1 contained in the second internal space 121i of the mold 121. During the heat removal, heat from the silicon melt MS1 transfers through, for example, the bottom 121b of the mold 121 and the mold holder 122 to the cooling plate 123. The cooling plate 123 thus cools, for example, the silicon melt MS1 from the portion near the bottom 121b.

The first temperature measurer CHA and the second temperature measurer CHB measure, for example, temperature. The second temperature measurer CHB is optional. The first temperature measurer CHA and the second temperature measurer CHB measure temperature with, for example, a thermocouple coated with a thin alumina or carbon tube. The controller 1301 includes, for example, a temperature detector that detects temperature corresponding to the voltage generated by each of the first temperature measurer CHA and the second temperature measurer CHB. The first temperature measurer CHA is, for example, adjacent to the lower heater H2l. The second temperature measurer CHB is, for example, adjacent to the lower surface of the bottom 121b of the mold 121 in the middle on the lower surface.

The controller 1301 controls, for example, the overall operation of the first manufacturing apparatus 1001. The controller 1301 has, for example, a processor, a memory, and a storage. The controller 1301 performs, for example, various control operations by executing a program stored in the storage with the processor. For example, the controller 1301 controls the outputs from the first upper heater H1u, the second upper heater H2u, the side heater H1s, and the lower heater H2l. The controller 1301 controls the outputs from the first upper heater H1u, the second upper heater H2u, the side heater H1s, and the lower heater H2l in accordance with, for example, at least one of an elapsed time or the temperatures obtained with the first temperature measurer CHA and the second temperature measurer CHB. The controller 1301 controls the rotational shaft 124 to raise or lower the cooling plate 123 in accordance with, for example, at least one of an elapsed time or the temperatures obtained with the first temperature measurer CHA and the second temperature measurer CHB. The controller 1301 thus controls, for example, the cooling plate 123 to be in contact with or separate from the lower surface of the mold holder 122.

### 1-1-2. Second Manufacturing Apparatus

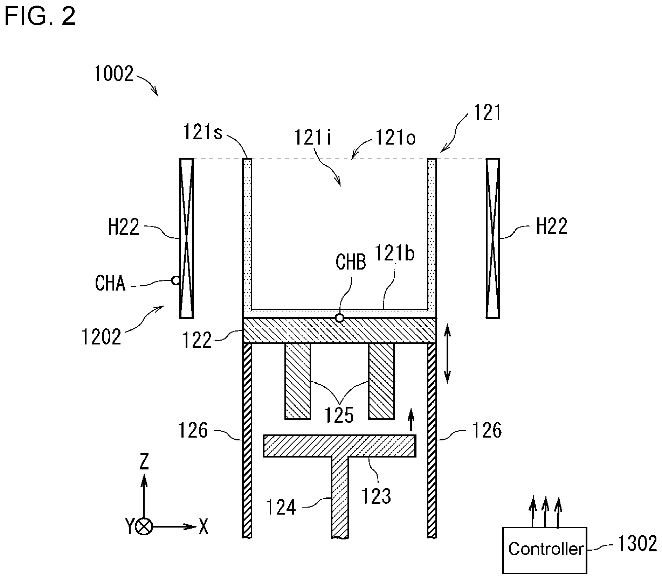

The second manufacturing apparatus 1002 will now be described with reference to FIG. 2. With the second manufacturing apparatus 1002, the silicon ingot In1 is manufactured by solidifying silicon melt MS1 resulting from melting multiple solid silicon lumps as a material of the silicon ingot In1 in the mold 121 (in-mold melting method).

As shown in FIG. 2, the second manufacturing apparatus 1002 includes, for example, a main unit 1202 and a controller 1302.

The main unit 1202 includes, for example, the mold 121, the mold holder 122, the cooling plate 123, the rotational shaft 124, a heat conductor 125, a mold support 126, a side heater H22, the first temperature measurer CHA, and the second temperature measurer CHB. The same components and the functions as those in the first manufacturing apparatus 1001 are given the same names and reference numerals. The components and the functions in the second manufacturing apparatus 1002 different from those in the first manufacturing apparatus 1001 will be described below.

The heat conductor 125 is connected to, for example, the bottom of the mold holder 122. The heat conductor 125 includes, for example, multiple members (heat conductor members) connected to the bottom of the mold holder 122. For example, the multiple heat conductor members are four heat conductor members. The heat conductor members may be formed from, for example, a material with high thermal conductivity such as graphite. For example, the cooling plate 123 is raised as the rotational shaft 124 is rotated and comes in contact with the bottom of the heat conductor 125. For example, the cooling plate 123 is lowered as the rotational shaft 124 is rotated and separates from the bottom of the heat conductor 125. In other words, the cooling plate 123 can be, for example, in contact with and separate from the bottom of the heat conductor 125. More specifically, the cooling plate 123 can be, for example, in contact with and separate from the bottom of each heat conductor member. The cooling plate 123 coming in contact with the bottom of the heat conductor 125 is referred to as contacting. For example, during manufacture of the silicon ingot In1 using the second manufacturing apparatus 1002, the cooling plate 123 may be placed into contact with the bottom of the heat conductor 125 to remove heat from the silicon melt MS1 contained in the second internal space 121i of the mold 121. During the heat removal, heat from the silicon melt MS1 transfers through, for example, the bottom 121b of the mold 121, the mold holder 122, and the heat conductor 125 to the cooling plate 123. The cooling plate 123 thus cools, for example, the silicon melt MS1 from the portion near the bottom 121b.

For example, the side heater H22 is looped as viewed in plan and surrounds a portion of the side wall 121s of the mold 121 from the bottom to the top in the positive Z-direction. The first temperature measurer CHA is, for example, adjacent to the side heater H22. The side heater H22 may be, for example, divided into multiple sections for separate temperature control.

The mold support 126 supports, for example, the mold holder 122 from below. The mold support 126 includes, for example, multiple rods connected to the mold holder 122 to support the mold holder 122 from below. The multiple rods are vertically movable with a raising and lowering device such as a ball screw or an air cylinder. The mold support 126 can thus raise and lower the mold 121 with the mold holder 122.

The controller 1302 controls, for example, the overall operation of the second manufacturing apparatus 1002. The controller 1302 includes, for example, a processor, a memory, and a storage. The controller 1302 performs, for example, various control operations by executing a program stored in the storage with the processor. For example, the controller 1302 controls the output from the side heater H22, the raising and lowering of the cooling plate 123 performed by the rotational shaft 124, and the raising and lowering of the mold 121 performed by the mold support 126. The controller 1302 controls the output from the side heater H22 and the contact and separation of the cooling plate 123 with and from the bottom of the heat conductor 125 in accordance with, for example, at least one of an elapsed time or the temperatures obtained with the first temperature measurer CHA and the second temperature measurer CHB. The controller 1302 includes, for example, a temperature detector that detects temperature corresponding to the voltage generated by each of the first temperature measurer CHA and the second temperature measurer CHB.

### 1-2. Manufacturing Method for Silicon Ingot

### 1-2-1. Manufacturing Method for Silicon Ingot Using First Manufacturing Apparatus

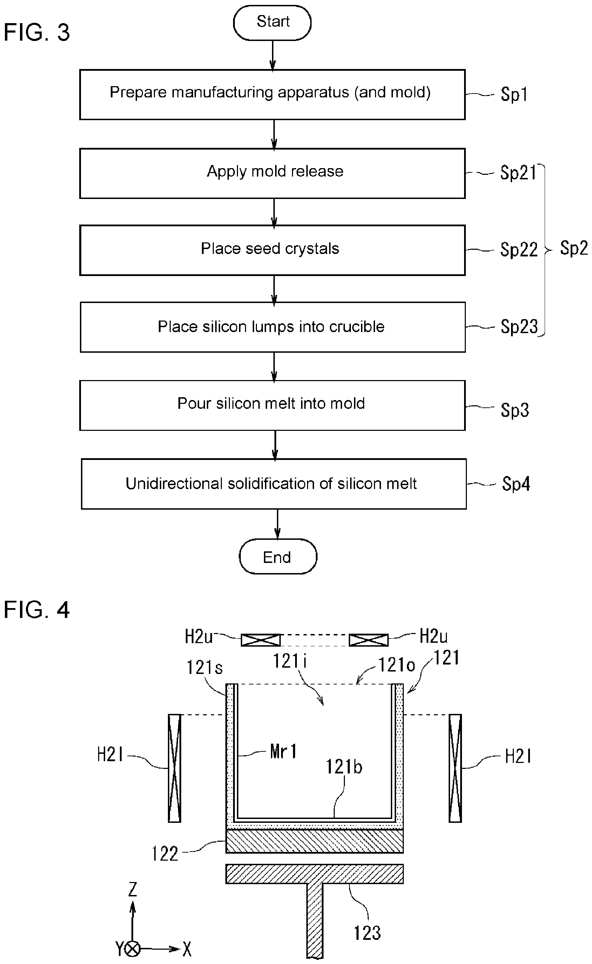

A manufacturing method for the silicon ingot In1 using the first manufacturing apparatus 1001 will be described with reference to FIGs. 3 to 10. As shown in FIG. 3, the manufacturing method for the silicon ingot In1 using the first manufacturing apparatus 1001 includes, for example, a first process in step Sp1, a second process in step Sp2, a third process in step Sp3, and a fourth process in step Sp4 performed in this order. The method allows easy manufacture of the high quality silicon ingot In1 with the crystal orientations aligned. FIGs. 4 to 5B and 8 to 10 show both the crucible 111 and the mold 121 or the mold 121 alone in each process.

### First Process

In the first process in step Sp1, the first manufacturing apparatus 1001 is prepared. The first manufacturing apparatus 1001 includes, for example, the mold 121 having the second upper opening 121o that is open in the positive Z-direction as the first direction.

### Second Process

In the second process in step Sp2, for example, a seed crystal assembly 200s of silicon monocrystals is placed on the bottom 121b of the mold 121 prepared in the first process. In the second process, three steps including step Sp21, step Sp22, and step Sp23 are performed in this order.

In step Sp21, as shown in the example in FIG. 4, a mold release is applied to the inner wall surface of the mold 121 to form a layer Mr1 of the mold release (a mold release layer). The mold release layer Mr1 reduces, for example, the likelihood of the silicon ingot In1 fusing to the inner wall of the mold 121 while the silicon melt MS1 is solidifying in the mold 121. The mold release layer Mr1 may be formed from, for example, at least one material selected from, for example, silicon nitride, silicon carbide, and silicon oxide. The mold release layer Mr1 may include, for example, a coating of slurry applied or sprayed to the inner wall surface of the mold 121. The slurry includes at least one selected from, for example, silicon nitride, silicon carbide, and silicon oxide. The slurry is prepared by, for example, adding, to a solution containing mainly an organic binder such as polyvinyl alcohol (PVA) and a solvent, powder of one of silicon nitride, silicon carbide, or silicon oxide or powder mixture of at least two of those materials, and stirring the resultant solution.

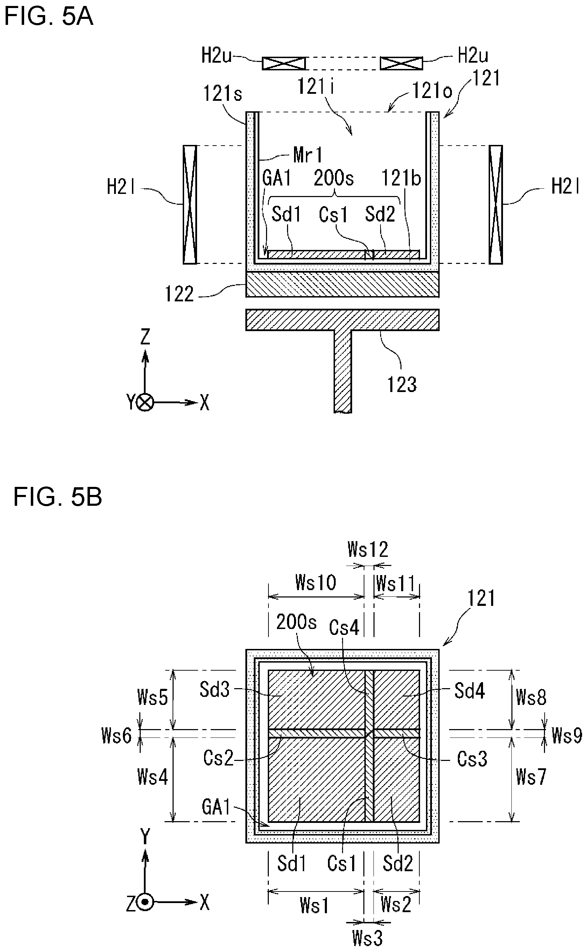

In the step Sp22, as shown in FIGs. 5A and 5B, the seed crystal assembly 200s is placed on the bottom 121b of the mold 121. The seed crystal assembly 200s may be attached to, for example, the mold release layer Mr1 formed on the inner wall surface of the mold 121 in step Sp21 before the mold release layer Mr1 is dried.

For example, the upper surface of the seed crystal assembly 200s facing in the positive Z-direction as the first direction may have the Miller indices of (100). In this case, the seed crystal assembly 200s may be easily prepared, and the crystal growth rate may be increased during unidirectional solidification of the silicon melt MS1 described later. As shown in the example in FIG. 5B, the upper surface of the seed crystal assembly 200s is rectangular or square as viewed in plan. The seed crystal assembly 200s may be, for example, thick enough not to melt at the bottom 121b when the silicon melt MS1 is poured into the mold 121 from the crucible 111. More specifically, the seed crystal assembly 200s has a thickness of, for example, about 5 to 70 mm. The seed crystal assembly 200s may have a thickness of, for example, about 10 to 30 mm.

For example, the seed crystal assembly 200s including multiple seed crystals is placed on the bottom 121b to upsize the bottom area of the silicon ingot In1 for increasing casting efficiency and to cover the difficulty of forming a large seed crystal. The seed crystal assembly 200s includes, for example, a first seed crystal Sd1, a second seed crystal Sd2, a third seed crystal Sd3, a fourth seed crystal Sd4, a first intermediate seed crystal Cs1, a second intermediate seed crystal Cs2, a third intermediate seed crystal Cs3, and a fourth intermediate seed crystal Cs4.

More specifically, for example, the first seed crystal Sd1, the first intermediate seed crystal Cs1, and the second seed crystal Sd2 are arranged on the bottom 121b of the mold 121 adjacent to one another in the stated order in the positive X-direction as a second direction perpendicular to the positive Z-direction as the first direction. In other words, for example, the first intermediate seed crystal Cs1 is between the first seed crystal Sd1 and the second seed crystal Sd2. For example, the first seed crystal Sd1, the second intermediate seed crystal Cs2, and the third seed crystal Sd3 are arranged on the bottom 121b of the mold 121 adjacent to one another in the stated order in the positive Y-direction as a third direction, which is perpendicular to the positive Z-direction as the first direction and crosses the positive X-direction as the second direction. In other words, for example, the second intermediate seed crystal Cs2 is between the first seed crystal Sd1 and the third seed crystal Sd3. For example, the second seed crystal Sd2, the third intermediate seed crystal Cs3, and the fourth seed crystal Sd4 are arranged on the bottom 121b of the mold 121 adjacent to one another in the stated order in the positive Y-direction as the third direction. In other words, for example, the third intermediate seed crystal Cs3 is between the second seed crystal Sd2 and the fourth seed crystal Sd4. For example, the third seed crystal Sd3, the fourth intermediate seed crystal Cs4, and the fourth seed crystal Sd4 are arranged on the bottom 121b of the mold 121 adjacent to one another in the stated order in the positive X-direction as the second direction. In other words, for example, the fourth intermediate seed crystal Cs4 is between the third seed crystal Sd3 and the fourth seed crystal Sd4.

Each of the first seed crystal Sd1, the second seed crystal Sd2, the third seed crystal Sd3, and the fourth seed crystal Sd4 is a monocrystal of silicon (or simply a seed crystal). Each of the first intermediate seed crystal Cs1, the second intermediate seed crystal Cs2, the third intermediate seed crystal Cs3, and the fourth intermediate seed crystal Cs4 is a section containing one or more silicon monocrystals (or simply an intermediate seed crystal). Each of the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 has, for example, a rectangular profile as viewed in plan in the negative Z-direction. The profile may be other than a rectangle.

The first intermediate seed crystal Cs1 has a width (third seed width) Ws3 less than each of a width (first seed width) Ws1 of the first seed crystal Sd1 and a width (second seed width) Ws2 of the second seed crystal Sd2 in the positive X-direction as the second direction. In other words, each of the first seed width Ws1 and the second seed width Ws2 is greater than the third seed width Ws3 in the positive X-direction as the second direction. The second intermediate seed crystal Cs2 has a width (sixth seed width) Ws6 less than each of a width (fourth seed width) Ws4 of the first seed crystal Sd1 and a width (fifth seed width) Ws5 of the third seed crystal Sd3 in the positive Y-direction as the third direction. In other words, each of the fourth seed width Ws4 and the fifth seed width Ws5 is greater than the sixth seed width Ws6 in the positive Y-direction as the third direction. The third intermediate seed crystal Cs3 has a width (ninth seed width) Ws9 less than each of a width (seventh seed width) Ws7 of the second seed crystal Sd2 and a width (eighth seed width) Ws8 of the fourth seed crystal Sd4 in the positive Y-direction as the third direction. In other words, each of the seventh seed width Ws7 and the eighth seed width Ws8 is greater than the ninth seed width Ws9 in the positive Y-direction as the third direction. The fourth intermediate seed crystal Cs4 has a width (twelfth seed width) Ws12 less than each of a width (tenth seed width) Ws10 of the third seed crystal Sd3 and a width (an eleventh seed width) Ws11 of the fourth seed crystal Sd4 in the positive X-direction as the second direction. In other words, each of the tenth seed width Ws10 and the eleventh seed width Ws11 is greater than the twelfth seed width Ws12 in the positive X-direction as the second direction.

The bottom 121b has, for example, a rectangular or square inner wall surface that is about 350 mm on a side. In this case, each of the first seed width Ws1, the second seed width Ws2, the fourth seed width Ws4, the fifth seed width Ws5, the seventh seed width Ws7, the eighth seed width Ws8, the tenth seed width Ws10, and the eleventh seed width Ws11 is about, for example, 50 to 250 mm. Each of the third seed width Ws3, the sixth seed width Ws6, the ninth seed width Ws9, and the twelfth seed width Ws12 is, for example, about 5 to 20 mm.

Each of the first seed crystal Sd1, the second seed crystal Sd2, the third seed crystal Sd3, and the fourth seed crystal Sd4 is, for example, a monocrystalline silicon plate or block. Each of the first intermediate seed crystal Cs1, the second intermediate seed crystal Cs2, the third intermediate seed crystal Cs3, and the fourth intermediate seed crystal Cs4 contains, for example, one or more monocrystalline silicon rods. In other words, for example, each of the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 contains the same monocrystalline silicon material.

The first intermediate seed crystal Cs1 and the fourth intermediate seed crystal Cs4 are, for example, elongated in the positive Y-direction as the third direction. For example, the first intermediate seed crystal Cs1 and the fourth intermediate seed crystal Cs4 may be formed from a single silicon monocrystal, two or more silicon monocrystals arranged in the positive Y-direction as the third direction, or two or more silicon monocrystals arranged in the positive X-direction as the second direction. For example, two or more silicon monocrystals included in the first intermediate seed crystal Cs1 and the fourth intermediate seed crystal Cs4 may be spaced from each other by, for example, about 0 to 5 mm or by about 0 to 1 mm. For example, the second intermediate seed crystal Cs2 and the third intermediate seed crystal Cs3 each are elongated in the positive X-direction as the second direction. For example, the second intermediate seed crystal Cs2 and the third intermediate seed crystal Cs3 may be formed from a single silicon monocrystal, two or more silicon monocrystals arranged in the positive X-direction as the second direction, or two or more silicon monocrystals arranged in the positive Y-direction as the third direction. For example, two or more silicon monocrystals included in the second intermediate seed crystal Cs2 and the third intermediate seed crystal Cs3 may be spaced from each other by, for example, about 0 to 3 mm or by about 0 to 1 mm. In the example in FIG. 5B, the section defined by the first intermediate seed crystal Cs1 and the fourth intermediate seed crystal Cs4 and the section defined by the second intermediate seed crystal Cs2 and the third intermediate seed crystal Cs3 cross each other in a cross shape.

For example, the first seed crystal Sd1 and the first intermediate seed crystal Cs1 have a first rotation angle relationship between their silicon monocrystals about an imaginary axis parallel to the positive Z-direction as the first direction. The first intermediate seed crystal Cs1 and the second seed crystal Sd2 have a second rotation angle relationship between their silicon monocrystals about an imaginary axis parallel to the positive Z-direction as the first direction. The first seed crystal Sd1 and the second intermediate seed crystal Cs2 have a third rotation angle relationship between their silicon monocrystals about an imaginary axis parallel to the positive Z-direction as the first direction. The second intermediate seed crystal Cs2 and the third seed crystal Sd3 have a fourth rotation angle relationship between their silicon monocrystals about an imaginary axis parallel to the positive Z-direction as the first direction. The second seed crystal Sd2 and the third intermediate seed crystal Cs3 have a fifth rotation angle relationship between their silicon monocrystals about an imaginary axis parallel to the positive Z-direction as the first direction. The third intermediate seed crystal Cs3 and the fourth seed crystal Sd4 have a sixth rotation angle relationship between their silicon monocrystals about an imaginary axis parallel to the positive Z-direction as the first direction. The third seed crystal Sd3 and the fourth intermediate seed crystal Cs4 have a seventh rotation angle relationship between their silicon monocrystals about an imaginary axis parallel to the positive Z-direction as the first direction. The fourth intermediate seed crystal Cs4 and the fourth seed crystal Sd4 have an eighth rotation angle relationship between their silicon monocrystals about an imaginary axis parallel to the positive Z-direction as the first direction.

In this case, in step Sp22, the seed crystals in the seed crystal assembly 200s are arranged to allow each of the first rotation angle relationship, the second rotation angle relationship, the third rotation angle relationship, the fourth rotation angle relationship, the fifth rotation angle relationship, the sixth rotation angle relationship, the seventh rotation angle relationship, and the eighth rotation angle relationship to be a rotation angle relationship of silicon monocrystals corresponding to a coincidence boundary. The coincidence boundary may occur between two neighboring crystal grains having the same crystal lattices and having the relationship of being rotated relative to each other about a rotation axis parallel to their shared crystal direction. When the crystal lattices shared by the two crystal grains are located to form lattice points arranged regularly, the grain boundary is referred to as a coincidence boundary. The two neighboring crystal grains across the coincidence boundary may be referred to as a first crystal grain and a second crystal grain. When the crystal lattices in the first crystal grain have lattice points shared by the crystal lattices in the second crystal grain for every N lattice points at the coincidence boundary, the period N indicating the occurrence frequency of such a lattice point is referred to as a Σ value of the coincidence boundary.

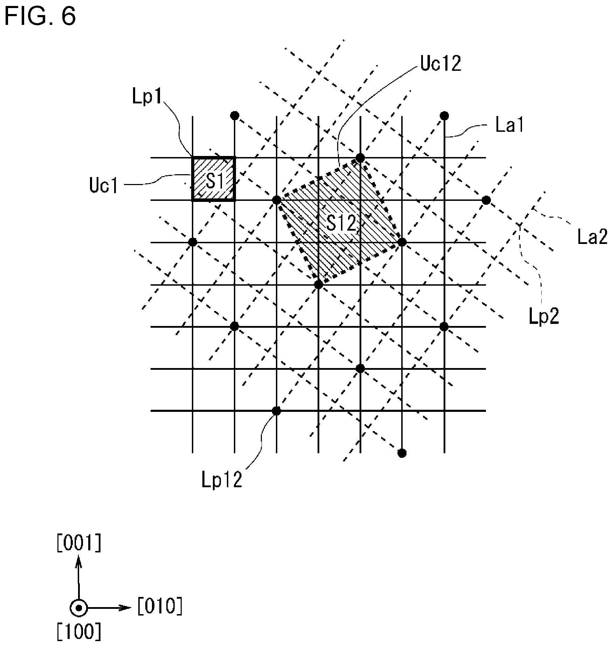

The ∑-value will be described using a simple cubic lattice as an example. In FIG. 6, a simple cubic lattice has lattice points Lp1 on a plane having the Miller indices of (100) at intersections between multiple vertical and horizontal solid lines La1 orthogonal to each other. In the example in FIG. 6, the square defined by the thick solid line is a unit cell (first unit cell) Uc1 of the simple cubic lattice. In FIG. 6, the simple cubic lattice is rotated clockwise by 36.52 degrees (36.52°) about a crystal axis parallel to a direction having the Miller indices of [100] as a rotation axis. The resultant simple cubic lattice has lattice points Lp2 on a plane having the Miller indices of (100) at intersections of multiple broken lines La2 orthogonal to each other. A point (coincidence lattice point) Lp12 at which a lattice point Lp1 before rotation overlaps a lattice point Lp2 after rotation occurs periodically. In FIG. 6, the dots indicate the periodically-occurring coincidence lattice points Lp12. In the example in FIG. 6, multiple coincidence lattice points Lp12 form a lattice (coincidence lattice) including a unit cell (coincidence unit cell) Uc12 indicated by the square defined by the thick broken line. The ∑ value is used as an index representing the degree of coincidence (the density of coincidence lattice points) between the simple cubic lattice before rotation (first lattice) including its lattice points Lp1 at the intersections between the solid lines La1 and the simple cubic lattice after rotation (second lattice) including its lattice points Lp2 at the intersections between the broken lines La2. In the example in FIG. 6, the ∑ value may be calculated by dividing an area S12 of the coincidence unit cell Uc12 by an area S1 of the first unit cell Uc1. More specifically, the ∑ value may be calculated by the formula ∑ value = (the area of the coincidence unit cell)/(the area of the first unit cell) = (S12)/(S1). In the example in FIG. 6, the calculated ∑ value is 5. The ∑ value calculated in this manner may be used as an index representing the degree of coincidence between the first and second lattices adjacent to one another across a grain boundary with a predetermined rotation angle relationship. In other words, the ∑ value may be used as an index representing the degree of coincidence between two neighboring crystal grains across a grain boundary having the predetermined rotation angle relationship and the same crystal lattices.

The rotation angular relationship of silicon monocrystals corresponding to the coincidence boundary may allow an error margin of, for example, 1 to 3 degrees. The error may occur when, for example, preparing the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 by cutting and when arranging the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4. Such errors may be reduced during, for example, unidirectional solidification of the silicon melt MS1 (described later).

In one example, the upper surface of each of the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and fourth intermediate seed crystal Cs4 facing in the positive Z-direction as the first direction has the Miller indices of (100). In other words, for example, the crystal direction of each of the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and fourth intermediate seed crystal Cs4 parallel to the positive Z-direction as the first direction has the Miller indices of <100>.

In this case, for example, the coincidence boundary is one of a ∑5 coincidence boundary, a ∑13 coincidence boundary, a ∑17 coincidence boundary, a ∑25 coincidence boundary, or a ∑29 coincidence boundary. The rotation angle relationship of silicon monocrystals corresponding to the Σ5 coincidence boundary may be, for example, about 36 to 37 degrees or about 35 to 38 degrees. The rotation angle relationship of silicon monocrystals corresponding to the E13 coincidence boundary may be, for example, about 22 to 23 degrees or about 21 to 24 degrees. The rotation angle relationship of silicon monocrystals corresponding to the E17 coincidence boundary may be, for example, about 26 to 27 degrees or about 25 to 28 degrees. The rotation angle relationship of silicon monocrystals corresponding to the Σ25 coincidence boundary may be, for example, about 16 to 17 degrees or about 15 to 18 degrees. The rotation angle relationship of silicon monocrystals corresponding to the Σ29 coincidence boundary (random boundary) may be, for example, about 43 to 44 degrees or about 42 to 45 degrees. The crystal orientation of each of the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 may be identified by measurement using, for example, X-ray diffraction or electron backscatter diffraction patterns (EBSDs).

For example, each of the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and fourth intermediate seed crystal Cs4 may be arranged to have its upper surface having the Miller indices of (100) facing in the positive Z-direction as the first direction. This may improve, for example, the crystal growth rate during unidirectional solidification of the silicon melt MS1 described later. Thus, mono-like crystals are easily obtained by growing crystal grains upward from the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4. The quality of the silicon ingot In1 may thus be easily improved.

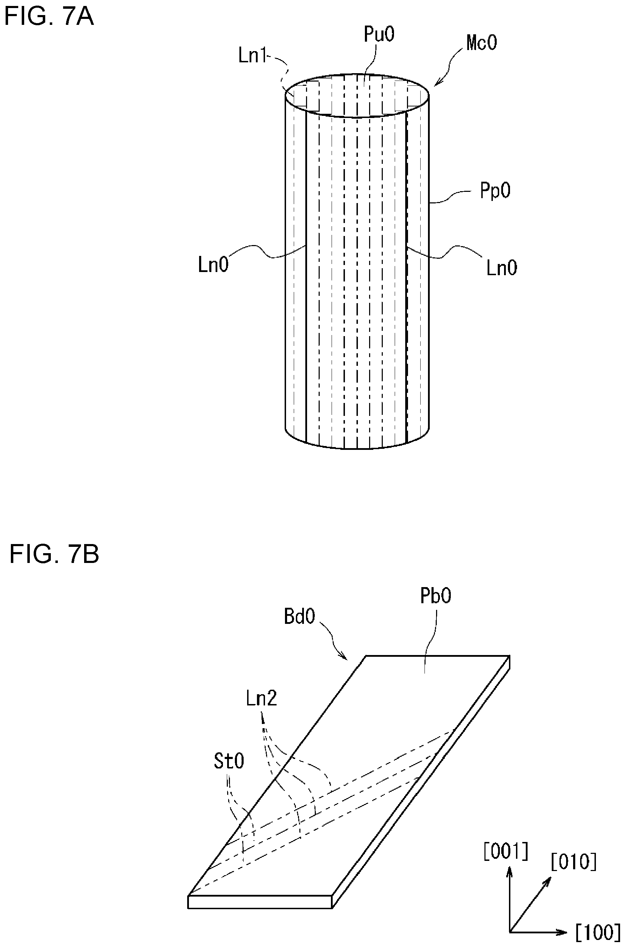

Each of the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 is prepared in the manner described below, for example. As shown in the example in FIG. 7A, a cylindrical lump of monocrystalline silicon (monocrystalline silicon lump) Mc0 is first obtained using the Czochralski (CZ) method by setting the crystal direction parallel to the direction in which the monocrystalline silicon is grown to have the Miller indices of <100>. In this example, the monocrystalline silicon lump Mc0 has an upper surface Pu0 having the Miller indices of (100) and an outer peripheral surface Pp0 including specific linear portions Ln0 having the Miller indices of (110). As shown in FIG. 7A, the monocrystalline silicon lump Mc0 is then cut with reference to the linear portions Ln0 on the outer peripheral surface Pp0 of the monocrystalline silicon lump Mc0. In FIG. 7A, the position at which the monocrystalline silicon lump Mc0 is cut (cut position) is indicated by imaginary thin two-dot chain lines Ln1. As shown in FIG. 7B, the monocrystalline silicon lump Mc0 may be, for example, cut into multiple plates Bd0 of monocrystalline silicon (monocrystalline silicon plates) each having a rectangular plate surface Pb0 having the Miller indices of (100). The monocrystalline silicon plates Bd0 may be used as, for example, the first seed crystal Sd1, the second seed crystal Sd2, the third seed crystal Sd3, and the fourth seed crystal Sd4. As shown in FIG. 7B, for example, the monocrystalline silicon plate Bd0 may be cut along the cut position indicated by the imaginary two-dot chain lines Ln2 into rods St0 of monocrystalline silicon (monocrystalline silicon rods). The angle between any one of the four sides of the plate surface Pb0 of the monocrystalline silicon plate Bd0 and any one of the two-dot chain lines Ln2 is the rotation angle between silicon monocrystals corresponding to a coincidence boundary. Each monocrystalline silicon rod St0 obtained as above may be used as, for example, one of silicon monocrystals to be the first intermediate seed crystal Cs1, the second intermediate seed crystal Cs2, the third intermediate seed crystal Cs3, or the fourth intermediate seed crystal Cs4.

In the lower space of the mold 121, silicon lumps in a solid state may be, for example, placed on the seed crystal assembly 200s of silicon monocrystals arranged on the bottom 121b of the mold 121. For example, the silicon lumps are relatively small silicon pieces.

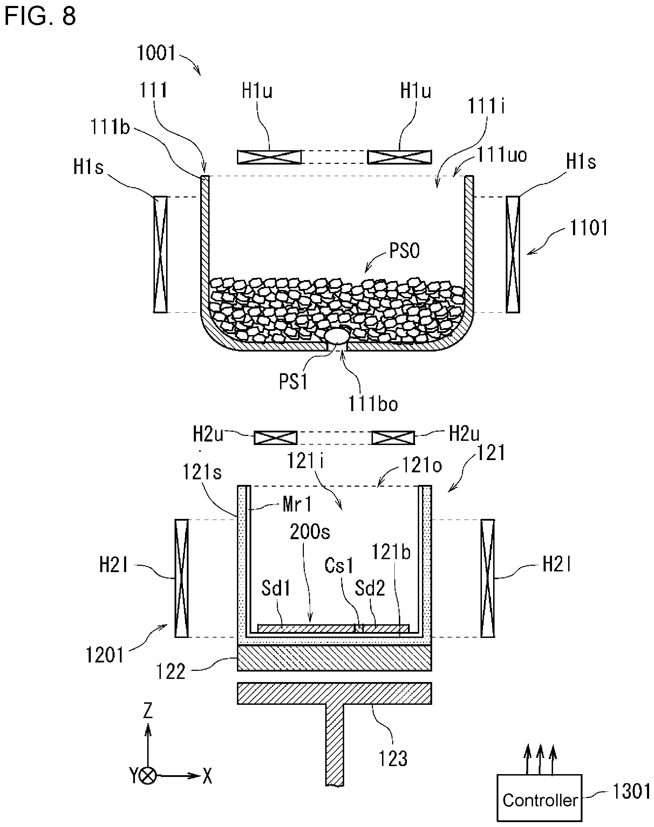

In step Sp23, as shown in FIG. 8, silicon lumps PS0 are placed in the first internal space 111i of the crucible 111. The silicon lumps PS0 are, for example, placed from the lower space toward the upper space of the crucible 111. The silicon lumps PS0 are, for example, mixed with an element to be a dopant in the silicon ingot In1. The silicon lumps PS0 are, for example polysilicon lumps as a material of the silicon ingot In1. The polysilicon lumps are, for example, relatively small silicon pieces. To manufacture a p-type silicon ingot In1, the dopant element is, for example, boron or gallium. To manufacture an n-type silicon ingot In1, the dopant element is, for example, phosphorus. In this example, the lower opening 111bo in the crucible 111 is filled with a silicon lump PS1 for obstruction (obstructive silicon lump). This obstructs, for example, the path from the first internal space 111i to the lower opening 111bo.

For example, the cooling plate 123 may remain separate from the lower surface of the mold holder 122 until the subsequent third process is started.

### Third Process

In the third process in step Sp3, for example, the seed crystal assembly 200s of silicon monocrystals placed on the bottom 121b of the mold 121 in the second process is heated to around the melting point of silicon, and the silicon melt MS1 is poured into the mold 121. More specifically, the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 are heated to around the melting point of silicon, and the silicon melt MS1 is poured into the mold 121.

In the third process, as shown in the example in FIG. 9, the second upper heater H2u above the mold 121 and the lower heater H2l lateral to the mold 121 raise the temperature of the silicon seed crystal assembly 200s to around 1414 °C or the melting point of silicon. For example, any silicon lumps in a solid state placed on the seed crystal assembly 200s of silicon monocrystals arranged on the bottom 121b of the mold 121 in the second process may be melted. In this case, the seed crystal assembly 200s in close contact with the bottom 121b of the mold 121 transfers heat to the bottom 121b and thus remains unmelted.

In the third process, as shown in the example in FIG. 9, the silicon lumps PS0 placed in the crucible 111 are heated and melted into the silicon melt MS1 to be stored in the crucible 111. For example, the first upper heater H1u above the crucible 111 and the side heater H1s lateral to the crucible 111 heat the silicon lumps PS0 to a temperature range of about 1414 to 1500 °C exceeding the melting point of silicon to obtain the silicon melt MS1. In FIG. 9, hatched arrows indicate heat from the heaters. In this state, the obstructive silicon lump PS1 on the lower opening 111bo obstructing the path in the crucible 111 is heated and thus melted. The obstructive silicon lump PS1 may be melted by a dedicated heater. The molten obstructive silicon lump PS1 opens the path from the first internal space 111i in the crucible 111 to the lower opening 111bo.This allows the silicon melt MS1 in the crucible 111 to be poured into the mold 121 through the lower opening 111bo.Thus, as in the example in FIG. 9, the silicon melt MS1 covers the upper surface of the seed crystal assembly 200s of silicon monocrystals arranged on the bottom 121b of the mold 121.

In the third process, as shown in the example in FIG. 9, the cooling plate 123 is placed into contact with the lower surface of the mold holder 122. This allows, for example, heat removal from the silicon melt MS1 in the mold 121 to the cooling plate 123 through the mold holder 122. In FIG. 9, solid arrows indicate rising of the cooling plate 123, and outlined arrows indicate transfer of heat from the silicon melt MS1 to the cooling plate 123 through the mold holder 122. The cooling plate 123 may be placed into contact with the lower surface of the mold holder 122 upon, for example, a predetermined elapsed time after the silicon melt MS1 is started to be poured into the mold 121 from the crucible 111 (contacting moment). In another example, the contacting moment may be immediately before the silicon melt MS1 is started to be poured into the mold 121 from the crucible 111. The contacting moment may be controlled in accordance with the temperature detected by the temperature measurers in the first manufacturing apparatus 1001, such as the first temperature measurer CHA and the second temperature measurer CHB.

### Fourth Process

In the fourth process in step Sp4, for example, the silicon melt MS1 poured into the mold 121 in the third process solidifies unidirectionally (unidirectional solidification) upward from the bottom 121b of the mold 121.

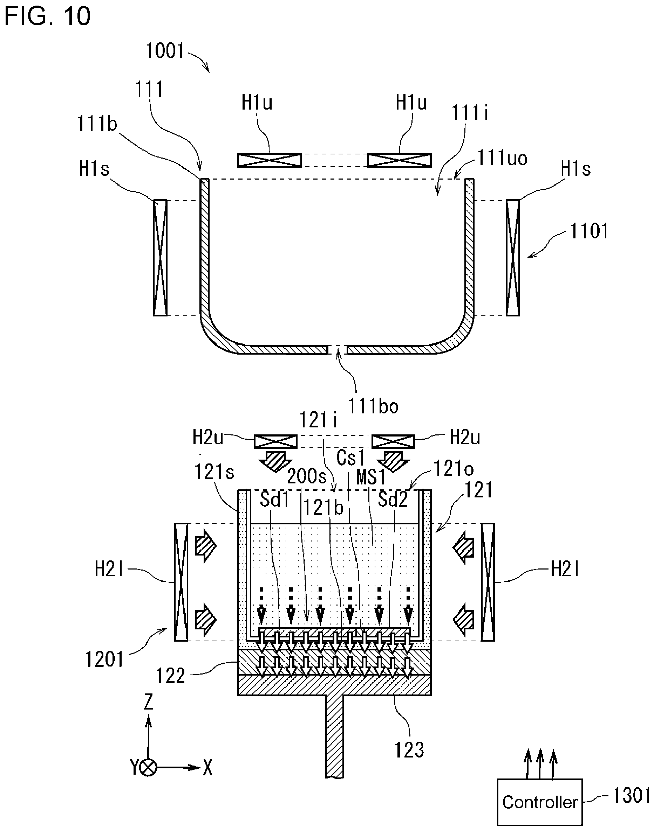

In the fourth process, as shown in the example in FIG. 10, the silicon melt MS 1 in the mold 121 is cooled from the bottom 121b as heat transfers from the silicon melt MS1 in the mold 121 to the cooling plate 123 through the mold holder 122. This allows, for example, unidirectional solidification of the silicon melt MS1 upward from the bottom 121b. In FIG. 10, thick dashed arrows indicate transfer of heat in the silicon melt MS1, and outlined arrows indicate transfer of heat from the silicon melt MS1 to the cooling plate 123 through the mold holder 122. For example, the outputs from the second upper heater H2u above the mold 121 and the lower heater H2l lateral to the mold 121 are controlled in accordance with the temperatures detected using, for example, the first temperature measurer CHA and the second temperature measurer CHB. In FIG. 10, hatched arrows indicate heat from the heaters. For example, the temperatures around the second upper heater H2u and the lower heater H2l are maintained at around the melting point of silicon. This reduces silicon crystal growth from the side surface of the mold 121 and increases the crystal growth of monocrystalline silicon in the positive Z-direction or upward. The lower heater H2l may be divided into multiple sections, for example. In this case, the second upper heater H2u and a section of the divided lower heater H2l may heat the silicon melt MS1, and another section of the divided lower heater H2l may not heat the silicon melt MS 1.

In the fourth process, for example, the silicon melt MS1 slowly solidifies unidirectionally into silicon ingot In1 in the mold 121. During the solidification, for example, mono-like crystals grow from the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 included in the seed crystal assembly 200s of monocrystalline silicon.

For example, a mono-like crystal grown from the first seed crystal Sd1 and a mono-like crystal grown from the first intermediate seed crystal Cs1 have the first rotation angle relationship inherited from the first seed crystal Sd1 and the first intermediate seed crystal Cs1. A grain boundary (functional grain boundary) including a coincidence boundary may form between such mono-like crystals. In other words, a coincidence boundary may form above the boundary between the first seed crystal Sd1 and the first intermediate seed crystal Cs1. Similarly, for example, a mono-like crystal grown from the first intermediate seed crystal Cs1 and a mono-like crystal grown from the second seed crystal Sd2 have the second rotation angle relationship inherited from the first intermediate seed crystal Cs1 and the second seed crystal Sd2. A functional grain boundary including a coincidence boundary may form at the boundary between such mono-like crystals. In other words, a coincidence boundary may form above the boundary between the first intermediate seed crystal Cs1 and the second seed crystal Sd2. Thus, while the silicon melt MS1 is solidifying unidirectionally, distortions are reduced as the coincidence boundaries form constantly. This may reduce defects in the silicon ingot In1. For example, while the silicon melt MS1 is solidifying unidirectionally, the first seed crystal Sd1 and the second seed crystal Sd2 tend to have dislocations relative to each other. However, the dislocations are likely to disappear at the two functional grain boundaries, being confined in the mono-like crystal portion between the two functional grain boundaries. For example, the third seed width Ws3 of the first intermediate seed crystal Cs1 is less than the first seed width Ws1 of the first seed crystal Sd1 and the second seed width Ws2 of the second seed crystal Sd2. In this case, the resultant silicon ingot In1 may have fewer defects.

For example, a mono-like crystal grown from the first seed crystal Sd1 and a mono-like crystal grown from the second intermediate seed crystal Cs2 have the third rotation angle relationship inherited from the first seed crystal Sd1 and the second intermediate seed crystal Cs2. A functional grain boundary including a coincidence boundary may form at the boundary between such mono-like crystals. In other words, a coincidence boundary may form above the boundary between the first seed crystal Sd1 and the second intermediate seed crystal Cs2. Similarly, for example, a mono-like crystal grown from the second intermediate seed crystal Cs2 and a mono-like crystal grown from the third seed crystal Sd3 have the fourth rotation angle relationship inherited from the second intermediate seed crystal Cs2 and the third seed crystal Sd3. A functional grain boundary including a coincidence boundary may form at the boundary between such mono-like crystals. In other words, a coincidence boundary may form above the boundary between the second intermediate seed crystal Cs2 and the third seed crystal Sd3. Thus, while the silicon melt MS1 is solidifying unidirectionally, distortions are reduced as the coincidence boundaries form constantly. This may reduce defects in the silicon ingot In1. For example, while the silicon melt MS1 is solidifying unidirectionally, the first seed crystal Sd1 and the third seed crystal Sd3 tend to have dislocations relative to each other. However, the dislocations are likely to disappear at the two functional grain boundaries, being confined in the mono-like crystal portion between the two functional grain boundaries. For example, the sixth seed width Ws6 of the second intermediate seed crystal Cs2 is less than the fourth seed width Ws4 of the first seed crystal Sd1 and the fifth seed width Ws5 of the third seed crystal Sd3. In this case, the resultant silicon ingot In1 may have fewer defects.

For example, a mono-like crystal grown from the second seed crystal Sd2 and a mono-like crystal grown from the third intermediate seed crystal Cs3 have the fifth rotation angle relationship inherited from the second seed crystal Sd2 and the third intermediate seed crystal Cs3. A functional grain boundary including a coincidence boundary may form at the boundary between such mono-like crystals. In other words, a coincidence boundary may form above the boundary between the second seed crystal Sd2 and the third intermediate seed crystal Cs3. Similarly, for example, a mono-like crystal grown from the third intermediate seed crystal Cs3 and a mono-like crystal grown from the fourth seed crystal Sd4 have the sixth rotation angle relationship inherited from the third intermediate seed crystal Cs3 and the fourth seed crystal Sd4. A functional grain boundary including a coincidence boundary may form at the boundary between such mono-like crystals. In other words, a coincidence boundary may form above the boundary between the third intermediate seed crystal Cs3 and the fourth seed crystal Sd4. Thus, while the silicon melt MS1 is solidifying unidirectionally, distortions are reduced as the coincidence boundaries form constantly. This may reduce defects in the silicon ingot In1. For example, while the silicon melt MS1 is solidifying unidirectionally, the second seed crystal Sd2 and the fourth seed crystal Sd4 tend to have dislocations relative to each other. However, the dislocations are likely to disappear at the two functional grain boundaries, being confined in the mono-like crystal portion between the two functional grain boundaries. For example, the ninth seed width Ws9 of the third intermediate seed crystal Cs3 is less than the seventh seed width Ws7 of the second seed crystal Sd2 and the eighth seed width Ws8 of the fourth seed crystal Sd4. In this case, the resultant silicon ingot In1 may have fewer defects.

For example, a mono-like crystal grown from the third seed crystal Sd3 and a mono-like crystal grown from the fourth intermediate seed crystal Cs4 have the seventh rotation angle relationship inherited from the third seed crystal Sd3 and the fourth intermediate seed crystal Cs4. A functional grain boundary including a coincidence boundary may form at the boundary between such mono-like crystals. In other words, a coincidence boundary may form above the boundary between the third seed crystal Sd3 and the fourth intermediate seed crystal Cs4. Similarly, for example, a mono-like crystal grown from the fourth intermediate seed crystal Cs4 and a mono-like crystal grown from the fourth seed crystal Sd4 have the eighth rotation angle relationship inherited from the fourth intermediate seed crystal Cs4 and the fourth seed crystal Sd4. A functional grain boundary including a coincidence boundary may form at the boundary between such mono-like crystals. In other words, a coincidence boundary may form above the boundary between the fourth intermediate seed crystal Cs4 and the fourth seed crystal Sd4. Thus, while the silicon melt MS1 is solidifying unidirectionally, distortions are reduced as the coincidence boundaries form constantly. This may reduce defects in the silicon ingot In1. For example, while the silicon melt MS1 is solidifying unidirectionally, the third seed crystal Sd3 and the fourth seed crystal Sd4 tend to have dislocations relative to each other. However, the dislocations are likely to disappear at the two functional grain boundaries, being confined in the mono-like crystal portion between the two functional grain boundaries. For example, the twelfth seed width Ws12 of the fourth intermediate seed crystal Cs4 is less than the tenth seed width Ws10 of the third seed crystal Sd3 and the eleventh seed width Ws11 of the fourth seed crystal Sd4. In this case, the resultant silicon ingot In1 may have fewer defects.

In this manner, for example, the resultant silicon ingot In1 may have fewer defects and thus have higher quality.

In the second process, for example, the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 may be arranged to allow each of the first to eighth rotation angle relationships to be a rotation angle relationship corresponding to a ∑ 29 coincidence boundary about an imaginary rotation axis parallel to a direction having the Miller indices of <100>. In this case, while the silicon melt MS1 is solidifying unidirectionally, ∑ 29 coincidence boundary (random boundary) may form above each of the boundary between the first seed crystal Sd1 and the first intermediate seed crystal Cs1, the boundary between the first intermediate seed crystal Cs1 and the second seed crystal Sd2, the boundary between the first seed crystal Sd1 and the second intermediate seed crystal Cs2, the boundary between the second intermediate seed crystal Cs2 and the third seed crystal Sd3, the boundary between the second seed crystal Sd2 and the third intermediate seed crystal Cs3, the boundary between the third intermediate seed crystal Cs3 and the fourth intermediate seed crystal Cs4, and the boundary between the fourth intermediate seed crystal Cs4 and the fourth seed crystal Sd4. For example, the random boundaries reduce distortions to cause fewer defects. The resultant silicon ingot In1 may thus have, for example, still fewer defects. Thus, the quality of the silicon ingot In1 may further be improved.

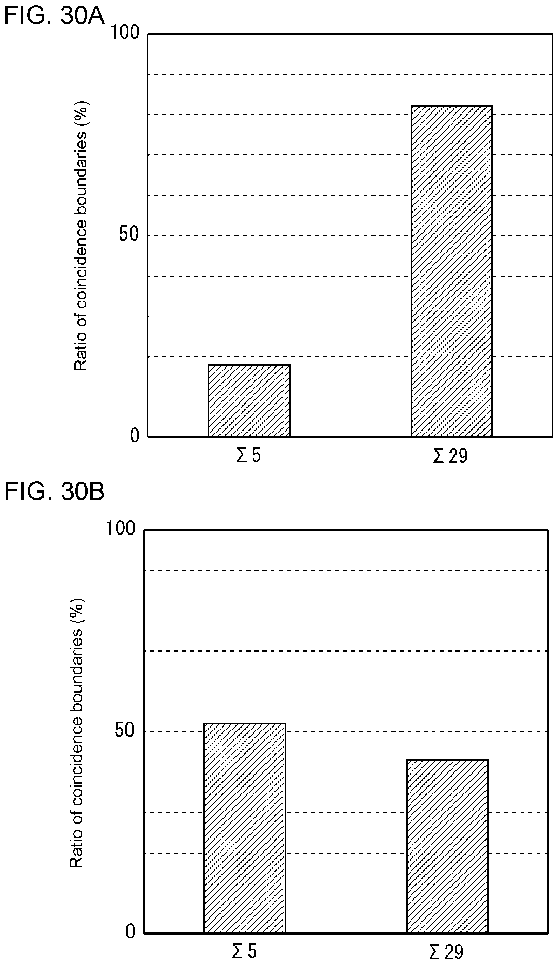

For example, the silicon ingot In1 may have a first portion including one end (first end) and a second portion including the other end (second end) opposite the first end. When the silicon ingot In1 has a total length of 100 from the first end to the second end, the first portion may extend, for example, from 0 to about 30 with the first end being the basal end. The second portion may extend, for example, from about 50 to 100 with the first end being the basal end. The first portion may have a higher ratio of Σ29 coincidence boundaries (random boundaries) than the second portion. Thus, for example, the random boundaries in the first portion reduce distortions to cause fewer defects. For example, the silicon ingot In1 manufactured using unidirectional solidification of the silicon melt MS1 may have fewer defects in the first portion at a low position in the height direction. Thus, the silicon ingot In1 may have higher quality. The second portion may have a higher ratio of Σ5 coincidence boundaries than the first portion. This may improve the crystal quality in the second portion. The coincidence boundaries and the types of coincidence boundaries in the silicon ingot In1 may be identified by measurement using EBSDs or other techniques. In this example, the portion including Σ5 coincidence boundaries includes a portion in which Σ29 coincidence boundaries and Σ5 coincidence boundaries are both detected. The above measurement reveals, as shown in FIGs. 30A and 30B, that the portion of the silicon ingot In1 at a height of 5% from the first end has a higher ratio of Σ29 coincidence boundaries (random boundaries) than the portion at a height of 50% from the first end. The above measurement also reveals, as shown in FIGs. 30A and 30B, that the portion of the silicon ingot In1 at a height of 50% from the first end has a higher ratio of ∑S coincidence boundaries than the portion at a height of 5% from the first end.

In the second process, the first seed width Ws1 of the first seed crystal Sd1 and the second seed width Ws2 of the second seed crystal Sd2 in the positive X-direction as the second direction may be, for example, the same or different. The fourth seed width Ws4 of the first seed crystal Sd1 and the fifth seed width Ws5 of the third seed crystal Sd3 in the positive Y-direction as the third direction may be the same or different. The seventh seed width Ws7 of the second seed crystal Sd2 and the eighth seed width Ws8 of the fourth seed crystal Sd4 in the positive Y-direction as the third direction may be the same or different. The tenth seed width Ws10 of the third seed crystal Sd3 and the eleventh seed width Ws11 of the fourth seed crystal Sd4 in the positive X-direction as the second direction may be the same or different. For example, the widths may be different in at least one of a pair of the first seed width Ws1 and the second seed width Ws2, a pair of the fourth seed width Ws4 and the fifth seed width Ws5, a pair of the seventh seed width Ws7 and the eighth seed width Ws8, and a pair of the tenth seed width Ws10 and the eleventh seed width Ws11. In this case, the seed crystal strips having different widths cut out from the cylindrical monocrystalline silicon lump Mc0 obtained by, for example, the CZ method may be used as the first seed crystal Sd1, the second seed crystal Sd2, the third seed crystal Sd3, and the fourth seed crystal Sd4. This allows, for example, easy manufacture of the high quality silicon ingot In1.

In this example, as shown in FIGs. 5A and 5B, a gap GA1 may be left between the outer periphery of the seed crystal assembly 200s and the side surface of the inner wall (inner side surface) of the mold 121. For example, one or more seed crystals (peripheral seed crystals) of monocrystalline silicon may be placed in the gap GA1 adjacent to the seed crystal assembly 200s. In this case, for example, one or more monocrystals may be placed along the periphery of the bottom 121b of the mold 121 to fill the looped gap GA1 between the outer periphery of the seed crystal assembly 200s and the inner side surface of the mold 121. In the example in FIGs. 5A and 5B, the peripheral seed crystal(s) may include, for example, a first peripheral seed portion, a second peripheral seed portion, a third peripheral seed portion, and a fourth peripheral seed portion. The first peripheral seed portion is adjacent to the first seed crystal Sd1. The second peripheral seed portion is adjacent to the second seed crystal Sd2. The third peripheral seed portion is adjacent to the third seed crystal Sd3. The fourth peripheral seed portion is adjacent to the fourth seed crystal Sd4.

For example, the first seed crystal Sd1 and the first peripheral seed portion are arranged to allow their rotation angle relationship about an imaginary axis parallel to the positive Z-direction as the first direction to be a rotation angle relationship of silicon monocrystals corresponding to a coincidence boundary. For example, the second seed crystal Sd2 and the second peripheral seed portion are arranged to allow their rotation angle relationship about an imaginary axis parallel to the positive Z-direction as the first direction to be a rotation angle relationship of silicon monocrystals corresponding to a coincidence boundary. For example, the third seed crystal Sd3 and the third peripheral seed portion are arranged to allow their rotation angle relationship about an imaginary axis parallel to the positive Z-direction as the first direction to be a rotation angle relationship of silicon monocrystals corresponding to a coincidence boundary. For example, the fourth seed crystal Sd4 and the fourth peripheral seed portion are arranged to allow their rotation angle relationship about an imaginary axis parallel to the positive Z-direction as the first direction to be a rotation angle relationship of silicon monocrystals corresponding to a coincidence boundary.

In this structure, for example, a mono-like crystal grown from the first seed crystal Sd1 and a mono-like crystal grown from the first peripheral seed portion have the rotation angle relationship inherited from the first seed crystal Sd1 and the first peripheral seed portion. A functional grain boundary including a coincidence boundary may form easily at the boundary between such mono-like crystals. In other words, a coincidence boundary may form above the boundary between the first seed crystal Sd1 and the first peripheral seed portion. Similarly, for example, a mono-like crystal grown from the second seed crystal Sd2 and a mono-like crystal grown from the second peripheral seed portion have the rotation angle relationship inherited from the second seed crystal Sd2 and the second peripheral seed portion. A functional grain boundary including a coincidence boundary may form easily at the boundary between such mono-like crystals. In other words, a coincidence boundary may form above the boundary between the second seed crystal Sd2 and the second peripheral seed portion. Similarly, for example, a mono-like crystal grown from the third seed crystal Sd3 and a mono-like crystal grown from the third peripheral seed portion have the rotation angle relationship inherited from the third seed crystal Sd3 and the third peripheral seed portion. A functional grain boundary including a coincidence boundary may form easily at the boundary between such mono-like crystals. In other words, a coincidence boundary may form above the boundary between the third seed crystal Sd3 and the third peripheral seed portion. Similarly, for example, a mono-like crystal grown from the fourth seed crystal Sd4 and a mono-like crystal grown from the fourth peripheral seed portion have the rotation angle relationship inherited from the fourth seed crystal Sd4 and the fourth peripheral seed portion. A functional grain boundary including a coincidence boundary may form easily at the boundary between such mono-like crystals. In other words, a coincidence boundary may form above the boundary between the fourth seed crystal Sd4 and the fourth peripheral seed portion.

Thus, while the silicon melt MS1 is solidifying unidirectionally, distortions are reduced as the coincidence boundaries form constantly. This may reduce defects in the silicon ingot In1. For example, while the silicon melt MS1 is solidifying unidirectionally, dislocations may occur originating from the inner side surface of the mold 121. However, the functional grain boundaries forming in a loop along the inner side surface of the mold 121 may obstructs development (propagation) of the dislocations. This may reduce defects in the mono-like crystals grown from the first seed crystal Sd1, the second seed crystal Sd2, the third seed crystal Sd3, and the fourth seed crystal Sd4. In other words, the resultant silicon ingot In1 may have fewer defects.

For the example manufacturing method for the silicon ingot In1 using the first manufacturing apparatus 1001 described above, the seed crystal assembly 200s includes two seed crystals and an intermediate seed crystal between the two seed crystals arranged in the positive X-direction as the second direction. The seed crystal assembly 200s also includes two seed crystals and an intermediate seed between the two seed crystals arranged in the positive Y-direction as the third direction. However, the structure is not limited to this example. The seed crystal assembly 200s may include, for example, three or more seed crystals and intermediate seed crystals each between adjacent ones of the three or more seed crystals arranged in the positive X-direction as the second direction. In this case, for example, two or more intermediate seed crystals arranged in the second direction (positive X-direction) at intervals and an intermediate seed crystal extending in the second direction (positive X-direction) cross each other at two or more points. This may upsize, for example, the silicon ingot In1 further. The seed crystal assembly 200s may include, for example, three or more seed crystals and intermediate seed crystals each between adjacent ones of the three or more seed crystals arranged in the positive Y-direction as the third direction. In this case, for example, two or more intermediate seed crystals arranged in the third direction (positive Y-direction) at intervals and an intermediate seed crystal extending in the third direction (positive Y-direction) cross each other at two or more points. This may upsize, for example, the silicon ingot In1 further.

### 1-2-2. Manufacturing Method for Silicon Ingot Using Second Manufacturing Apparatus

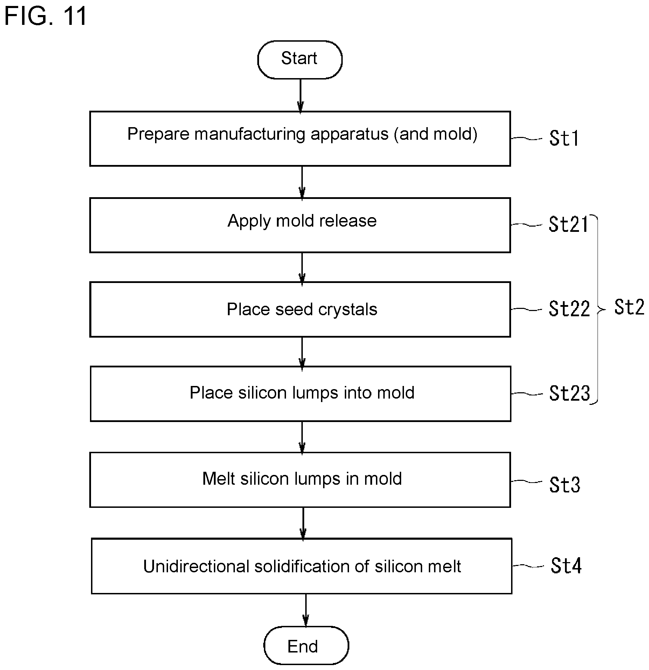

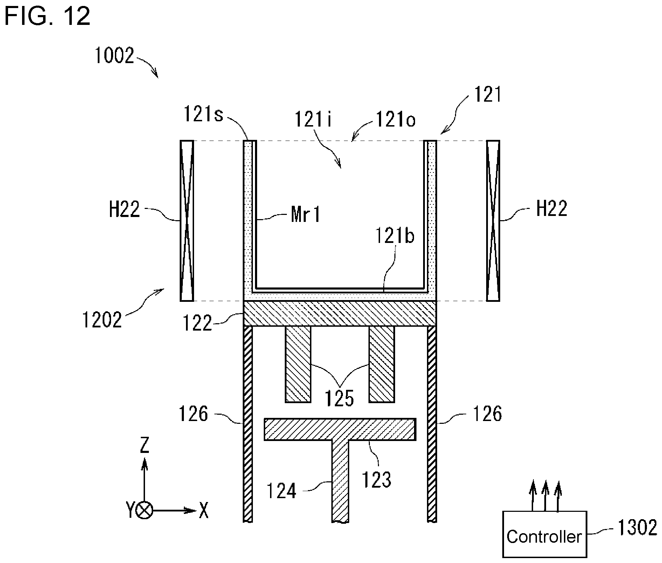

A manufacturing method for the silicon ingot In1 using the second manufacturing apparatus 1002 will be described with reference to FIGs. 11 to 16. As shown in FIG. 11, the manufacturing method for the silicon ingot In1 using the second manufacturing apparatus 1002 includes, for example, a first process in step St1, a second process in step St2, a third process in step St3, and a fourth process in step St4 performed in this order. The method allows easy manufacture of the high quality silicon ingot In1 with the crystal orientations aligned. FIGs. 12 to 16 show the state of the mold 121 in each process.

### First Process

In the first process in step St1, the second manufacturing apparatus 1002 described above is prepared. The second manufacturing apparatus 1002 includes, for example, a mold 121 having an upper opening 121o that is open in the positive Z-direction as the first direction. Second Process

In the second process in step St2, for example, a seed crystal assembly 200s of silicon monocrystals is placed on the bottom of the mold 121 prepared in the first process. In the second process, three steps including step St21, step St22, and step St23 are performed in this order.

In step St21, as shown in the example in FIG. 12, a mold release is applied to the inner wall surface of the mold 121 to form a mold release layer Mr1. This mold release layer Mr1 may be formed in the same manner as in step Sp21 in FIG. 3 described above.

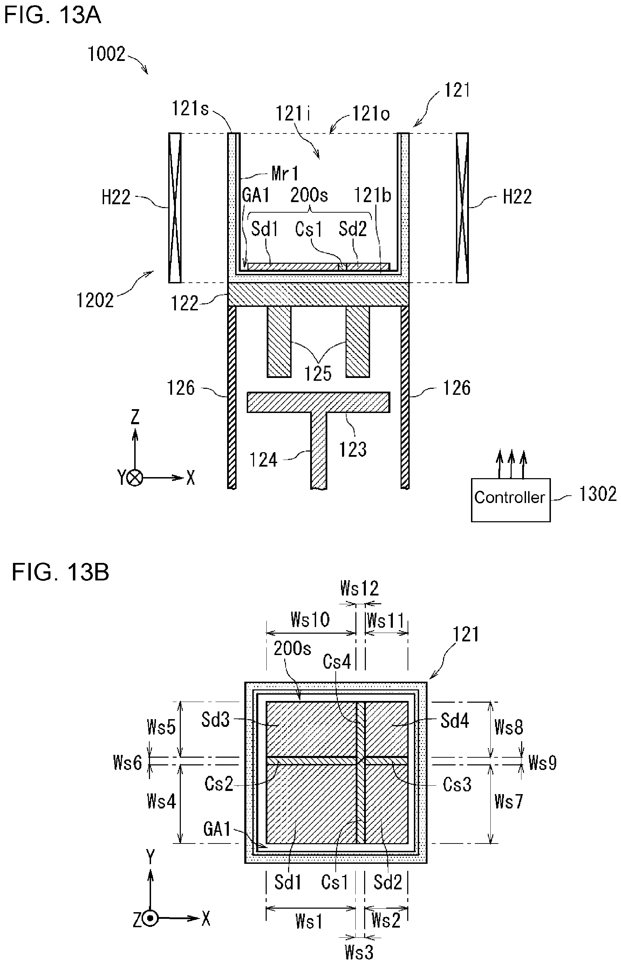

In the step St22, as shown in FIGs. 13A and 13B, the seed crystal assembly 200s is placed on the bottom 121b of the mold 121. The seed crystal assembly 200s may be placed in the same manner as in step Sp22 in FIG. 3 described above.

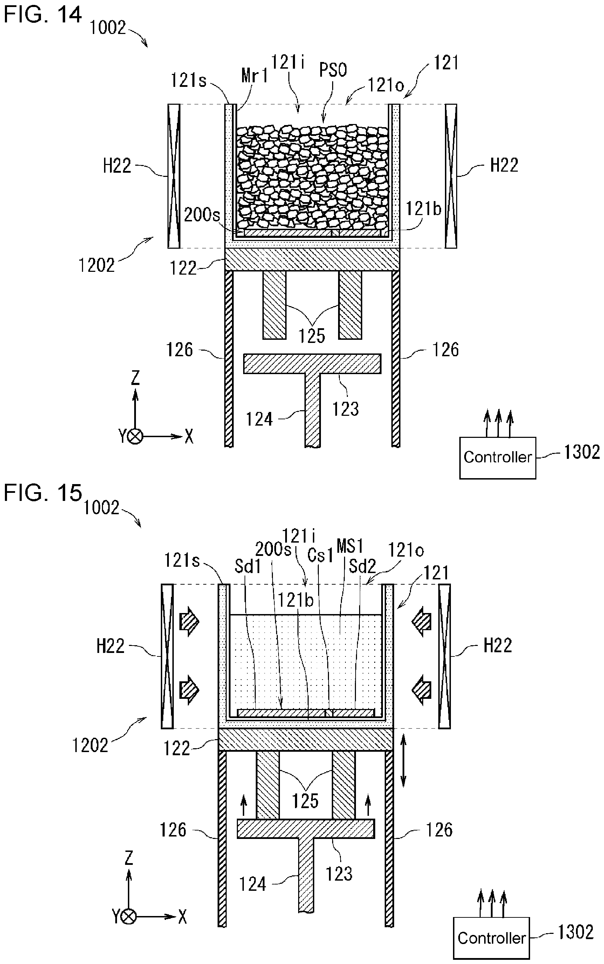

In step St23, as shown in FIG. 14, silicon lumps PS0 are placed onto the seed crystal assembly 200s of silicon monocrystals placed on the bottom 121b of the mold 121. In this example, the silicon lumps PS0 are placed from the upper surface of the seed crystal assembly 200s of silicon monocrystals placed on the bottom 121b of the mold 121 toward the upper space of the mold 121. The silicon lumps PS0 are, for example, mixed with an element to be a dopant in the silicon ingot In1. The silicon lumps PS0 are, for example polysilicon lumps as a material of the silicon ingot In1. The polysilicon lumps are, for example, relatively small silicon pieces. To manufacture a p-type silicon ingot In1, the dopant element is, for example, boron or gallium. To manufacture an n-type silicon ingot In1, the dopant element is, for example, phosphorus. In this example, before the subsequent third process is started, the cooling plate 123 is separate from the lower end of the heat conductor 125 connected to the mold holder 122.

### Third Process

In the third process in step St3, as shown in the example in FIG. 15, the silicon lumps PS0 on the seed crystal assembly 200s placed in the second process are heated by the side heater H22 to be melted in the mold 121. This produces silicon melt MS1. Thus, for example, the silicon lumps PS0 are melted in the mold 121 into the silicon melt MS1 on the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4. For example, the output from the side heater H22 and the raising and lowering of the mold 121 performed by the mold support 126 are controlled as appropriate. In FIG. 15, hatched arrows indicate heat from the heater, and solid arrows indicate raising and lowering of the cooling plate 123 and the mold 121. In this example, the seed crystal assembly 200s in close contact with the bottom 121b of the mold 121 may transfer heat from the seed crystal assembly 200s to the bottom 121b and remain unmelted. Thus, as in the example in FIG. 15, the silicon melt MS 1 covers the upper surface of the monocrystalline silicon seed crystal assembly 200s placed on the bottom 121b of the mold 121.

In the third process, as shown in the example in FIG. 15, the cooling plate 123 is placed into contact with the lower end of the heat conductor 125. This allows, for example, heat removal from the silicon melt MS1 in the mold 121 to the cooling plate 123 through the mold holder 122 and the heat conductor 125. The cooling plate 123 may be placed into contact with the lower end of the heat conductor 125 upon, for example, a predetermined elapsed time after the silicon lumps PS0 are started to be melted in the mold 121 (contacting moment). In another example, the contacting moment may be immediately before the silicon lumps PS0 are started to be melted in the mold 121. The contacting moment may be controlled in accordance with the temperature detected by the temperature measurers in the second manufacturing apparatus 1002, such as the first temperature measurer CHA and the second temperature measurer CHB.

### Fourth Process

In the fourth process in step St4, for example, the silicon melt MS1 produced in the mold 121 in the third process solidifies unidirectionally (unidirectional solidification) upward from the bottom 121b of the mold 121.

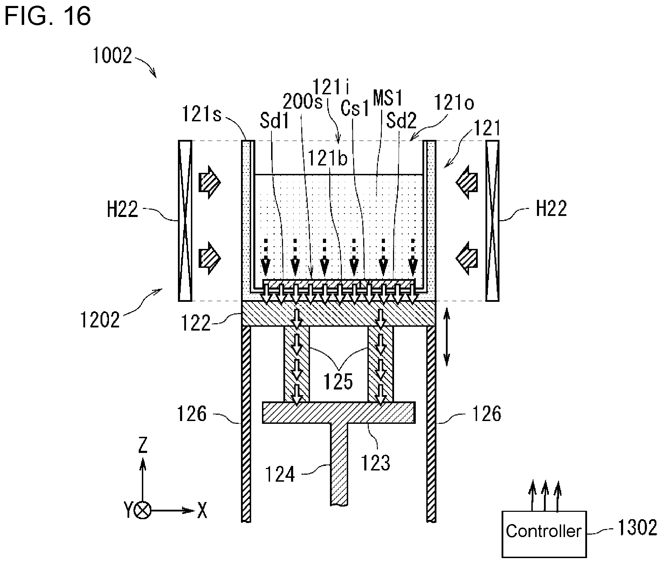

In the fourth process, as shown in the example in FIG. 16, the silicon melt MS 1 in the mold 121 is cooled from the bottom 121b as heat transfers from the silicon melt MS1 in the mold 121 to the cooling plate 123 through the mold holder 122 and the heat conductor 125. This allows, for example, unidirectional solidification of the silicon melt MS1 upward from the bottom 121b. In FIG. 16, thick dashed arrows indicate transfer of heat in the silicon melt MS1, and outlined arrows indicate transfer of heat from the silicon melt MS1 to the cooling plate 123 through the mold holder 122 and the heat conductor 125. In this example, the output from the side heater H22 and the raising and lowering of the mold 121 performed by the mold support 126 are controlled in accordance with the temperature detected with the first temperature measurer CHA and the second temperature measurer CHB. In FIG. 16, hatched arrows indicate heat from the heater, and solid arrows indicate raising and lowering of the mold 121. For example, the temperature around the side heater H22 is maintained at around the melting point of silicon. This reduces silicon crystal growth from the side surfaces of the mold 121 and increases the crystal growth of monocrystalline silicon in the positive Z-direction or upward. For example, the side heater H22 may be divided into multiple sections. In this case, a section of the divided side heater H22 may heat the silicon melt MS1, and another section of the divided side heater H22 may not heat the silicon melt MS1.

In the fourth process, for example, the silicon melt MS1 slowly solidifies unidirectionally into the silicon ingot In1 in the mold 121, in the same manner as in step Sp4 in the fourth process in FIG. 3. During the solidification, for example, mono-like crystals grow from the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4 included in the monocrystalline silicon seed crystal assembly 200s.

For the example manufacturing method for the silicon ingot In1 using the second manufacturing apparatus 1002, a gap GA1 may also be left between the outer periphery of the seed crystal assembly 200s and the inner side surface of the mold 121, in the same manner as the example manufacturing method for the silicon ingot In1 using the first manufacturing apparatus 1001 described above. For example, one or more seed crystals (peripheral seed crystals) of monocrystalline silicon may be placed in the gap GA1 adjacent to the seed crystal assembly 200s. While the silicon melt MS1 is solidifying unidirectionally, dislocations may occur originating from the inner side surface of the mold 121. However, the functional grain boundaries forming in a loop along the inner side surface of the mold 121 may obstruct development (propagation) of the dislocations. Thus, the resultant silicon ingot In1 may have fewer defects. The seed crystal assembly 200s may include, for example, three or more seed crystals and intermediate seed crystals each between adjacent ones of the three or more seed crystals arranged in the positive X-direction as the second direction. The seed crystal assembly 200s may include, for example, three or more seed crystals and intermediate seed crystals each between adjacent ones of the three or more seed crystals arranged in the positive Y-direction as the third direction. This may upsize, for example, the silicon ingot In1 further. 1-3. Silicon Ingot

The silicon ingot In1 according to a first embodiment will be described with reference to FIGs. 17A and 17B. In the example in FIGs. 17A and 17B, the silicon ingot In1 is a rectangular prism. The silicon ingot In1 may be manufactured with, for example, the method for manufacturing the silicon ingot In1 using the first manufacturing apparatus 1001 or the second manufacturing apparatus 1002 described above.

As shown in FIGs. 17A and 17B, the silicon ingot In1 has, for example, a first surface F1, a second surface F2, and a third surface F3. In the example in FIGs. 17A and 17B, the first surface F1 is rectangular or square surface (upper surface) facing in the positive Z-direction as the first direction. The second surface F2 is located opposite to the first surface F1. In the example in FIGs. 17A and 17B, the second surface F2 is rectangular or square surface (lower surface) facing in the negative Z-direction as a fourth direction, which is opposite to the first direction. The third surface F3 extends in the first direction to connect the first surface F1 and the second surface F2. In the example in FIGs. 17A and 17B, the third surface F3 extends in the positive Z-direction as the first direction to connect the upper surface and lower surface, and includes four surfaces (side surfaces) extending in the positive Z-direction as the first direction.

The silicon ingot In1 includes, for example, a first mono-like crystalline portion Am1, a second mono-like crystalline portion Am2, a third mono-like crystalline portion Am3, a fourth mono-like crystalline portion Am4, a first intermediate portion Ac1, a second intermediate portion Ac2, a third intermediate portion Ac3, and a fourth intermediate portion Ac4. For example, the first mono-like crystalline portion Am1, the first intermediate portion Ac1, and the second mono-like crystalline portion Am2 are adjacent to one another in the stated order in the positive X-direction as the second direction, which is perpendicular to the positive Z-direction as the first direction. For example, the first mono-like crystalline portion Am1, the second intermediate portion Ac2, and the third mono-like crystalline portion Am3 are adjacent to one another in the stated order in the positive Y-direction as the third direction, which is perpendicular to the positive Z-direction as the first direction and crosses the positive X-direction as the second direction. For example, the second mono-like crystalline portion Am2, the third intermediate portion Ac3, and the fourth mono-like crystalline portion Am4 are adj acent to one another in the stated order in the positive Y-direction as the third direction. For example, the third mono-like crystalline portion Am3, the fourth intermediate portion Ac4, and the fourth mono-like crystalline portion Am4 are adjacent to one another in the stated order in the positive X-direction as the second direction. Each of the first mono-like crystalline portion Am1, the second mono-like crystalline portion Am2, the third mono-like crystalline portion Am3, and the fourth mono-like crystalline portion Am4 is a section of a mono-like crystal.

The first mono-like crystalline portion Am1 is, for example, a mono-like crystal portion (or simply a mono-like crystal) resulting from unidirectional solidification of the silicon melt MS1 from the first seed crystal Sd1. The first mono-like crystalline portion Am1 has a crystal structure and a crystal orientation inherited from the first seed crystal Sd1. The first mono-like crystalline portion Am1 thus includes, for example, a section corresponding to the first seed crystal Sd1 and a section above the section corresponding to the first seed crystal Sd1. In the example in FIGs. 17A and 17B, the section corresponding to the first seed crystal Sd1 is rectangular prismatic and has a rectangular upper surface facing in the positive Z-direction as the first direction and a rectangular lower surface facing in the negative Z-direction as the fourth direction. The first mono-like crystalline portion Am1 is rectangular prismatic and includes the section corresponding to the rectangular prismatic first seed crystal Sd1 as the lowest part.

The second mono-like crystalline portion Am2 is, for example, a mono-like crystal portion resulting from unidirectional solidification of the silicon melt MS1 from the second seed crystal Sd2. The second mono-like crystalline portion Am2 has a crystal structure and a crystal orientation inherited from the second seed crystal Sd2. The second mono-like crystalline portion Am2 thus includes, for example, a section corresponding to the second seed crystal Sd2 and a section above the section corresponding to the second seed crystal Sd2. In the example in FIGs. 17A and 17B, the section corresponding to the second seed crystal Sd2 is rectangular prismatic and has a rectangular upper surface facing in the positive Z-direction as the first direction and a rectangular lower surface facing in the negative Z-direction as the fourth direction. The second mono-like crystalline portion Am2 is rectangular prismatic and includes the section corresponding to the rectangular-prismatic second seed crystal Sd2 as the lowest part.

The third mono-like crystalline portion Am3 is, for example, a mono-like crystalline portion resulting from unidirectional solidification of the silicon melt MS1 from the third seed crystal Sd3. The third mono-like crystalline portion Am3 has a crystal structure and a crystal orientation inherited from the third seed crystal Sd3. The third mono-like crystalline portion Am3 thus includes, for example, a section corresponding to the third seed crystal Sd3 and a section above the section corresponding to the third seed crystal Sd3. In the example in FIGs. 17A and 17B, the section corresponding to the third seed crystal Sd3 is rectangular prismatic and has a rectangular upper surface facing in the positive Z-direction as the first direction and a rectangular lower surface facing in the negative Z-direction as the fourth direction. The third mono-like crystalline portion Am3 is rectangular prismatic and includes the section corresponding to the rectangular-prismatic third seed crystal Sd3 as the lowest part.

The fourth mono-like crystalline portion Am4 is, for example, a mono-like crystalline portion resulting from unidirectional solidification of the silicon melt MS1 from the fourth seed crystal Sd4. The fourth mono-like crystalline portion Am4 has a crystal structure and a crystal orientation inherited from the fourth seed crystal Sd4. The fourth mono-like crystalline portion Am4 thus includes, for example, a section corresponding to the fourth seed crystal Sd4 and a section above the section corresponding to the fourth seed crystal Sd4. In the example in FIGs. 17A and 17B, the section corresponding to the fourth seed crystal Sd4 is rectangular prismatic and has a rectangular upper surface facing in the positive Z-direction as the first direction and a rectangular lower surface facing in the negative Z-direction as the fourth direction. The fourth mono-like crystalline portion Am4 is rectangular prismatic and includes the section corresponding to the rectangular-prismatic fourth seed crystal Sd4 as the lowest part.

Each of the first intermediate portion Ac1, the second intermediate portion Ac2, the third intermediate portion Ac3, and the fourth intermediate portion Ac4 is a portion including one or more mono-like crystalline sections (or simply an intermediate portion).

The first intermediate portion Ac1 is, for example, a portion resulting from unidirectional solidification of the silicon melt MS1 from the first intermediate seed crystal Cs 1. The first intermediate portion Ac1 has a crystal structure and a crystal orientation inherited from the first intermediate seed crystal Cs1. The first intermediate portion Ac1 thus includes, for example, a section corresponding to the first intermediate seed crystal Cs1 and a section above the section corresponding to the first intermediate seed crystal Cs1. The second intermediate portion Ac2 is, for example, a portion resulting from unidirectional solidification of the silicon melt MS1 from the second intermediate seed crystal Cs2. The second intermediate portion Ac2 has a crystal structure and a crystal orientation inherited from the second intermediate seed crystal Cs2. The second intermediate portion Ac2 thus includes, for example, a section corresponding to the second intermediate seed crystal Cs2 and a section above the section corresponding to the second intermediate seed crystal Cs2. The third intermediate portion Ac3 is, for example, a portion resulting from unidirectional solidification of the silicon melt MS1 from the third intermediate seed crystal Cs3. The third intermediate portion Ac3 has a crystal structure and a crystal orientation inherited from the third intermediate seed crystal Cs3. The third intermediate portion Ac3 thus includes, for example, a section corresponding to the third intermediate seed crystal Cs3 and a section above the section corresponding to the third intermediate seed crystal Cs3. The fourth intermediate portion Ac4 is, for example, a portion resulting from unidirectional solidification of the silicon melt MS1 from the fourth intermediate seed crystal Cs4. The fourth intermediate portion Ac4 has a crystal structure and a crystal orientation inherited from the fourth intermediate seed crystal Cs4. The fourth intermediate portion Ac4 thus includes, for example, a section corresponding to the fourth intermediate seed crystal Cs4 and a section above the section corresponding to the fourth intermediate seed crystal Cs4.

In the example in FIGs. 17A and 17B, the section corresponding to each of the first intermediate seed crystal Cs1, the second intermediate seed crystal Cs2, the third intermediate seed crystal Cs3, and the fourth intermediate seed crystal Cs4 is rod-like and has a narrow rectangular upper surface facing in the positive Z-direction as the first direction and a narrow rectangular lower surface facing in the negative Z-direction as the fourth direction. The first intermediate portion Ac1 is a plate-like portion including the section corresponding to the rod-like first intermediate seed crystal Cs1 as the lowest part. Thus, for example, a boundary (first boundary) B1 between the first mono-like crystalline portion Am1 and the first intermediate portion Ac1 and a boundary (second boundary) B2 between the second mono-like crystalline portion Am2 and the first intermediate portion Ac1 are rectangular. The second intermediate portion Ac2 is a plate-like portion including the section corresponding to the rod-like second intermediate seed crystal Cs2 as the lowest part. Thus, for example, a boundary (third boundary) B3 between the first mono-like crystalline portion Am1 and the second intermediate portion Ac2 and a boundary (fourth boundary) B4 between the third mono-like crystalline portion Am3 and the second intermediate portion Ac2 are rectangular. The third intermediate portion Ac3 is a plate-like portion including the section corresponding to the rod-like third intermediate seed crystal Cs3 as the lowest part. Thus, for example, a boundary (fifth boundary) B5 between the second mono-like crystalline portion Am2 and the third intermediate portion Ac3 and a boundary (sixth boundary) B6 between the fourth mono-like crystalline portion Am4 and the third intermediate portion Ac3 are rectangular. The fourth intermediate portion Ac4 is a plate-like portion including the section corresponding to the rod-like fourth intermediate seed crystal Cs4 as the lowest part. Thus, for example, a boundary (seventh boundary) B7 between the third mono-like crystalline portion Am3 and the fourth intermediate portion Ac4 and a boundary (eighth boundary) B8 between the fourth mono-like crystalline portion Am4 and the fourth intermediate portion Ac4 are rectangular.

In this example, the first intermediate portion Ac1 and the fourth intermediate portion Ac4 are elongated in the positive Y-direction as the third direction. The first intermediate portion Ac1 and the fourth intermediate portion Ac4 may define, for example, a single plate-like section extending in the positive Y-direction as the third direction, or may be deviated from each other in the positive X-direction as the second direction. For example, the second intermediate portion Ac2 and the third intermediate portion Ac3 are elongated in the positive X-direction as the second direction. The second intermediate portion Ac2 and the third intermediate portion Ac3 may define, for example, a single plate-like section extending in the positive X-direction as the second direction, or may be deviated from each other in the positive Y-direction as the third direction. In the example in FIG. 17B, the section defined by the first intermediate portion Ac1 and the fourth intermediate portion Ac4 and the section defined by the second intermediate portion Ac2 and the third intermediate portion Ac3 cross each other in a cross shape.

For example, a width (first width) W1 of the first mono-like crystalline portion Am1 and a width (second width) W2 of the second mono-like crystalline portion Am2 each are greater than a width (third width) W3 of the first intermediate portion Ac1 in the positive X-direction as the second direction. For example, a width (fourth width) W4 of the first mono-like crystalline portion Am1 and a width (fifth width) W5 of the third mono-like crystalline portion Am3 each are also greater than a width (sixth width) W6 of the second intermediate portion Ac2 in the positive Y-direction as the third direction. For example, a width (seventh width) W7 of the second mono-like crystalline portion Am2 and a width (eighth width) W8 of the fourth mono-like crystalline portion Am4 each are also greater than a width (ninth width) W9 of the third intermediate portion Ac3 in the positive Y-direction as the third direction. For example, a width (tenth width) W10 of the third mono-like crystalline portion Am3 and a width (eleventh width) W11 of the fourth mono-like crystalline portion Am4 each are also greater than a width (twelfth width) W12 of the fourth intermediate portion Ac4 in the positive X-direction as the second direction.

For example, each of the first surface F1 and the second surface F2 of the silicon ingot In1 is rectangular or square, and is about 350 mm on a side. In this case, for example, each of the first width W1, the second width W2, the fourth width W4, the fifth width W5, the seventh width W7, the eighth width W8, the tenth width W10, and the eleventh width W11 is about 50 to 250 mm. Each of the third width W3, the sixth width W6, the ninth width W9, and the twelfth width W12 is, for example, about 2 to 25 mm.

For example, each of the first boundary B1, the second boundary B2, the third boundary B3, the fourth boundary B4, the fifth boundary B5, the sixth boundary B6, the seventh boundary B7, and the eighth boundary B8 includes a coincidence boundary. In this example, the surface of each of the first mono-like crystalline portion Am1, the second mono-like crystalline portion Am2, the third mono-like crystalline portion Am3, and the fourth mono-like crystalline portion Am4 perpendicular to the positive Z-direction as the first direction has the Miller indices of (100), and the surfaces of one or more mono-like crystals included in each of the first intermediate portion Ac1, the second intermediate portion Ac2, the third intermediate portion Ac3, and the fourth intermediate portion Ac4 perpendicular to the positive Z-direction as the first direction also has the Miller indices of (100). In other words, for example, the crystal direction of each of the first mono-like crystalline portion Am1, the second mono-like crystalline portion Am2, the third mono-like crystalline portion Am3, and the fourth mono-like crystalline portion Am4 parallel to the positive Z-direction as the first direction has the Miller indices of <100>, and the crystal direction of one or more mono-like crystals in each of the first intermediate portion Ac1, the second intermediate portion Ac2, the third intermediate portion Ac3, and the fourth intermediate portion Ac4 parallel to the positive Z-direction as the first direction also has the Miller indices of <100>.

In this case, for example, the coincidence boundary includes one of a ∑5 coincidence boundary, a ∑13 coincidence boundary, a ∑17 coincidence boundary, a ∑25 coincidence boundary, or a Σ29 coincidence boundary. The silicon ingot In1 with such a structure may be obtained by, for example, growing mono-like crystals from the seed crystal assembly 200s and forming a coincidence boundary above the boundary between each pair of a seed crystal and an intermediate seed crystal. While the coincidence boundary is forming, for example, distortions are reduced to cause fewer defects in the silicon ingot In1. Thus, the silicon ingot In1 with the above structure suited to the manufacture of the silicon ingot In1 causing fewer defects may have higher quality with fewer defects. The coincidence boundaries and the ratio of each type of coincidence boundary may be identified in each of the first boundary B1, the second boundary B2, the third boundary B3, the fourth boundary B4, the fifth boundary B5, the sixth boundary B6, the seventh boundary B7, and the eighth boundary B8 by measurement using EBSDs or other techniques.

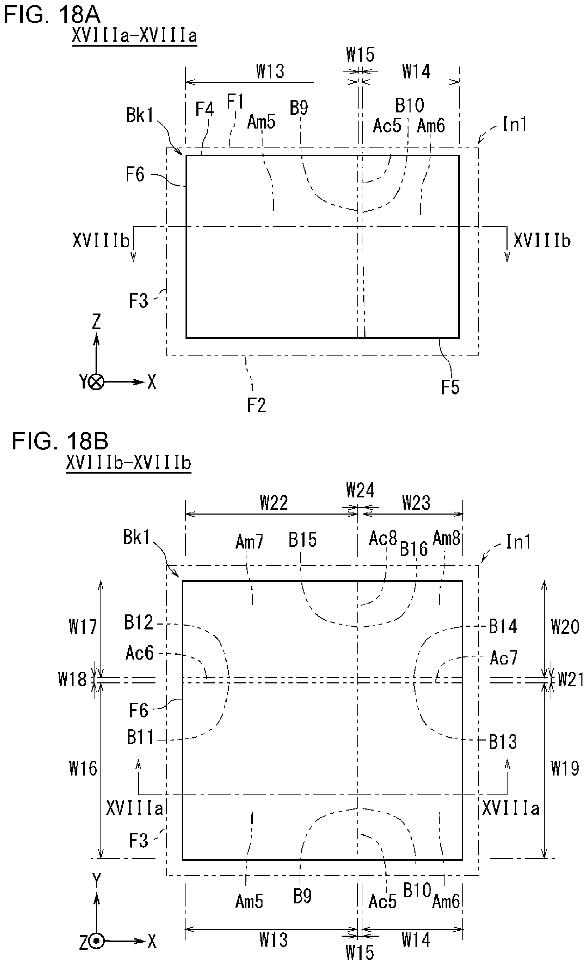

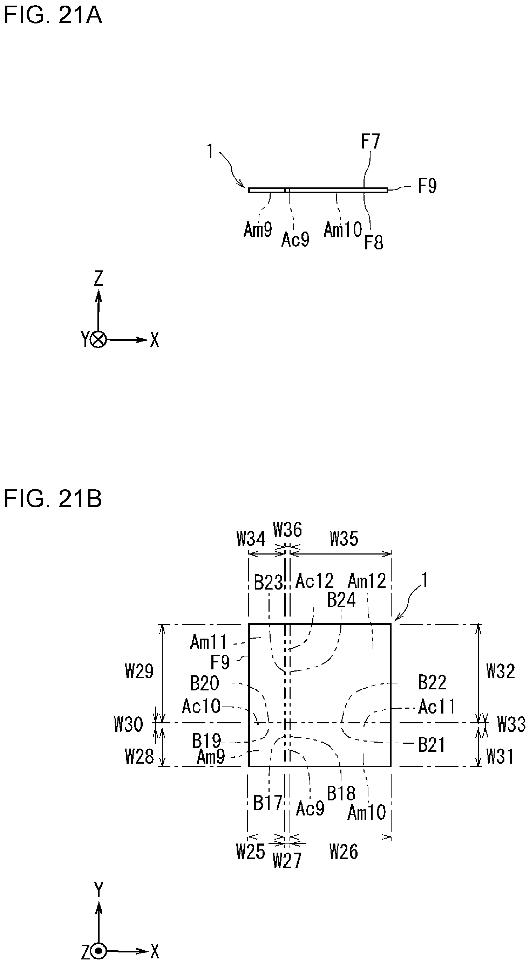

As shown in, for example, FIGs. 17A and 17B, the silicon ingot In1 may have a portion (peripheral portion) A0 along the third surface F3, which includes four sides. The peripheral portion A0 may contain, for example, defects resulting from dislocations originating from the inner side surface of the mold 121 during the unidirectional solidification of the silicon melt MS1. The peripheral portion A0 is cut off from the silicon ingot In1 to manufacture the silicon block Bk1 (refer to, for example, FIGs. 18A and 18B) and the silicon substrate 1 (refer to, for example, FIGs. 21A and 21B) described later.

For example, the crystal direction of each of the first mono-like crystalline portion Am1, the second mono-like crystalline portion Am2, the third mono-like crystalline portion Am3, and the fourth mono-like crystalline portion Am4 parallel to the positive Z-direction as the first direction has the Miller indices of <100>, and the crystal direction of one or more mono-like crystals in each of the first intermediate portion Ac1, the second intermediate portion Ac2, the third intermediate portion Ac3, and the fourth intermediate portion Ac4 parallel to the positive Z-direction as the first direction also has the Miller indices of <100>. This structure may be achieved by, for example, placing the seed crystal assembly 200s on the bottom 121b of the mold 121 with a plane having the Miller indices of (100) to be the upper surface and unidirectionally growing the silicon melt MS1 to cause the resulting crystals to inherit the crystal direction of the seed crystal assembly 200s. This may improve, for example, the crystal growth rate during unidirectional solidification of the silicon melt MS1. This allows easy formation of the first mono-like crystalline portion Am1, the second mono-like crystalline portion Am2, the third mono-like crystalline portion Am3, the fourth mono-like crystalline portion Am4, the first intermediate portion Ac1, the second intermediate portion Ac2, the third intermediate portion Ac3, and the fourth intermediate portion Ac4, which are formed by growing crystal grains upward from the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4. Thus, the quality of the silicon ingot In1 may be, for example, easily improved.

For example, the coincidence boundaries at each of the first boundary B1, the second boundary B2, the third boundary B3, the fourth boundary B4, the fifth boundary B5, the sixth boundary B6, the seventh boundary B7, and the eighth boundary B8 may include a Σ29 coincidence boundary. In this case, for example, a random boundary having a ∑ value of 29 forms constantly above the boundary between each pair of a seed crystal and an intermediate seed crystal while mono-like crystals are growing from the seed crystal assembly 200s into the silicon ingot In1. Distortions are further reduced in the random boundary to cause fewer defects. Thus, the silicon ingot In1 with the above structure suited to the manufacture of the silicon ingot In1 causing fewer defects may have higher quality with still fewer defects.

The first width W1 and the second width W2 may be, for example, the same or different. The fourth width W4 and the fifth width W5 may be, for example, the same or different. For example, the first width W1 and the second width W2 are different (first width relationship), and the fourth width W4 and the fifth width W5 are different (second width relationship). When the silicon ingot In1 has at least one of the first width relationship or the second width relationship, the first seed crystal Sd1, the second seed crystal Sd2, and the third seed crystal Sd3 on the bottom 121b of the mold 121 may have different widths from one another. Thus, for example, the seed crystal strips cut out from the cylindrical monocrystalline silicon lump Mc0 obtained by, for example, the CZ method and having different widths from one another may be used as the first seed crystal Sd1, the second seed crystal Sd2, and the third seed crystal Sd3. This allows, for example, easy manufacture of the high quality silicon ingot In1. In other words, the quality of the silicon ingot In1 may be, for example, easily improved.

The seventh width W7 and the eighth width W8 may be, for example, the same or different. The tenth width W10 and the eleventh width W11 may be, for example, the same or different. For example, the seventh width W7 and the eighth width W8 are different (third width relationship), and the tenth width W10 and the eleventh width W11 are different (fourth width relationship). When the silicon ingot In1 has at least one of the third width relationship or the fourth width relationship, the second seed crystal Sd2, the third seed crystal Sd3, and the fourth seed crystal Sd4 on the bottom 121b of the mold 121 may have different widths from one another. Thus, for example, the seed crystal strips cut out from the cylindrical monocrystalline silicon lump Mc0 obtained by, for example, the CZ method and having different widths from one another may be used as the second seed crystal Sd2, the third seed crystal Sd3, and the fourth seed crystal Sd4. This allows, for example, easy manufacture of the high quality silicon ingot In1. In other words, the quality of the silicon ingot In1 may be, for example, easily improved.

The example silicon ingot In1 described above includes two mono-like crystalline portions and an intermediate portion between the two mono-like crystalline portions aligned in the positive X-direction as the second direction. The example silicon ingot In1 described above also includes two mono-like crystalline portions and an intermediate portion between the two mono-like crystalline portions aligned in the positive Y-direction as the third direction. However, the structure is not limited to this example. The silicon ingot In1 may include, for example, three or more mono-like crystalline portions and intermediate portions each between adjacent ones of the mono-like crystalline portions aligned in the positive X-direction as the second direction. The silicon ingot In1 may include, for example, three or more mono-like crystalline portions and intermediate portions each between adjacent ones of the mono-like crystalline portions aligned in the positive Y-direction as the third direction. This may upsize, for example, the silicon ingot In1 further.

### 1-4. Silicon Block

The block of silicon (silicon block) Bk1 according to the first embodiment will be described with reference to FIGs. 18A and 18B. In the example in FIGs. 18A and 18B, the silicon block Bk1 is a rectangular prism. The silicon block Bk1 may be obtained by, for example, cutting off the outer periphery of the silicon ingot In1 described above using, for example, a wire saw. The outer periphery is likely to contain defects. The periphery of the silicon ingot In1 includes, for example, a portion having a first thickness along the first surface F1, a portion having a second thickness along the second surface F2, and a portion having a third thickness along the third surface F3. The first thickness is, for example, about several to 20 mm. The second thickness is, for example, a thickness that allows cutting of the section corresponding to the seed crystal assembly 200s. The third thickness is, for example, a thickness that allows cutting of the peripheral portion A0.

As shown in FIGs. 18A and 18B, the silicon block Bk1 has, for example, a fourth surface F4, a fifth surface F5, and a sixth surface F6. In the example in FIGs. 18A and 18B, the fourth surface F4 is rectangular or square surface (upper surface) facing in the positive Z-direction as the first direction. The fifth surface F5 is located opposite to the fourth surface F4. In the example in FIGs. 18A and 18B, the fifth surface F5 is rectangular or square surface (lower surface) facing in the negative Z-direction as a fourth direction, which is opposite to the first direction. The sixth surface F6 extends in the first direction to connect the fourth surface F4 and the fifth surface F5. In the example in FIGs. 18A and 18B, the sixth surface F6 extends in the positive Z-direction as the first direction to connect the upper surface and lower surface, and includes four surfaces (side surfaces) extending in the positive Z-direction as the first direction.

The silicon block Bk1 includes, for example, a fifth mono-like crystalline portion Am5, a sixth mono-like crystalline portion Am6, a seventh mono-like crystalline portion Am7, an eighth mono-like crystalline portion Am8, a fifth intermediate portion Ac5, a sixth intermediate portion Ac6, a seventh intermediate portion Ac7, and an eighth intermediate portion Ac8. For example, the fifth mono-like crystalline portion Am5, the fifth intermediate portion Ac5, and the sixth mono-like crystalline portion Am6 are adjacent to one another in the stated order in the positive X-direction as the second direction, which is perpendicular to the positive Z-direction as the first direction. Also, the fifth mono-like crystalline portion Am5, the sixth intermediate portion Ac6, and the seventh mono-like crystalline portion Am7 are, for example, adjacent to one another in the stated order in the positive Y-direction as the third direction, which is perpendicular to the positive Z-direction as the first direction and crosses the positive X-direction as the second direction. Also, the sixth mono-like crystalline portion Am6, the seventh intermediate portion Ac7, and the eighth mono-like crystalline portion Am8 are, for example, adjacent to one another in the stated order in the positive Y-direction as the third direction. Also, the seventh mono-like crystalline portion Am7, the eighth intermediate portion Ac8, and the eighth mono-like crystalline portion Am8 are, for example, adjacent to one another in the stated order in the positive X-direction as the second direction.

Each of the fifth mono-like crystalline portion Am5, the sixth mono-like crystalline portion Am6, the seventh mono-like crystalline portion Am7, and the eighth mono-like crystalline portion Am8 is a section of a mono-like crystal (mono-like crystalline portion). The fifth mono-like crystalline portion Am5 is, for example, at least a part of the first mono-like crystalline portion Am1 in the silicon ingot In1. The sixth mono-like crystalline portion Am6 is, for example, at least a part of the second mono-like crystalline portion Am2 in the silicon ingot In1. The seventh mono-like crystalline portion Am7 is, for example, at least a part of the third mono-like crystalline portion Am3 in the silicon ingot In1. The eighth mono-like crystalline portion Am8 is, for example, at least a part of the fourth mono-like crystalline portion Am4 in the silicon ingot In1. In the example in FIGs. 18A and 18B, each of the fifth mono-like crystalline portion Am5, the sixth mono-like crystalline portion Am6, the seventh mono-like crystalline portion Am7, and the eighth mono-like crystalline portion Am8 is a rectangular prism having a rectangular upper surface facing in the positive Z-direction as the first direction and a rectangular lower surface facing in the negative Z-direction as the fourth direction.

Each of the fifth intermediate portion Ac5, the sixth intermediate portion Ac6, the seventh intermediate portion Ac7, and the eighth intermediate portion Ac8 includes one or more mono-like crystalline sections (intermediate portion). The fifth intermediate portion Ac5 is, for example, at least a part of the first intermediate portion Ac1 in the silicon ingot In1. The sixth intermediate portion Ac6 is, for example, at least a part of the second intermediate portion Ac2 in the silicon ingot In1. The seventh intermediate portion Ac7 is, for example, at least a part of the third intermediate portion Ac3 in the silicon ingot In1. The eighth intermediate portion Ac8 is, for example, at least a part of the fourth intermediate portion Ac4 in the silicon ingot In1. In the example in FIGs. 18A and 18B, each of the fifth intermediate portion Ac5, the sixth intermediate portion Ac6, the seventh intermediate portion Ac7, and the eighth intermediate portion Ac8 is a plate-like portion having a narrow rectangular upper surface facing in the positive Z-direction as the first direction and a narrow rectangular lower surface facing in the negative Z-direction as the fourth direction. Thus, for example, a boundary (ninth boundary) B9 between the fifth mono-like crystalline portion Am5 and the fifth intermediate portion Ac5 and a boundary (tenth boundary) B10 between the sixth mono-like crystalline portion Am6 and the fifth intermediate portion Ac5 are rectangular. For example, a boundary (eleventh boundary) B11 between the fifth mono-like crystalline portion Am5 and the sixth intermediate portion Ac6 and a boundary (twelfth boundary) B12 between the seventh mono-like crystalline portion Am7 and the sixth intermediate portion Ac6 are rectangular. For example, a boundary (thirteenth boundary) B13 between the sixth mono-like crystalline portion Am6 and the seventh intermediate portion Ac7 and a boundary (fourteenth boundary) B14 between the eighth mono-like crystalline portion Am8 and the seventh intermediate portion Ac7 are rectangular. For example, a boundary (fifteenth boundary) B15 between the seventh mono-like crystalline portion Am7 and the eighth intermediate portion Ac8 and a boundary (sixteenth boundary) B16 between the eighth mono-like crystalline portion Am8 and the eighth intermediate portion Ac8 are rectangular.

For example, the fifth intermediate portion Ac5 and the eighth intermediate portion Ac8 are elongated in the positive Y-direction as the third direction. The fifth intermediate portion Ac5 and the eighth intermediate portion Ac8 may define, for example, a single plate-like section extending in the positive Y-direction as the third direction, or may be deviated from each other in the positive X-direction as the second direction. For example, the sixth intermediate portion Ac6 and the seventh intermediate portion Ac7 are elongated in the positive X-direction as the second direction. The sixth intermediate portion Ac6 and the seventh intermediate portion Ac7 may define, for example, a single plate-like section extending in the positive X-direction as the second direction, or may be deviated from each other in the positive Y-direction as the third direction. In the example in FIG. 18B, the section defined by the fifth intermediate portion Ac5 and the eighth intermediate portion Ac8 and the section defined by the sixth intermediate portion Ac6 and the seventh intermediate portion Ac7 cross each other in a cross shape.

For example, a width (thirteenth width) W13 of the fifth mono-like crystalline portion Am5 and a width (fourteenth width) W14 of the sixth mono-like crystalline portion Am6 each are greater than a width (fifteenth width) W15 of the fifth intermediate portion Ac5 in the positive X-direction as the second direction. A width (sixteenth width) W16 of the fifth mono-like crystalline portion Am5 and a width (seventeenth width) W17 of the seventh mono-like crystalline portion Am7 are also each greater than a width (eighteenth width) W18 of the sixth intermediate portion Ac6 in the positive Y-direction as the third direction. A width (nineteenth width) W19 of the sixth mono-like crystalline portion Am6 and a width (twentieth width) W20 of the eighth mono-like crystalline portion Am8 are also each greater than a width (twenty-first width) W21 of the seventh intermediate portion Ac7 in the positive Y-direction as the third direction. A width (twenty-second width) W22 of the seventh mono-like crystalline portion Am7 and a width (twenty-third width) W23 of the eighth mono-like crystalline portion Am8 are also each greater than a width (twenty-fourth width) W24 of the eighth intermediate portion Ac8 in the positive X-direction as the second direction.

For example, each of the fourth surface F4 and the fifth surface F5 of the silicon block Bk1 is rectangular or square, and is about 300 to 320 mm on a side. In this case, for example, each of the thirteenth width W13, the fourteenth width W14, the sixteenth width W16, the seventeenth width W17, the nineteenth width W19, the twentieth width W20, the twenty-second width W22, and the twenty-third width W23 is about 50 to 250 mm. Each of the fifteenth width W15, the eighteenth width W18, the twenty-first width W21, and the twenty-fourth width W24 is, for example, about 2 to 25 mm.

For example, each of the ninth boundary B9, the tenth boundary B10, the eleventh boundary B11, the twelfth boundary B12, the thirteenth boundary B13, the fourteenth boundary B14, the fifteenth boundary B15, and the sixteenth boundary B16 includes a coincidence boundary. In this example, the surface of each of the fifth mono-like crystalline portion Am5, the sixth mono-like crystalline portion Am6, the seventh mono-like crystalline portion Am7, the eighth mono-like crystalline portion Am8, the fifth intermediate portion Ac5, the sixth intermediate portion Ac6, the seventh intermediate portion Ac7, and the eighth intermediate portion Ac8 perpendicular to the positive Z-direction as the first direction may have the Miller indices of (100). In other words, for example, the crystal direction of each of the fifth mono-like crystalline portion Am5, the sixth mono-like crystalline portion Am6, the seventh mono-like crystalline portion Am7, and the eighth mono-like crystalline portion Am8 parallel to the positive Z-direction as the first direction has the Miller indices of <100>, and the crystal direction of one or more mono-like crystals in each of the fifth intermediate portion Ac5, the sixth intermediate portion Ac6, the seventh intermediate portion Ac7, and the eighth intermediate portion Ac8 parallel to the positive Z-direction as the first direction also has the Miller indices of <100>.

In this case, for example, the coincidence boundary includes one of a ∑5 coincidence boundary, a ∑13 coincidence boundary, a ∑17 coincidence boundary, a Σ25 coincidence boundary, or a Σ29 coincidence boundary. The silicon block Bk1 with such a structure may be obtained by, for example, growing mono-like crystals from the seed crystal assembly 200s and forming coincidence boundaries above the boundary between each pair of a seed crystal and an intermediate seed crystal. While the coincidence boundary is forming, for example, distortions are reduced and thus cause fewer defects in the silicon ingot In1. The silicon block Bk1 obtained by cutting off the periphery of the silicon ingot In1 may also have fewer defects. For example, the silicon block Bk1 with the above structure suited to the manufacture of the silicon block Bk1 with fewer defects may have higher quality and fewer defects. The coincidence boundaries and the ratio of each type of coincidence boundary may be identified in each of the ninth boundary B9, the tenth boundary B10, the eleventh boundary B11, the twelfth boundary B12, the thirteenth boundary B13, the fourteenth boundary B14, the fifteenth boundary B15, and the sixteenth boundary B16 using, for example, EBSDs.

In this example, the crystal direction of each of the fifth mono-like crystalline portion Am5, the sixth mono-like crystalline portion Am6, the seventh mono-like crystalline portion Am7, and the eighth mono-like crystalline portion Am8 parallel to the positive Z-direction as the first direction has the Miller indices of <100>, and the crystal direction of one or more mono-like crystals included in each of the fifth intermediate portion Ac5, the sixth intermediate portion Ac6, the seventh intermediate portion Ac7, and the eighth intermediate portion Ac8 parallel to the positive Z-direction as the first direction also has the Miller indices of <100>. This structure may be achieved by, for example, placing the seed crystal assembly 200s on the bottom 121b of the mold 121 with a plane having the Miller indices of (100) to be the upper surface and unidirectionally growing the silicon melt MS1 to cause the resulting crystals to inherit the crystal direction of the seed crystal assembly 200s. This may improve, for example, the crystal growth rate during unidirectional solidification of the silicon melt MS 1. This allows, for example, easy manufacture of the silicon ingot In1 including the first mono-like crystalline portion Am1, the second mono-like crystalline portion Am2, the third mono-like crystalline portion Am3, the fourth mono-like crystalline portion Am4, the first intermediate portion Ac1, the second intermediate portion Ac2, the third intermediate portion Ac3, and the fourth intermediate portion Ac4, which are formed by growing crystal grains upward from the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4. The silicon block Bk1 cut out from the silicon ingot In1 may thus easily have higher quality, for example.

For example, the coincidence boundaries at each of the ninth boundary B9, the tenth boundary B10, the eleventh boundary B11, the twelfth boundary B12, the thirteenth boundary B13, the fourteenth boundary B14, the fifteenth boundary B15, and the sixteenth boundary B16 may include a Σ29 coincidence boundary. In this case, for example, a random boundary having a Σ value of 29 forms constantly above the boundary between each pair of a seed crystal and an intermediate seed crystal while mono-like crystals are growing from the seed crystal assembly 200s into the silicon ingot In1. Distortions are further reduced in the random boundary to cause fewer defects. Thus, the silicon block Bk1 with the above structure suited to the manufacture of the silicon ingot In1 causing fewer defects may have higher quality with still fewer defects.

The thirteenth width W13 and the fourteenth width W14 may be, for example, the same or different. The sixteenth width W16 and the seventeenth width W17 may be, for example, the same or different. For example, the thirteenth width W13 and the fourteenth width W14 are different (fifth width relationship), and the sixteenth width W16 and the seventeenth width W17 are different (sixth width relationship). When the silicon block Bk1 has at least one of the fifth width relationship or the sixth width relationship, the first seed crystal Sd1, the second seed crystal Sd2, and the third seed crystal Sd3 on the bottom 121b of the mold 121 may have different widths from one another. Thus, for example, the seed crystal strips cut out from the cylindrical monocrystalline silicon lump Mc0 obtained by, for example, the CZ method and having different widths from one another may be used as the first seed crystal Sd1, the second seed crystal Sd2, and the third seed crystal Sd3. This allows, for example, easy manufacture of the high quality silicon block Bk1. In other words, the quality of silicon block Bk1 may be, for example, easily improved.

The nineteenth width W19 and the twentieth width W20 may be, for example, the same or different. The twenty-second width W22 and the twenty-third width W23 may be, for example, the same or different. For example, the nineteenth width W19 and the twentieth width W20 are different (seventh width relationship), and the twenty-second width W22 and the twenty-third width W23 are different (eighth width relationship). When the silicon block Bk1 has at least one of the seventh width relationship or the eighth width relationship, the second seed crystal Sd2, the third seed crystal Sd3, and the fourth seed crystal Sd4 on the bottom 121b of the mold 121 may have different widths from one another. Thus, for example, the seed crystal strips cut out from the cylindrical monocrystalline silicon lump Mc0 obtained by, for example, the CZ method and having different widths from one another may be used as the second seed crystal Sd2, the third seed crystal Sd3, and the fourth seed crystal Sd4. This allows, for example, easy manufacture of the high quality silicon block Bk1. In other words, the quality of silicon block Bk1 may be, for example, easily improved.

For example, the silicon block Bk1 may have a third portion including one end (third end) nearer the fourth surface F4 and a fourth portion including the other end (fourth end) opposite to the third end (nearer the fifth surface F5). When the silicon block Bk1 has a total length of 100 from the third end to the fourth end, the third portion may extend, for example, from 0 to about 30 with the third end being the basal end. The fourth portion may extend, for example, from about 50 to 100 with the third end being the basal end. The third portion may have a higher ratio of Σ29 coincidence boundaries (random boundaries) than the fourth portion. Thus, for example, the random boundaries in the third portion reduce distortions to causer fewer defects. For example, the silicon block Bk1 cut out from the silicon ingot In1 manufactured using unidirectional solidification of the silicon melt MS1 may have fewer defects in the third portion, which is at a low position in the height direction. The quality of the silicon block Bk1 may thus be improved. The fourth portion may have a higher ratio of Σ5 coincidence boundaries than the third portion. Thus, the fourth portion may have improved crystal quality. The coincidence boundaries and the types of coincidence boundaries in the silicon block Bk1 may be identified by measurement using EBSDs or other techniques. In this example, the portion including Σ5 coincidence boundaries includes a portion in which Σ29 coincidence boundaries and Σ5 coincidence boundaries are both detected.

The example silicon block Bk1 described above includes two mono-like crystalline portions and an intermediate portion between the two mono-like crystalline portions aligned in the positive X-direction as the second direction. The example silicon block Bk1 described above includes two mono-like crystalline portions and an intermediate portion between the two mono-like crystalline portions aligned in the positive Y-direction as the third direction. However, the structure is not limited to this example. The silicon block Bk1 may include, for example, three or more mono-like crystalline portions and intermediate portions each between adjacent ones of the mono-like crystalline portions aligned in the positive X-direction as the second direction. The silicon block Bk1 may include, for example, three or more mono-like crystalline portions and intermediate portions each between adjacent ones of the mono-like crystalline portions aligned in the positive Y-direction as the third direction. This may upsize, for example, the silicon block Bk1 further.

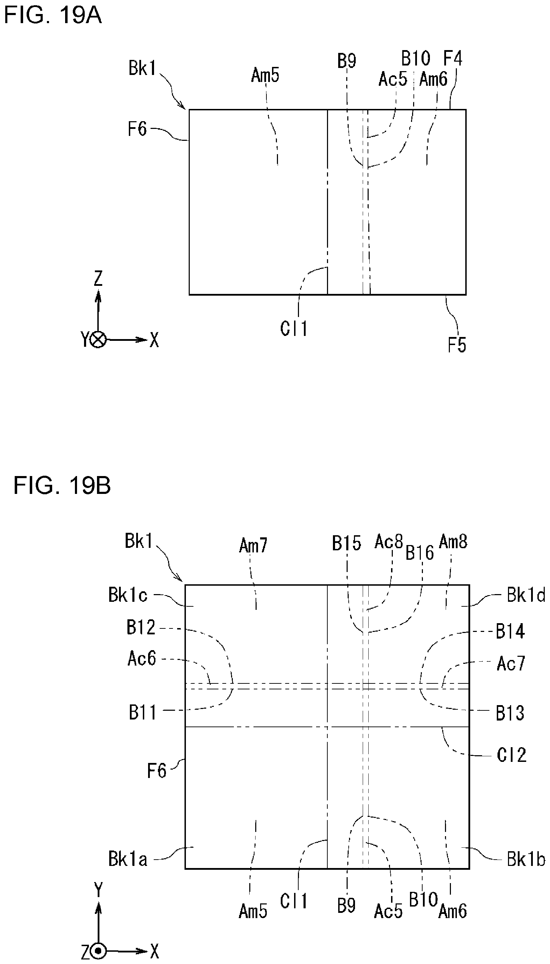

In the example show in FIGs. 19A and 19B, the silicon block Bk1 is divided into two equal parts in the positive X-direction as the second direction and also into two equal parts in the positive Y-direction as the third direction for manufacture of silicon substrates 1. For example, the silicon block Bk1 is cut along a first cut surface Cl1 in a YZ plane and along a second cut surface Cl2 in an XZ plane into four silicon blocks, which are relatively small (small silicon blocks). The four small silicon blocks include a first small silicon block Bk1a, a second small silicon block Bklb, a third small silicon block Bk1c, and fourth small silicon block Bk1d. The silicon block Bk1 is cut with, for example, a wire saw.

In the example in FIGs. 19A and 19B, the first small silicon block Bkla includes a part of the fifth mono-like crystalline portion Am5. The second small silicon block Bklb includes a part of the fifth mono-like crystalline portion Am5, a part of the fifth intermediate portion Ac5, and a part of the sixth mono-like crystalline portion Am6. The third small silicon block Bklc includes a part of the fifth mono-like crystalline portion Am5, a part of the sixth intermediate portion Ac6, and a part of the seventh mono-like crystalline portion Am7. The fourth small silicon block Bk1d includes a part of the fifth mono-like crystalline portion Am5, a part of the fifth intermediate portion Ac5, a part of the sixth mono-like crystalline portion Am6, a part of the sixth intermediate portion Ac6, a part of the seventh mono-like crystalline portion Am7, the seventh intermediate portion Ac7, the eighth mono-like crystalline portion Am8, and a part of the eighth intermediate portion Ac8.

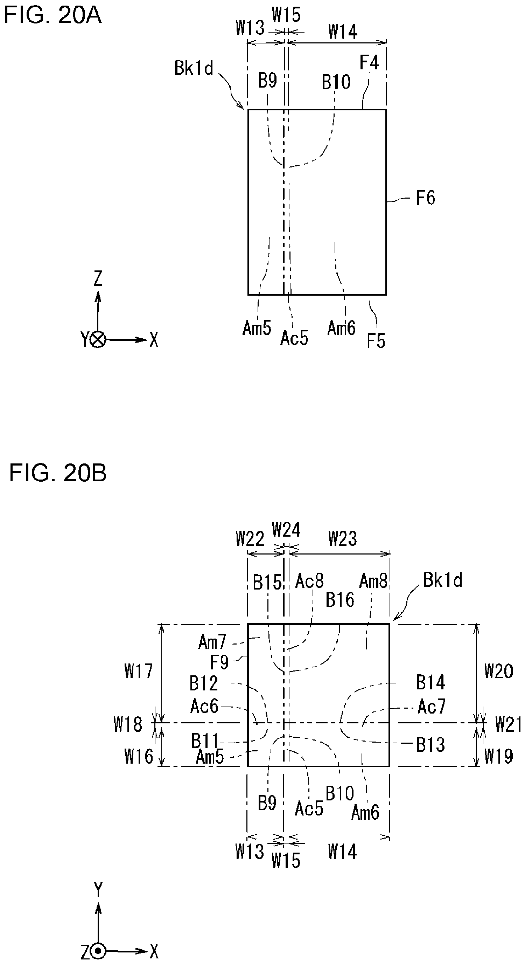

In this example, as shown in FIGs. 20A and 20B, the fourth small silicon block Bk1d may have each of the thirteenth width W13 of the fifth mono-like crystalline portion Am5 and the fourteenth width W14 of the sixth mono-like crystalline portion Am6 greater than the fifteenth width W15 of the fifth intermediate portion Ac5 in the positive X-direction as the second direction. The thirteenth width W13 and the fourteenth width W14 may be the same or different. Each of the sixteenth width W16 of the fifth mono-like crystalline portion Am5 and the seventeenth width W17 of the seventh mono-like crystalline portion Am7 may be greater than the eighteenth width W18 of the sixth intermediate portion Ac6 in the positive Y-direction as the third direction. The sixteenth width W16 and the seventeenth width W17 may be the same or different. Each of the nineteenth width W19 of the sixth mono-like crystalline portion Am6 and the twentieth width W20 of the eighth mono-like crystalline portion Am8 may be greater than the twenty-first width W21 of the seventh intermediate portion Ac7 in the positive Y-direction as the third direction. The nineteenth width W19 and the twentieth width W20 may be the same or different. Each of the twenty-second width W22 of the seventh mono-like crystalline portion Am7 and the twenty-third width W23 of the eighth mono-like crystalline portion Am8 may be greater than the twenty-fourth width W24 of the eighth intermediate portion Ac8 in the positive X-direction as the second direction. The twenty-second width W22 and the twenty-third width W23 may be the same or different.

### 1-5. Silicon Substrate

The substrate of silicon (silicon substrate) 1 according to the first embodiment will be described with reference to FIGs. 21A and 21B. In the example in FIGs. 21A and 21B, the silicon substrate 1 is a plate having rectangular front and back surfaces. For example, the silicon substrate 1 may be obtained by slicing, at predetermined intervals in the positive Z-direction as the first direction, a small silicon block such as the fourth small silicon block Bkld along an XY plane parallel to the fourth and fifth surfaces F4 and F5. FIGs. 21A and 21B each show an example silicon substrate 1 obtained by slicing the fourth small silicon block Bkld. For example, the fourth small silicon block Bkld is sliced with, for example, a wire saw into silicon substrates 1 each having a thickness of about 100 to 300 micrometers (µm) and having a square plate surface that is about 150 mm on a side. The surface layer of the silicon substrate 1 may include a damage layer resulting from the cutting of the small silicon block. The damage layer may be removed by etching using, for example, a sodium hydroxide solution.

As shown in FIGs. 21A and 21B, the silicon substrate 1 is a flat plate having, for example, a seventh surface F7, an eighth surface F8, and a ninth surface F9. The eighth surface F8 is located opposite to the seventh surface F7. The ninth surface F9 connects the seventh surface F7 and the eighth surface F8, and is an outer peripheral surface extending in the positive Z-direction as the first direction. In the example in FIGs. 21A and 21B, the seventh surface F7 is a rectangular or square surface (front surface) facing in the positive Z-direction as the first direction. The eighth surface F8 is a rectangular or square surface (back surface) facing in the negative Z-direction as the fourth direction, which is opposite to the first direction. The ninth surface F9 extends in the positive Z-direction as the first direction to connect the front surface and the back surface. The ninth surface F9 is an outer peripheral surface aligned with the four sides of each of the seventh surface F7 and the eighth surface F8.

The silicon substrate 1 includes, for example, a ninth mono-like crystalline portion Am9, a tenth mono-like crystalline portion Am10, an eleventh mono-like crystalline portion Am11, a twelfth mono-like crystalline portion Am12, a ninth intermediate portion Ac9, a tenth intermediate portion Ac10, an eleventh intermediate portion Ac11, and a twelfth intermediate portion Ac12. The ninth mono-like crystalline portion Am9, the ninth intermediate portion Ac9, and the tenth mono-like crystalline portion Am10 are adjacent to one another in the stated order in the positive X-direction as the second direction. The ninth mono-like crystalline portion Am9, the tenth intermediate portion Ac10, and the eleventh mono-like crystalline portion Am11 are adjacent to one another in the stated order in the positive Y-direction as the third direction. The tenth mono-like crystalline portion Am10, the eleventh intermediate portion Ac11, and the twelfth mono-like crystalline portion Am12 are adjacent to one another in the stated order in the positive Y-direction as the third direction. The eleventh mono-like crystalline portion Am11, the twelfth intermediate portion Ac12, and the twelfth mono-like crystalline portion Am12 are adjacent to one another in the stated order in the positive X-direction as the second direction.

Each of the ninth mono-like crystalline portion Am9, the tenth mono-like crystalline portion Am10, the eleventh mono-like crystalline portion Am11, and the twelfth mono-like crystalline portion Am12 is a section of a mono-like crystal (mono-like crystalline portion). The ninth mono-like crystalline portion Am9 is, for example, at least a part of the fifth mono-like crystalline portion Am5 in the silicon block Bk1. The tenth mono-like crystalline portion Am10 is, for example, at least a part of the sixth mono-like crystalline portion Am6 in the silicon block Bk1. The eleventh mono-like crystalline portion Am11 is, for example, at least a part of the seventh mono-like crystalline portion Am7 in the silicon block Bk1. The twelfth mono-like crystalline portion Am12 is, for example, at least a part of the eighth mono-like crystalline portion Am8 in the silicon block Bk1. In the example in FIGs. 21A and 21B, each of the ninth mono-like crystalline portion Am9, the tenth mono-like crystalline portion Am10, the eleventh mono-like crystalline portion Am11, and the twelfth mono-like crystalline portion Am12 is a plate-like portion having a rectangular front surface facing in the positive Z-direction as the first direction and a rectangular back surface facing in the negative Z-direction as the fourth direction.

Each of the ninth intermediate portion Ac9, the tenth intermediate portion Ac10, the eleventh intermediate portion Ac11, and the twelfth intermediate portion Ac12 includes one or more mono-like crystalline sections (intermediate portion). The ninth intermediate portion Ac9 is, for example, at least a part of the fifth intermediate portion Ac5 in the silicon block Bk1. The tenth intermediate portion Ac10 is, for example, at least a part of the sixth intermediate portion Ac6 in the silicon block Bk1. The eleventh intermediate portion Ac11 is, for example, at least a part of the seventh intermediate portion Ac7 in the silicon block Bk1. The twelfth intermediate portion Ac12 is, for example, at least a part of the eighth intermediate portion Ac8 in the silicon block Bk1.

In the example in FIGs. 21A and 21B, each of the ninth intermediate portion Ac9, the tenth intermediate portion Ac10, the eleventh intermediate portion Ac11, and the twelfth intermediate portion Ac12 is a plate-like portion having a narrow rectangular upper surface facing in the positive Z-direction as the first direction and a narrow rectangular lower surface facing in the negative Z-direction as the fourth direction. For example, a boundary (seventeenth boundary) B17 between the ninth mono-like crystalline portion Am9 and the ninth intermediate portion Ac9 and a boundary (eighteenth boundary) B18 between the tenth mono-like crystalline portion Am 10 and the ninth intermediate portion Ac9 are elongated in the positive Y-direction as the third direction. For example, a boundary (nineteenth boundary) B19 between the ninth mono-like crystalline portion Am9 and the tenth intermediate portion Ac10 and a boundary (twentieth boundary) B20 between the eleventh mono-like crystalline portion Am11 and the tenth intermediate portion Ac10 are elongated in the positive X-direction as the second direction. For example, a boundary (twenty-first boundary) B21 between the tenth mono-like crystalline portion Am10 and the eleventh intermediate portion Ac11 and a boundary (twenty-second boundary) B22 between the twelfth mono-like crystalline portion Am12 and the eleventh intermediate portion Ac11 are elongated in the positive X-direction as the second direction. For example, a boundary (twenty-third boundary) B23 between the eleventh mono-like crystalline portion Am11 and the twelfth intermediate portion Ac12 and a boundary (twenty-fourth boundary) B24 between the twelfth mono-like crystalline portion Am12 and the twelfth intermediate portion Ac12 are elongated in the positive Y-direction as the third direction.

For example, the ninth intermediate portion Ac9 and the twelfth intermediate portion Ac12 are elongated in the positive Y-direction as the third direction. The ninth intermediate portion Ac9 and the twelfth intermediate portion Ac12 may define, for example, a single narrow section extending in the positive Y-direction as the third direction, or may be deviated from each other in the positive X-direction as the second direction. In this example, the tenth intermediate portion Ac10 and the eleventh intermediate portion Ac11 are elongated in the positive X-direction as the second direction. The tenth intermediate portion Ac10 and the eleventh intermediate portion Ac11 may define, for example, a single narrow section extending in the positive X-direction as the second direction, or may be deviated from each other in the positive Y-direction as the third direction. In the example in FIG. 21B, the section defined by the ninth intermediate portion Ac9 and the twelfth intermediate portion Ac12 and the section by the tenth intermediate portion Ac10 and the eleventh intermediate portion Ac11 cross each other in a cross shape.

For example, a width (twenty-fifth width) W25 of the ninth mono-like crystalline portion Am9 and a width (twenty-sixth width) W26 of the tenth mono-like crystalline portion Am10 each are greater than a width (twenty-seventh width) W27 of the ninth intermediate portion Ac9 in the positive X-direction as the second direction. For example, a width (twenty-eighth width) W28 of the ninth mono-like crystalline portion Am9 and a width (twenty-ninth width) W29 of the eleventh mono-like crystalline portion Am11 each are also greater than a width (thirtieth width) W30 of the tenth intermediate portion Ac10 in the positive Y-direction as the third direction. For example, a width (thirty-first width) W31 of the tenth mono-like crystalline portion Am10 and a width (thirty-second width) W32 of the twelfth mono-like crystalline portion Am12 each are also greater than a width (thirty-third width) W33 of the eleventh intermediate portion Ac11 in the positive Y-direction as the third direction. For example, a width (thirty-fourth width) W34 of the eleventh mono-like crystalline portion Am11 and a width (thirty-fifth width) W35 of the twelfth mono-like crystalline portion Am12 each are also greater than a width (thirty-sixth width) W36 of the twelfth intermediate portion Ac12 in the positive X-direction as the second direction.

In this example, the seventh surface F7 and the eighth surface F8 of the silicon substrate 1 each are square, and is about 150 mm on a side. In this case, for example, each of the twenty-fifth width W25, the twenty-sixth width W26, the twenty-eighth width W28, the twenty-ninth width W29, the thirty-first width W31, the thirty-second width W32, the thirty-fourth width W34, and the thirty-fifth width W35 is about 50 to 100 mm. Each of the twenty-seventh width W27, the thirtieth width W30, the thirty-third width W33, and the thirty-sixth width W36 is, for example, about 2 to 25 mm.

For example, each of the seventeenth boundary B17, the eighteenth boundary B18, the nineteenth boundary B19, the twentieth boundary B20, the twenty-first boundary B21, the twenty-second boundary B22, the twenty-third boundary B23, and the twenty-fourth boundary B24 includes a coincidence boundary. In this example, the surface of each of the ninth mono-like crystalline portion Am9, the tenth mono-like crystalline portion Am10, the eleventh mono-like crystalline portion Am11, the twelfth mono-like crystalline portion Am12, the ninth intermediate portion Ac9, the tenth intermediate portion Ac10, the eleventh intermediate portion Ac11, and the twelfth intermediate portion Ac12 perpendicular to the positive Z-direction as the first direction has the Miller indices of (100). In other words, for example, the crystal direction of each of the ninth mono-like crystalline portion Am9, the tenth mono-like crystalline portion Am10, the eleventh mono-like crystalline portion Am11, and the twelfth mono-like crystalline portion Am12 parallel to the positive Z-direction as the first direction has the Miller indices of <100>, and the crystal direction of one or more mono-like crystals in each of the ninth intermediate portion Ac9, the tenth intermediate portion Ac10, the eleventh intermediate portion Ac11, and the twelfth intermediate portion Ac12 parallel to the positive Z-direction as the first direction also has the Miller indices of <100>.

In this case, for example, the coincidence boundary includes one of a Σ5 coincidence boundary, a Σ13 coincidence boundary, a Σ17 coincidence boundary, a Σ25 coincidence boundary, or a Σ29 coincidence boundary. The silicon substrate 1 with such a structure may be obtained by, for example, growing mono-like crystals from the seed crystal assembly 200s and forming coincidence boundaries above the boundary between each pair of a seed crystal and an intermediate seed crystal. While the coincidence boundary is forming, for example, distortions are reduced and thus cause fewer defects in the silicon ingot In1. The silicon substrate 1 sliced from the silicon block Bk1 obtained by cutting off the periphery of the silicon ingot In1 may also have fewer defects. For example, the silicon substrate 1 with the above structure suited to the manufacture of the silicon substrate 1 with fewer defects may have higher quality with fewer defects. The coincidence boundaries and the ratio of each type of coincidence boundary may be identified in each of the seventeenth boundary B17, the eighteenth boundary B18, the nineteenth boundary B19, the twentieth boundary B20, the twenty-first boundary B21, the twenty-second boundary B22, the twenty-third boundary B23, and the twenty-fourth boundary B24 using, for example, EBSDs.

For example, the crystal direction of each of the ninth mono-like crystalline portion Am9, the tenth mono-like crystalline portion Am10, the eleventh mono-like crystalline portion Am11, and the twelfth mono-like crystalline portion Am12 parallel to the positive Z-direction as the first direction has the Miller indices of <100>, and the crystal direction of one or more mono-like crystals included in each of the ninth intermediate portion Ac9, the tenth intermediate portion Ac10, the eleventh intermediate portion Ac11, and the twelfth intermediate portion Ac12 parallel to the positive Z-direction as the first direction also has the Miller indices of <100>. This structure may be achieved by, for example, placing the seed crystal assembly 200s on the bottom 121b of the mold 121 with a plane having the Miller indices of (100) to be the upper surface and unidirectionally growing the silicon melt MS1 to cause the resulting crystals to inherit the crystal direction of the seed crystal assembly 200s. This may improve, for example, the crystal growth rate during unidirectional solidification of the silicon melt MS1. This allows, for example, easy manufacture of the silicon ingot In1 including the first mono-like crystalline portion Am1, the second mono-like crystalline portion Am2, the third mono-like crystalline portion Am3, the fourth mono-like crystalline portion Am4, the first intermediate portion Ac1, the second intermediate portion Ac2, the third intermediate portion Ac3, and the fourth intermediate portion Ac4, which are formed by growing crystal grains upward from the first seed crystal Sd1, the second seed crystal Sd2, the third seed crystal Sd3, the fourth seed crystal Sd4, the first intermediate seed crystal Cs1, the second intermediate seed crystal Cs2, the third intermediate seed crystal Cs3, and the fourth intermediate seed crystal Cs4. The silicon substrate 1 sliced from the silicon block Bk1 cut out from the silicon ingot In1 may easily have higher quality, for example.

For example, the coincidence boundaries at each of the seventeenth boundary B17, the eighteenth boundary B18, the nineteenth boundary B19, the twentieth boundary B20, the twenty-first boundary B21, the twenty-second boundary B22, the twenty-third boundary B23, and the twenty-fourth boundary B24 may include a Σ29 coincidence boundary. In this example, the silicon ingot In1 is manufactured by growing mono-like crystals from the seed crystal assembly 200s. In this case, for example, a random boundary having a Σ value of 29 forms constantly above the boundary between each pair of a seed crystal and an intermediate seed crystal. During the formation, distortions are further reduced in the random boundary to cause fewer defects. Thus, the silicon substrate 1 with the above structure suited to the manufacture of the silicon ingot In1 causing fewer defects may have higher quality with still fewer defects.

The example silicon substrate 1 described above includes two mono-like crystalline portions and an intermediate portion between the two mono-like crystalline portions aligned in the positive X-direction as the second direction. The example silicon substrate 1 described above includes two mono-like crystalline portions and an intermediate portion between the two mono-like crystalline portions aligned in the positive Y-direction as the third direction. However, the structure is not limited to this example. The silicon substrate 1 may include, for example, three or more mono-like crystalline portions and intermediate portions each between adjacent ones of the mono-like crystalline portions aligned in the positive X-direction as the second direction. The silicon substrate 1 may include, for example, three or more mono-like crystalline portions and intermediate portions each between adjacent ones of the mono-like crystalline portions aligned in the positive Y-direction as the third direction.

### 1-6. Solar Cell Element

The silicon substrate 1 obtained from the silicon block Bk1 cut out from the silicon ingot In1 according to the first embodiment described above is used in, for example, a semiconductor board included in the solar cell element 10 as a solar cell. In other words, for example, the solar cell element 10 includes the silicon substrate 1 having the structure suited to the manufacture of the silicon ingot In1 causing fewer defects. For example, the solar cell element 10 may thus achieve higher performance in, for example, output characteristics.

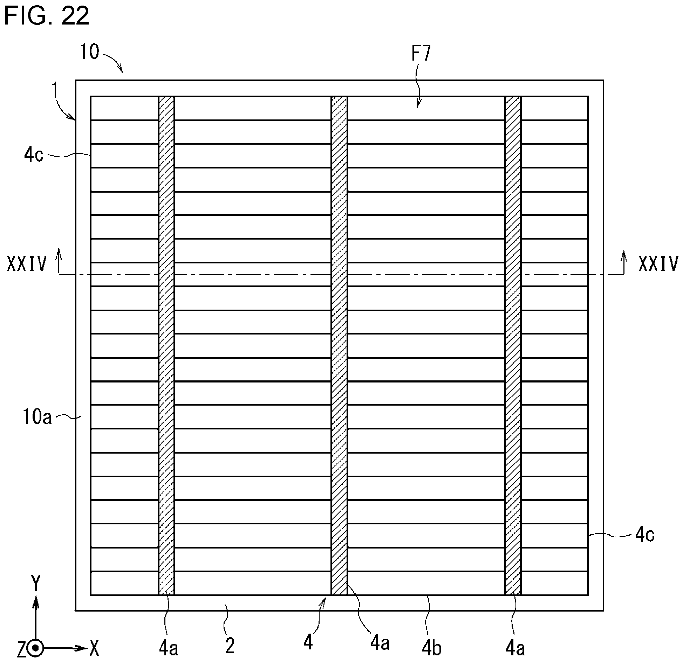

An example solar cell element 10 will be described with reference to FIGs. 22 to 24. The solar cell element 10 has a light receiving surface 10a to receive light and a non-light receiving surface 10b opposite to the light receiving surface 10a.

As shown in FIGs. 22 to 24, the solar cell element 10 includes, for example, the silicon substrate 1, an anti-reflection film 2, a first electrode 4, and a second electrode 5.

The silicon substrate 1 includes, for example, a first semiconductor layer 1p of a first conduction type and a second semiconductor layer In of a second conduction type adjacent to the light receiving surface 10a of the first semiconductor layer 1p. For example, when the first conduction type is p-type, the second conduction type is n-type. For example, when the first conduction type is n-type, the second conduction type is p-type. For example, when the first conduction type is p-type, boron or another element is used as a dopant element to obtain the silicon ingot In1 of p-type. For example, the silicon ingot In1 may have a boron concentration (the number of atoms per unit volume) of about 1 × 10¹⁶ to 1 × 10¹⁷ atoms per cubic centimeter (atoms/cm³). In this case, the silicon substrate 1 has a specific resistance of about 0.2 to 2 ohm-centimeter (Ω·cm). The silicon substrate 1 may be doped with boron by, for example, mixing an appropriate amount of a simple boron element or an appropriate amount of silicon lumps having a known boron concentration during the manufacture of the silicon ingot In1. For example, when the first conduction type is p-type, the second semiconductor layer In may be formed by introducing impurities such as phosphorus into the surface layer on the seventh surface F7 of the silicon substrate 1 by diffusion. The first semiconductor layer 1p and the second semiconductor layer In thus form a p-n junction.

The silicon substrate 1 may include, for example, a back-surface-field (BSF) 1Hp located adjacent to the eighth surface F8. The BSF 1Hp produces, for example, an internal electric field adjacent to the eighth surface F8 of the silicon substrate 1 and reduces recombination of minority carriers near the eighth surface F8. Thus, the solar cell element 10 can avoid decrease in photoelectric conversion efficiency. The BSF 1Hp has the same conduction type as the first semiconductor layer 1p. The BSF 1Hp contains majority carriers at a higher concentration level than the first semiconductor layer 1p. For example, when the silicon substrate 1 is of p-type, the BSF 1Hp may be formed by introducing a dopant element such as boron or aluminum into the surface layer on the eighth surface F8 of the silicon substrate 1 by diffusion. In this example, the concentration of the dopant in the BSF 1Hp is, for example, about 1 × 10¹⁸ to 5 × 10²¹ atoms/cm³.

The anti-reflection film 2 is located, for example, on the seventh surface F7 adjacent to the light receiving surface 10a of the silicon substrate 1. The anti-reflection film 2 reduces the reflectivity of the light receiving surface 10a against light in an intended wavelength range, thus allowing light in the intended wavelength range to be easily absorbed into the silicon substrate 1. This may increase the amount of carriers generated through photoelectric conversion in the silicon substrate 1. The anti-reflection film 2 may be formed from, for example, one or more materials selected from silicon nitride, titanium oxide, and silicon oxide. For example, the anti-reflection film 2 may have a thickness specified as appropriate in accordance with the material to achieve a condition under which incident light in an intended wavelength range is hardly reflected (reflection-free condition). More specifically, for example, the anti-reflection film 2 has a refractive index of about 1.8 to 2.3 and a thickness of about 50 to 120 nanometers (nm).

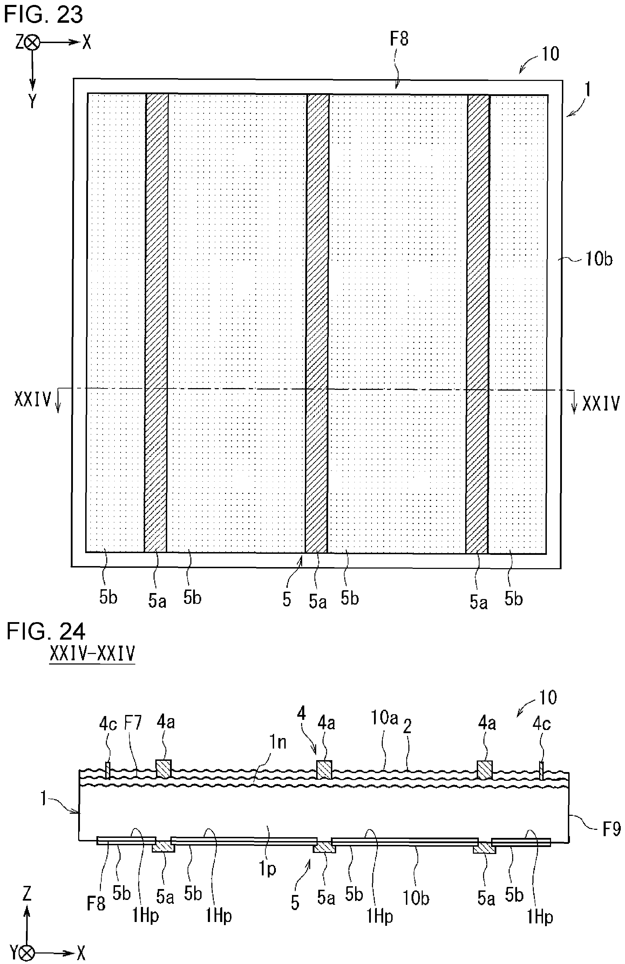

The first electrode 4 is located on, for example, the seventh surface F7 adjacent to the light receiving surface 10a of the silicon substrate 1. As shown in FIGs. 22 and 24, the first electrode 4 includes, for example, first output-intake electrodes 4a and linear first current-collecting electrodes 4b. In the example in FIGs. 22 and 24, the first electrode 4 includes three first output-intake electrodes 4a elongated in the positive Y-direction and twenty-two linear first current-collecting electrodes 4b elongated in the positive X-direction. At least one of the first output-intake electrodes 4a crosses each first current-collecting electrode 4b. The first output-intake electrodes 4a each have a line width of, for example, about 0.6 to 1.5 mm. The first current-collecting electrodes 4b each have a line width of, for example, about 25 to 100 µm. The first current-collecting electrodes 4b thus have a less line width than the first output-intake electrodes 4a. The linear first current-collecting electrodes 4b are at predetermined intervals in the positive Y-direction and are substantially parallel to one another. The predetermined interval is, for example, about 1.5 to 3 mm. The first electrode 4 has a thickness of, for example, about 10 to 40 µm. The first electrode 4 may include, for example, an auxiliary electrode 4c connecting the ends of the first current-collecting electrodes 4b in the positive X-direction and an auxiliary electrode 4c connecting the ends of the first current-collecting electrodes 4b in the negative X-direction. The auxiliary electrodes 4c have, for example, substantially the same line width as the first current-collecting electrodes 4b. The first electrode 4 may be formed by, for example, applying silver paste in an intended pattern to the seventh surface F7 of the silicon substrate 1 and then firing the silver paste. The silver paste may be a mixture of, for example, powder containing silver as the main ingredient, glass frit, and an organic vehicle. The main ingredient refers to an ingredient that has the highest content among the contained ingredients. The silver paste may be applied by, for example, screen printing.

The second electrode 5 is located on, for example, the eighth surface F8 adjacent to the non-light receiving surface 10b of the silicon substrate 1. As shown in FIGs. 23 and 24, the second electrode 5 includes, for example, second output-intake electrodes 5a and second current-collecting electrodes 5b. In the example in FIGs. 23 and 24, the second electrode 5 includes three second output-intake electrodes 5a elongated in the positive Y-direction. The second output-intake electrodes 5a each have a thickness of, for example, about 10 to 30 µm. The second output-intake electrodes 5a each have a line width of, for example, about 1 to 4 mm. The second output-intake electrodes 5a may be formed from, for example, the same material and in the same manner as the first electrode 4. For example, the second output-intake electrodes 5a may be formed by, for example, applying silver paste in an intended pattern to the eighth surface F8 of the silicon substrate 1 and then firing the silver paste. The second current-collecting electrodes 5b are located across, for example, substantially the entire eighth surface F8 of the silicon substrate 1 except in a large portion of the area in which the second output-intake electrodes 5a are located. The second current-collecting electrodes 5b each have a thickness of, for example, about 15 to 50 µm. The second current-collecting electrodes 5b may be formed by, for example, applying aluminum paste in an intended pattern to the eighth surface F8 of the silicon substrate 1 and then firing the aluminum paste. The aluminum paste may be a mixture of, for example, powder containing aluminum as the main ingredient, glass frit, and an organic vehicle. The aluminum paste may be applied by, for example, screen printing.

### 1-7. Output Characteristics of Solar Cell Element in Specific Example

A rectangular prismatic silicon ingot according to the first embodiment was first manufactured in a specific example with the manufacturing method for the silicon ingot In1 shown in FIGs. 11 to 16 and using the second manufacturing apparatus 1002 shown in FIG. 2. In this example, the seed crystal assembly 200s includes five seed crystals and intermediate seed crystals each located adjacent ones of the five seed crystals aligned in the positive X-direction as the second direction, and also includes two seed crystals and an intermediate seed crystal located between the two seed crystals aligned in the positive Y-direction as the third direction. In this example, the crystal direction of each of the seed crystals and the intermediate seed crystals parallel to the positive Z-direction as the first direction has the Miller indices of <100>. In other words, the upper surface of each of the seed crystals and the intermediate seed crystals facing in the positive Z-direction as the first direction has the Miller indices of (100). Each pair of a seed crystal and an intermediate seed crystal adjacent each other have a rotation angle relationship of 45 degrees between their silicon monocrystals about an imaginary axis parallel to the positive Z-direction as the first direction. Each intermediate seed crystal has a width of about 10 mm in the positive X-direction as the second direction or in the positive Y-direction as the third direction. Silicon lumps doped with boron was used as the material for the silicon ingot to manufacture the silicon ingot in the specific example according to the first embodiment having a conductivity of p-type.

Subsequently, the silicon ingot was cut, with a band saw along the eight faces of the ingot, into twenty-five prismatic silicon blocks each having a square bottom surface with a side of about 157 mm and a height of about 215 mm. Each silicon block was then sliced, with a band saw, into silicon substrates each having square front and back surfaces with a side of about 157 mm and a thickness of about 170 µm. Each silicon substrate was then etched with caustic soda to remove contaminated and mechanically damaged layers on its front and back surfaces. A surface (first surface) of each silicon substrate was then textured by reactive ion etching (RIE) to have fine irregularities. Phosphorus (P) as a n-type dopant was introduced into the surface layer of the first surface of each silicon substrate by vapor phase thermal diffusion using phosphorus oxychloride (POCl₃) as the diffusion source, thus forming a p-n junction in each silicon substrate. Subsequently, a thin silicon nitride film (anti-reflection film) was deposited on the first surface of the silicon substrate by vapor deposition. Silver paste was further applied to the first surface of the silicon substrate and then dried, and silver paste and aluminum paste were applied to a second surface of the silicon substrate opposite to the first surface and then dried. The silver paste and the aluminum paste were fired to be the first electrode and the second electrode. In this manner, many solar cell elements shown in FIGs. 22 to 24 were fabricated in the specific example.

Silicon ingots in first and second reference examples were further manufactured by placing no seed crystal or arranging the intermediate seed crystals and the seed crystals in a manner different from the manner used in the manufacturing method for the silicon ingot in the specific example.

The silicon ingot in the first reference example was manufactured using the second manufacturing apparatus 1002 shown in FIG. 2 without placing the seed crystal assembly 200s on the bottom 121b of the mold 121.

The silicon ingot in the second reference example was manufactured using the second manufacturing apparatus 1002 shown in FIG. 2. Thirty-six square seed crystals each being about 160 mm on a side as viewed in plan were arranged on the bottom 121b of the mold 121 adjacent to one another in matrix. In this example, the thirty-six seed crystals include no intermediate seed crystal. The thirty-six seed crystals include six seed crystal rows extending in the positive Y-direction as the third direction each including six seed crystals arranged in the positive X-direction as the second direction. In this example, the upper surface of each of the thirty-six seed crystals facing in the positive Z-direction as the first direction has the Miller indices of (100). Each neighboring pair of the thirty-six seed crystals has a rotation angle relationship of 45 degrees between their silicon monocrystals about an imaginary axis parallel to the positive Z-direction as the first direction.

Solar cell elements in the first reference example were fabricated from the silicon ingot in the first reference example, and solar cell elements in the second reference example were fabricated from the silicon ingot in the second reference example, in the same manner as the solar cell elements in the specific example were fabricated from the silicon ingot in the specific example.

The solar cell elements in the specific example, the first reference example, and the second reference example underwent conversion efficiency measurement. The conversion efficiency was measured in accordance with JIS C 8913 (1998). The results of the measurement are shown in Table 1. Table 1 shows values normalized using the conversion efficiency for the solar cell elements in the first reference example as 100.

**Table 1**

| | Reference Example 1 | Reference example 2 | Specific example 1 |
|---|---|---|---|
| Conversion efficiency | 100 | 102 | 103 |

Table 1 shows that the solar cell elements in the second reference example and the specific example have higher conversion efficiency than the solar cell element in the first reference example. Table 1 also shows that the solar cell elements in the specific example has higher conversion efficiency than the solar cell elements in the second reference example. The results reveal that the solar cell elements 10 according to the first embodiment may improve the output characteristics. The results also reveal that the silicon ingot In1 manufactured by placing an intermediate seed crystal between seed crystals may cause fewer defects during unidirectional solidification of the silicon melt MS1.

### 1-8. Overview of First Embodiment

The manufacturing method for the silicon ingot In1 according to the first embodiment includes, for example, placing, on the bottom 121b of the mold 121, the first intermediate seed crystal Cs1 between the first seed crystal Sd1 and the second seed crystal Sd2 in the positive X-direction as the second direction, and placing the second intermediate seed crystal Cs2 between the first seed crystal Sd1 and the third seed crystal Sd3 in the positive X-direction as the third direction. For example, the first seed crystal Sd1 and the second seed crystal Sd2 have a greater width than the first intermediate seed crystal Cs1 in the positive X-direction as the second direction. The first seed crystal Sd1 and the third seed crystal Sd3 have a greater width than the second intermediate seed crystal Cs2 in the positive Y-direction as the third direction. The first seed crystal Sd1, the second seed crystal Sd2, the third seed crystal Sd3, the first intermediate seed crystal Cs1, and the second intermediate seed crystal Cs2 are arranged to allow, for example, each of the first rotation angle relationship between the first seed crystal Sd1 and the first intermediate seed crystal Cs1, the second rotation angle relationship between the second seed crystal Sd2 and the first intermediate seed crystal Cs1, the third rotation angle relationship between the first seed crystal Sd1 and second intermediate seed crystal Cs2, and the fourth rotation angle relationship between the third seed crystal Sd3 and second intermediate seed crystal Cs2 to be a rotation angle relationship of silicon monocrystals corresponding to a coincidence boundary. This allows, for example, the coincidence boundary as a functional grain boundary to form above the boundary between each pair of a seed crystal and an intermediate seed crystal, while mono-like crystals are growing by unidirectional solidification of the silicon melt MS1 from each of the first seed crystal Sd1, the second seed crystal Sd2, the third seed crystal Sd3, the first intermediate seed crystal Cs1, and the second intermediate seed crystal Cs2. Thus, while the silicon melt MS1 is unidirectionally solidifying, coincidence boundaries form constantly and reduce distortions. For example, while the silicon melt MS1 is solidifying unidirectionally, dislocations tend to occur above the portions between the first seed crystal Sd1 and the second seed crystal Sd2 and between the first seed crystal Sd1 and the third seed crystal Sd3. However, as the two functional grain boundaries form, the dislocations are likely to disappear, being confined into the mono-like crystalline portion between the two functional grain boundaries.

The manufacturing method for the silicon ingot In1 according to the first embodiment also includes, for example, placing, on the bottom 121b of the mold 121, the third intermediate seed crystal Cs3 between the second seed crystal Sd2 and the fourth seed crystal Sd4 in the positive Y-direction as the third direction, and placing the fourth intermediate seed crystal Cs4 between the third seed crystal Sd3 and the fourth seed crystal Sd4 in the positive X-direction as the second direction. For example, the second seed crystal Sd2 and the fourth seed crystal Sd4 have a greater width than the third intermediate seed crystal Cs3 in the positive Y-direction as the third direction. The third seed crystal Sd3 and the fourth seed crystal Sd4 have a greater width than the fourth intermediate seed crystal Cs4 in the positive X-direction as the second direction. The second seed crystal Sd2, the third seed crystal Sd3, the fourth seed crystal Sd4, the third intermediate seed crystal Cs3, and the fourth intermediate seed crystal Cs4 are arranged to allow, for example, each of the fifth rotation angle relationship between the second seed crystal Sd2 and the third intermediate seed crystal Cs3, the sixth rotation angle relationship between the fourth seed crystal Sd4 and the third intermediate seed crystal Cs3, the seventh rotation angle relationship between the third seed crystal Sd3 and fourth intermediate seed crystal Cs4, and the eighth rotation angle relationship between the fourth seed crystal Sd4 and fourth intermediate seed crystal Cs4 to be a rotation angle relationship of silicon monocrystals corresponding to a coincidence boundary. This allows, for example, the coincidence boundary as a functional grain boundary to form above the boundary between each pair of a seed crystal and an intermediate seed crystal, while mono-like crystals are growing by unidirectional solidification of the silicon melt MS1 from each of the second seed crystal Sd2, the third seed crystal Sd3, the fourth seed crystal Sd4, the third intermediate seed crystal Cs3, and the fourth intermediate seed crystal Cs4. Thus, while the silicon melt MS1 is unidirectionally solidifying, coincidence boundaries form constantly and reduce distortions. For example, while the silicon melt MS1 is solidifying unidirectionally, dislocations tend to occur above the portions between the second seed crystal Sd2 and the fourth seed crystal Sd4 and between the third seed crystal Sd3 and the fourth seed crystal Sd4. However, as the two functional grain boundaries form, the dislocations are likely to disappear, being confined into the mono-like crystalline portion between the two functional grain boundaries. Thus, the silicon ingot In1 may have higher quality.

The silicon ingot In1 according to the first embodiment includes, for example, the first intermediate portion Ac1 including one or more mono-like crystalline sections between the first mono-like crystalline portion Am1 and the second mono-like crystalline portion Am2 in the positive X-direction as the second direction and the second intermediate portion Ac2 including one or more mono-like crystalline sections between the first mono-like crystalline portion Am1 and the third mono-like crystalline portion Am3 in the positive Y-direction as the third direction. For example, the first mono-like crystalline portion Am1 and the second mono-like crystalline portion Am2 have a greater width than the first intermediate portion Ac1 in the positive X-direction as the second direction. The first mono-like crystalline portion Am1 and the third mono-like crystalline portion Am3 have a greater width than the second intermediate portion Ac2 in the positive Y-direction as the third direction. For example, each of the first boundary B1 between the first mono-like crystalline portion Am1 and the first intermediate portion Ac1, the second boundary B2 between the second mono-like crystalline portion Am2 and the first intermediate portion Ac1, the third boundary B3 between the first mono-like crystalline portion Am1 and the second intermediate portion Ac2, and the fourth boundary B4 between the third mono-like crystalline portion Am3 and the second intermediate portion Ac2 includes a coincidence boundary. This structure may be achieved by, for example, growing mono-like crystals from the seed crystal assembly 200s and forming a coincidence boundary above each of the boundaries between the first seed crystal Sd1 and the first intermediate seed crystal Cs1, between the second seed crystal Sd2 and the first intermediate seed crystal Cs1, between the first seed crystal Sd1 and the second intermediate seed crystal Cs2, and between the third seed crystal Sd3 and the second intermediate seed crystal Cs2. While the coincidence boundary is forming, for example, distortions are reduced to cause fewer defects in the silicon ingot In1. Thus, the structure of the silicon ingot In1 suited to the manufacture of the silicon ingot In1 causing fewer defects may has higher quality, for example.

The silicon ingot In1 according to the first embodiment includes, for example, the third intermediate portion Ac3 including one or more mono-like crystalline sections between the second mono-like crystalline portion Am2 and the fourth mono-like crystalline portion Am4 in the positive Y-direction as the third direction and the fourth intermediate portion Ac4 including one or more mono-like crystalline sections between the third mono-like crystalline portion Am3 and the fourth mono-like crystalline portion Am4 in the positive X-direction as the second direction. For example, the second mono-like crystalline portion Am2 and the fourth mono-like crystalline portion Am4 have a greater width than the third intermediate portion Ac3 in the positive Y-direction as the third direction. The third mono-like crystalline portion Am3 and the fourth mono-like crystalline portion Am4 have a greater width than the fourth intermediate portion Ac4 in the positive X-direction as the second direction. For example, each of the fifth boundary B5 between the second mono-like crystalline portion Am2 and the third intermediate portion Ac3, the sixth boundary B6 between the fourth mono-like crystalline portion Am4 and the third intermediate portion Ac3, the seventh boundary B7 between the third mono-like crystalline portion Am3 and the fourth intermediate portion Ac4, and the eighth boundary B8 between the fourth mono-like crystalline portion Am4 and the fourth intermediate portion Ac4 includes a coincidence boundary. This structure may be achieved by, for example, growing mono-like crystals from the seed crystal assembly 200s and forming a coincidence boundary above each of the boundaries between the second seed crystal Sd2 and the third intermediate seed crystal Cs3, between the fourth seed crystal Sd4 and the third intermediate seed crystal Cs3, between the third seed crystal Sd3 and the fourth intermediate seed crystal Cs4, and between the fourth seed crystal Sd4 and the fourth intermediate seed crystal Cs4. While the coincidence boundary is forming, for example, distortions are reduced to cause fewer defects in the silicon ingot In1. Thus, the structure of the silicon ingot In1 suited to the manufacture of the silicon ingot In1 causing fewer defects may has higher quality, for example.

The silicon block Bk1 according to the first embodiment may be, for example, cut out from the silicon ingot In1 according to the first embodiment. The silicon block Bk1 includes, for example, the fifth intermediate portion Ac5 including one or more mono-like crystalline sections between the fifth mono-like crystalline portion Am5 and the sixth mono-like crystalline portion Am6 in the positive X-direction as the second direction and the sixth intermediate portion Ac6 including one or more mono-like crystalline sections between the fifth mono-like crystalline portion Am5 and the seventh mono-like crystalline portion Am7 in the positive Y-direction as the third direction. For example, the fifth mono-like crystalline portion Am5 and the sixth mono-like crystalline portion Am6 have a greater width than the fifth intermediate portion Ac5 in the positive X-direction as the second direction. The fifth mono-like crystalline portion Am5 and the seventh mono-like crystalline portion Am7 have a greater width than the sixth intermediate portion Ac6 in the positive Y-direction as the third direction. For example, each of the ninth boundary B9 between the fifth mono-like crystalline portion Am5 and the fifth intermediate portion Ac5, the tenth boundary B10 between the sixth mono-like crystalline portion Am6 and the fifth intermediate portion Ac5, the eleventh boundary B 11 between the fifth mono-like crystalline portion Am5 and the sixth intermediate portion Ac6, and the twelfth boundary B12 between the seventh mono-like crystalline portion Am7 and the sixth intermediate portion Ac6 includes a coincidence boundary. This structure may be achieved by, for example, growing mono-like crystals from the seed crystal assembly 200s and forming a coincidence boundary above each of the boundaries between the first seed crystal Sd1 and the first intermediate seed crystal Cs1, between the second seed crystal Sd2 and the first intermediate seed crystal Cs1, between the first seed crystal Sd1 and the second intermediate seed crystal Cs2, and between the third seed crystal Sd3 and the second intermediate seed crystal Cs2. While the coincidence boundary is forming, for example, distortions are reduced to cause fewer defects in the silicon ingot In1. For example, the silicon block Bk1 with the structure suited to the manufacture of the silicon ingot In1 causing fewer defects may have higher quality with fewer defects.

The silicon block Bk1 according to the first embodiment includes, for example, the seventh intermediate portion Ac7 including one or more mono-like crystalline sections between the sixth mono-like crystalline portion Am6 and the eighth mono-like crystalline portion Am8 in the positive Y-direction as the third direction and the eighth intermediate portion Ac8 including one or more mono-like crystalline sections between the seventh mono-like crystalline portion Am7 and the eighth mono-like crystalline portion Am8 in the positive X-direction as the second direction. For example, the sixth mono-like crystalline portion Am6 and the eighth mono-like crystalline portion Am8 have a greater width than the seventh intermediate portion Ac7 in the positive Y-direction as the third direction. The seventh mono-like crystalline portion Am7 and the eighth mono-like crystalline portion Am8 have a greater width than the eighth intermediate portion Ac8 in the positive X-direction as the second direction. For example, each of the thirteenth boundary B13 between the sixth mono-like crystalline portion Am6 and the seventh intermediate portion Ac7, the fourteenth boundary B14 between the eighth mono-like crystalline portion Am8 and the seventh intermediate portion Ac7, the fifteenth boundary B15 between the seventh mono-like crystalline portion Am7 and the eighth intermediate portion Ac8, and the sixteenth boundary B16 between the eighth mono-like crystalline portion Am8 and the eighth intermediate portion Ac8 includes a coincidence boundary. This structure may be achieved by, for example, growing mono-like crystals from the seed crystal assembly 200s and forming a coincidence boundary above each of the boundaries between the second seed crystal Sd2 and the third intermediate seed crystal Cs3, between the fourth seed crystal Sd4 and the third intermediate seed crystal Cs3, between the third seed crystal Sd3 and the fourth intermediate seed crystal Cs4, and between the fourth seed crystal Sd4 and the fourth intermediate seed crystal Cs4. While the coincidence boundary is forming, for example, distortions are reduced to cause fewer defects in the silicon ingot In1. For example, the silicon block Bk1 with the structure suited to the manufacture of the silicon ingot In1 causing fewer defects may have higher quality with fewer defects.

The silicon substrate 1 according to the first embodiment may be, for example, cut out from the silicon ingot In1 according to the first embodiment. The silicon substrate 1 includes, for example, the ninth intermediate portion Ac9 including one or more mono-like crystalline sections between the ninth mono-like crystalline portion Am9 and the tenth mono-like crystalline portion Am10 in the positive X-direction as the second direction and the tenth intermediate portion Ac10 including one or more mono-like crystalline sections between the ninth mono-like crystalline portion Am9 and the eleventh mono-like crystalline portion Am11 in the positive Y-direction as the third direction. For example, the ninth mono-like crystalline portion Am9 and the tenth mono-like crystalline portion Am 10 have a greater width than the ninth intermediate portion Ac9 in the positive X-direction as the second direction. The ninth mono-like crystalline portion Am9 and the eleventh mono-like crystalline portion Am11 have a greater width than the tenth intermediate portion Ac10 in the positive Y-direction as the third direction. For example, each of the seventeenth boundary B17 between the ninth mono-like crystalline portion Am9 and the ninth intermediate portion Ac9, the eighteenth boundary B18 between the tenth mono-like crystalline portion Am 10 and the ninth intermediate portion Ac9, the nineteenth boundary B19 between the ninth mono-like crystalline portion Am9 and the tenth intermediate portion Ac10, and the twentieth boundary B20 between the eleventh mono-like crystalline portion Am11 and the tenth intermediate portion Ac10 includes a coincidence boundary. This structure may be achieved by, for example, growing mono-like crystals from the seed crystal assembly 200s and forming a coincidence boundary above each of the boundaries between the first seed crystal Sd1 and the first intermediate seed crystal Cs1, between the second seed crystal Sd2 and the first intermediate seed crystal Cs1, between the first seed crystal Sd1 and the second intermediate seed crystal Cs2, and between the third seed crystal Sd3 and the second intermediate seed crystal Cs2. While the coincidence boundary is forming, for example, distortions are reduced to cause fewer defects in the silicon ingot In1. In this example, the silicon substrate 1 with the structure suited to the manufacture of the silicon ingot In1 causing fewer defects may have higher quality with fewer defects.

The silicon substrate 1 according to the first embodiment includes, for example, the eleventh intermediate portion Ac11 including one or more mono-like crystalline sections between the tenth mono-like crystalline portion Am10 and the twelfth mono-like crystalline portion Am12 in the positive Y-direction as the third direction and the twelfth intermediate portion Ac12 including one or more mono-like crystalline sections between the eleventh mono-like crystalline portion Am11 and the twelfth mono-like crystalline portion Am12 in the positive X-direction as the second direction. In this example, the tenth mono-like crystalline portion Am 10 and the twelfth mono-like crystalline portion Am12 have a greater width than the eleventh intermediate portion Ac11 in the positive Y-direction as the third direction. The eleventh mono-like crystalline portion Am11 and the twelfth mono-like crystalline portion Am12 have a greater width than the twelfth intermediate portion Ac12 in the positive X-direction as the second direction. For example, each of the twenty-first boundary B21 between the tenth mono-like crystalline portion Am10 and the eleventh intermediate portion Ac11, the twenty-second boundary B22 between the twelfth mono-like crystalline portion Am12 and the eleventh intermediate portion Ac11, the twenty-third boundary B23 between the eleventh mono-like crystalline portion Am11 and the twelfth intermediate portion Ac12, and the twenty-fourth boundary B24 between the twelfth mono-like crystalline portion Am12 and the twelfth intermediate portion Ac12 includes a coincidence boundary. This structure may be achieved by, for example, growing mono-like crystals from the seed crystal assembly 200s and forming a coincidence boundary above each of the boundaries between the second seed crystal Sd2 and the third intermediate seed crystal Cs3, between the fourth seed crystal Sd4 and the third intermediate seed crystal Cs3, between the third seed crystal Sd3 and the fourth intermediate seed crystal Cs4, and between the fourth seed crystal Sd4 and the fourth intermediate seed crystal Cs4. While the coincidence boundary is forming, for example, distortions are reduced to cause fewer defects in the silicon ingot In1. In this example, the silicon substrate 1 with the structure suited to the manufacture of the silicon ingot In1 causing fewer defects may have higher quality with fewer defects.

The solar cell element 10 including the silicon substrate 1 with the structure suited to the manufacture of the silicon ingot In1 causing fewer defects may achieve, for example, higher performance in, for example, output characteristics.

### 2. Other Embodiments

The present disclosure is not limited to the above first embodiment and may be changed or modified variously without departing from the spirit and scope of the present disclosure.

### 2-1. Second Embodiment

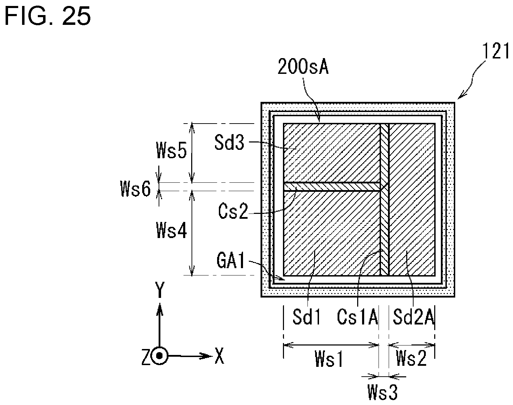

A manufacturing method for a silicon ingot In1A according to a second embodiment may replace, for example, the seed crystal assembly 200s with a seed crystal assembly 200sA not including the fourth seed crystal Sd4 in the second process in the manufacturing method for the silicon ingot In1 according to the first embodiment. In this example, as shown in FIG. 25, the first seed crystal Sd1, a second seed crystal Sd2A, the third seed crystal Sd3, a first intermediate seed crystal Cs1A, and the second intermediate seed crystal Cs2 may be arranged on the bottom 121b of the mold 121 without the fourth seed crystal Sd4. More specifically, for example, the first seed crystal Sd1, the first intermediate seed crystal Cs1A, and the second seed crystal Sd2A may be arranged, on the bottom 121b of the mold 121, adjacent to one another in sequence in the positive X-direction as the second direction. The first seed crystal Sd1, the second intermediate seed crystal Cs2, and the third seed crystal Sd3 may be arranged, on the bottom 121b of the mold 121, adjacent to one another in sequence in the positive Y-direction as the third direction.

In the example in FIG. 25, the second seed crystal Sd2A extends over an area corresponding the total area of the second seed crystal Sd2, the third intermediate seed crystal Cs3, and the fourth seed crystal Sd4 in the first embodiment. In other words, the third intermediate seed crystal Cs3 and the fourth seed crystal Sd4 are eliminated in this example. The first intermediate seed crystal Cs1A extends over an area corresponding the total area of the first intermediate seed crystal Cs1 and the fourth intermediate seed crystal Cs4 in the first embodiment. In other words, the fourth intermediate seed crystal Cs4 is eliminated in this example. The second intermediate seed crystal Cs2 has one end in its longitudinal direction parallel to the positive X-direction as the second direction in contact with a middle portion of the first intermediate seed crystal Cs1A in its longitudinal direction parallel to the positive Y-direction in the third direction. In other words, the first intermediate seed crystal Cs1 and the second intermediate seed crystal Cs2 together form a T-shape. For example, the third seed crystal Sd3, the first intermediate seed crystal Cs1, and the second seed crystal Sd2 are arranged on the bottom 121b of the mold 121 adjacent to one another in sequence in the positive X-direction as the second direction.

In the second process of the manufacturing method for the silicon ingot In1A according to the second embodiment, for example, the first intermediate seed crystal Cs1A has a width (third seed width) Ws3 less than each of the width (first seed width) Ws1 of the first seed crystal Sd1 and a width (second seed width) Ws2 of the second seed crystal Sd2A in the positive X-direction as the second direction. In other words, each of the first seed width Ws1 and the second seed width Ws2 is greater than the third seed width Ws3 in the positive X-direction as the second direction. For example, the second intermediate seed crystal Cs2 has a width (sixth seed width) Ws6 less than each of the width (fourth seed width) Ws4 of the first seed crystal Sd1 and the width (fifth seed width) Ws5 of the third seed crystal Sd3 in the positive Y-direction as the third direction. In other words, each of the fourth seed width Ws4 and the fifth seed width Ws5 is greater than the sixth seed width Ws6 in the positive Y-direction as the third direction. The first seed crystal Sd1, the second seed crystal Sd2A, the third seed crystal Sd3, the first intermediate seed crystal Cs1A, and the second intermediate seed crystal Cs2 included in the seed crystal assembly 200sA are arranged to allow, for example, each of a first rotation angle relationship between the first seed crystal Sd1 and the first intermediate seed crystal Cs1A, a second rotation angle relationship between the first intermediate seed crystal Cs1A and the second seed crystal Sd2A, a third rotation angle relationship between the first seed crystal Sd1 and the second intermediate seed crystal Cs2, and a fourth rotation angle relationship between the second intermediate seed crystal Cs2 and the third seed crystal Sd3 to be a rotation angle relationship of silicon monocrystals corresponding to a coincidence boundary. For example, each of the rotation angle relationship between the third seed crystal Sd3 and the first intermediate seed crystal Cs1A and the rotation angle relationship between the first intermediate seed crystal Cs1A and the second seed crystal Sd2A may be a rotation angle relationship of silicon monocrystals corresponding to a coincidence boundary.

The manufacturing method for the silicon ingot In1A according to the second embodiment allows, for example, the coincidence boundary as a functional grain boundary to form above each of the boundaries between the first seed crystal Sd1 and the first intermediate seed crystal Cs1A, between the second seed crystal Sd2A and the first intermediate seed crystal Cs1 A, between the first seed crystal Sd1 and the second intermediate seed crystal Cs2, and between the third seed crystal Sd3 and the second intermediate seed crystal Cs2, while mono-like crystals are growing by unidirectional solidification of the melt MS1 from each of the first seed crystal Sd1, the second seed crystal Sd2A, the third seed crystal Sd3, the first intermediate seed crystal Cs1A, and the second intermediate seed crystal Cs2. Thus, while the silicon melt MS1 is unidirectionally solidifying, coincidence boundaries form constantly and reduce distortions. For example, while the silicon melt MS1 is solidifying unidirectionally, dislocations tend to occur above the portions between the first seed crystal Sd1 and the second seed crystal Sd2A and between the first seed crystal Sd1 and the third seed crystal Sd3. However, as the two functional grain boundaries form, the dislocations are likely to disappear, being confined into the mono-like crystalline portion between the two functional grain boundaries. Thus, the silicon ingot In1A may have higher quality, for example.

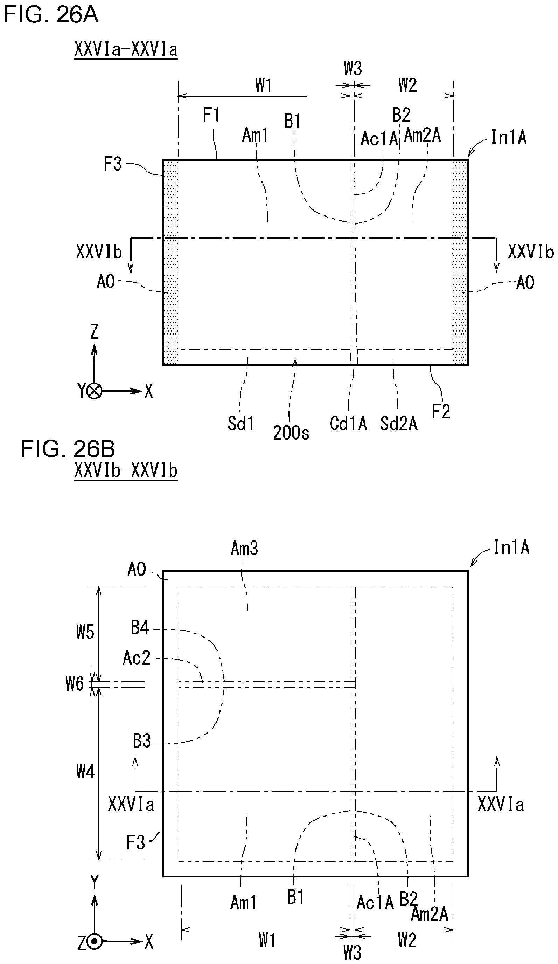

As shown in FIGs. 26A and 26B, the silicon ingot In1A manufactured with the method for manufacturing the silicon ingot In1A according to the second embodiment includes, for example, the first mono-like crystalline portion Am1, a second mono-like crystalline portion Am2A, the third mono-like crystalline portion Am3, a first intermediate portion Ac1A, and the second intermediate portion Ac2, without including the fourth mono-like crystalline portion Am4. More specifically, for example, the first mono-like crystalline portion Am1, the first intermediate portion Ac1A, and the second mono-like crystalline portion Am2A are adjacent to one another in the stated order in the positive X-direction as the second direction. The first mono-like crystalline portion Am1, the second intermediate portion Ac2, and the third mono-like crystalline portion Am3 are adjacent to one another in the stated order in the positive Y-direction as the third direction.

In the example in FIGs. 26A and 26B, the second mono-like crystalline portion Am2A extends over an area corresponding to the total area of the second mono-like crystalline portion Am2, the third intermediate portion Ac3, and the fourth mono-like crystalline portion Am4 in the first embodiment. In other words, the third intermediate portion Ac3 and the fourth mono-like crystalline portion Am4 are eliminated in this example. The first intermediate portion Ac1A extends over an area corresponding to the total area of the first intermediate portion Ac1 and the fourth intermediate portion Ac4 in the first embodiment. In other words, the fourth intermediate portion Ac4 is eliminated in this example. The second intermediate portion Ac2 has one end in its longitudinal direction parallel to the positive X-direction as the second direction in contact with a middle portion of the first intermediate portion Ac1A in its longitudinal direction parallel to the positive Y-direction in the third direction. In other words, the first intermediate portion Ac1A and the second intermediate portion Ac2 together form a T-shape. For example, the third mono-like crystalline portion Am3, the first intermediate portion Ac1A, and the second mono-like crystalline portion Am2A are adjacent to one another in sequence in the positive X-direction as the second direction.

For the silicon ingot In1A according to the second embodiment, for example, the first intermediate portion Ac1A has a width (third width) W3 less than each of the width (first width) W1 of the first mono-like crystalline portion Am1 and a width (second width) W2 of the second mono-like crystalline portion Am2A in the positive X-direction as the second direction. In other words, each of the first width W1 and the second width W2 is greater than the third width W3 in the positive X-direction as the second direction. The second intermediate portion Ac2 has a width (sixth width) W6 less than each of the width (fourth width) W4 of the first mono-like crystalline portion Am1 and the width (fifth width) W5 of the third mono-like crystalline portion Am3 in the positive Y-direction as the third direction. In other words, each of the fourth width W4 and the fifth width W5 is greater than the sixth width W6 in the positive Y-direction as the third direction. For example, each of the first boundary B1 between the first mono-like crystalline portion Am1 and the first intermediate portion Ac1A, the second boundary B2 between the first intermediate portion Ac1A and the second mono-like crystalline portion Am2A, the third boundary B3 between the first mono-like crystalline portion Am1 and the second intermediate portion Ac2, and the fourth boundary B4 between the second intermediate portion Ac2 and the third mono-like crystalline portion Am3 includes a coincidence boundary. In this example, each of the boundaries between the third mono-like crystalline portion Am3 and the first intermediate portion Ac1A and between the first intermediate portion Ac1A and the second mono-like crystalline portion Am2A may have a coincidence boundary.

The silicon ingot In1A according to the second embodiment may be manufactured by, for example, growing mono-like crystals from the seed crystal assembly 200sA and forming a coincidence boundary above each of the boundaries between the first seed crystal Sd1 and the first intermediate seed crystal Cs1A, between the second seed crystal Sd2A and the first intermediate seed crystal Cs1A, between the first seed crystal Sd1 and the second intermediate seed crystal Cs2, and between the third seed crystal Sd3 and the second intermediate seed crystal Cs2. While the coincidence boundary is forming, for example, distortions are reduced to cause fewer defects in the silicon ingot In1A. Thus, the silicon ingot In1A suited to the manufacture of the silicon ingot In1A causing fewer defects may have higher quality, for example.

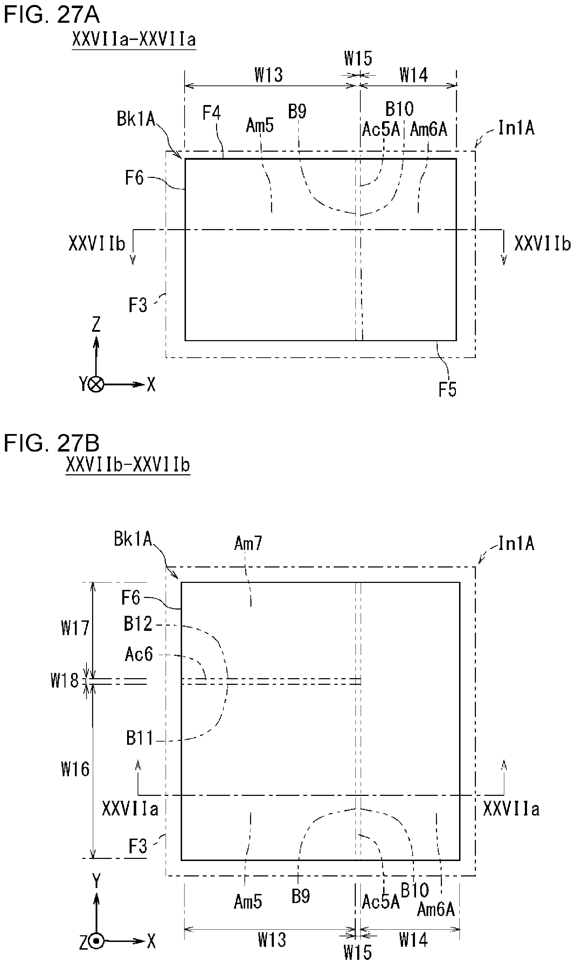

As shown in FIGs. 27A and 27B, the silicon block Bk1A cut out from the silicon ingot In1A according to the second embodiment with the above structure includes, for example, the fifth mono-like crystalline portion Am5, a sixth mono-like crystalline portion Am6A, the seventh mono-like crystalline portion Am7, a fifth intermediate portion Ac5A, and the sixth intermediate portion Ac6, without including the eighth mono-like crystalline portion Am8. More specifically, for example, the fifth mono-like crystalline portion Am5, the fifth intermediate portion Ac5A, and the sixth mono-like crystalline portion Am6A are adjacent to one another in the stated order in the positive X-direction as the second direction. The fifth mono-like crystalline portion Am5, the sixth intermediate portion Ac6, and the seventh mono-like crystalline portion Am7 are adjacent to one another in the stated order in the positive Y-direction as the third direction.

In the example in FIGs. 27A and 27B, the sixth mono-like crystalline portion Am6A extends over an area corresponding to the total area of the sixth mono-like crystalline portion Am6, the seventh intermediate portion Ac7, and the eighth mono-like crystalline portion Am8 in the first embodiment. In other words, the seventh intermediate portion Ac7 and the eighth mono-like crystalline portion Am8 are eliminated in this example. The fifth intermediate portion Ac5A extends over an area corresponding to the total area of the fifth intermediate portion Ac5 and the eighth intermediate portion Ac8 in the first embodiment. In other words, the eighth intermediate portion Ac8 is eliminated in this example. The sixth intermediate portion Ac6 has one end in its longitudinal direction parallel to the positive X-direction as the second direction in contact with a middle portion of the fifth intermediate portion Ac5A in its longitudinal direction parallel to the positive Y-direction in the third direction. In other words, the fifth intermediate portion Ac5A and the sixth intermediate portion Ac6 together form a T-shape. For example, the seventh mono-like crystalline portion Am7, the fifth intermediate portion Ac5A, and the sixth mono-like crystalline portion Am6A are adjacent to one another in sequence in the positive X-direction as the second direction.

For the silicon block Bk1A according to the second embodiment, for example, the fifth intermediate portion Ac5A has a width (fifteenth width) W15 less than each of the width (thirteenth width) W13 of the fifth mono-like crystalline portion Am5 and the width (fourteenth width) W14 of the sixth mono-like crystalline portion Am6A in the positive X-direction as the second direction. In other words, each of the thirteenth width W13 and the fourteenth width W14 is greater than the fifteenth width W15 in the positive X-direction as the second direction. For example, the sixth intermediate portion Ac6 has a width (eighteenth width) W18 less than each of the width (sixteenth width) W16 of the fifth mono-like crystalline portion Am5 and the width (seventeenth width) W17 of the seventh mono-like crystalline portion Am7 in the positive Y-direction as the third direction. In other words, each of the sixteenth width W16 and the seventeenth width W17 is greater than the eighteenth width W18 in the positive Y-direction as the third direction. For example, each of the ninth boundary B9 between the fifth mono-like crystalline portion Am5 and the fifth intermediate portion Ac5A, the tenth boundary B10 between the fifth intermediate portion Ac5A and the sixth mono-like crystalline portion Am6A, the eleventh boundary B11 between the fifth mono-like crystalline portion Am5 and the sixth intermediate portion Ac6, and the twelfth boundary B 12 between the sixth intermediate portion Ac6 and the seventh mono-like crystalline portion Am7 includes a coincidence boundary. For example, each of the boundaries between the seventh mono-like crystalline portion Am7 and the fifth intermediate portion Ac5A and between the fifth intermediate portion Ac5A and the sixth mono-like crystalline portion Am6A may have a coincidence boundary.

The silicon block bklA according to the second embodiment may be manufactured by, for example, growing mono-like crystals from the seed crystal assembly 200sAand forming a coincidence boundary above each of the boundaries between the first seed crystal Sd1 and the first intermediate seed crystal Cs1A, between the second seed crystal Sd2A and the first intermediate seed crystal Cs1A, between the first seed crystal Sd1 and the second intermediate seed crystal Cs2, and between the third seed crystal Sd3 and the second intermediate seed crystal Cs2. While the coincidence boundary is forming, for example, distortions are reduced to cause fewer defects in the silicon ingot In1A. For example, the silicon block Bk1A with the structure suited to the manufacture of the silicon ingot In1A causing fewer defects may have higher quality with fewer defects.

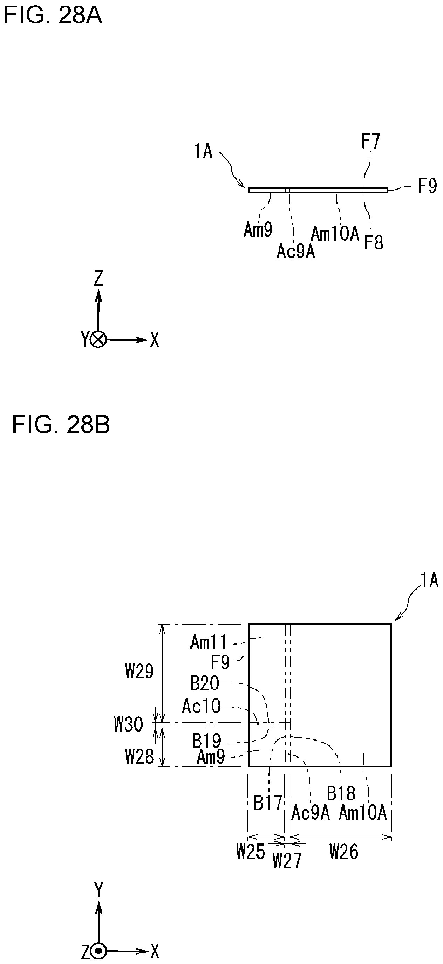

As shown in FIGs. 28A and 28B, a silicon substrate 1A cut out from the silicon block Bk1A according to the second embodiment with the above structure includes, for example, the ninth mono-like crystalline portion Am9, a tenth mono-like crystalline portion Am10A, the eleventh mono-like crystalline portion Am11, a ninth intermediate portion Ac9A, and the tenth intermediate portion Ac10, without including the twelfth mono-like crystalline portion Am12. More specifically, for example, the ninth mono-like crystalline portion Am9, the ninth intermediate portion Ac9A, and the tenth mono-like crystalline portion Am10A are adjacent to one another in the stated order in the positive X-direction as the second direction. The ninth mono-like crystalline portion Am9, the tenth intermediate portion Ac10, and the eleventh mono-like crystalline portion Am11 are adjacent to one another in the stated order in the positive Y-direction as the third direction.

In the example in FIGs. 28A and 28B, the tenth mono-like crystalline portion Am10A extends over an area corresponding to the total area of the tenth mono-like crystalline portion Am10, the eleventh intermediate portion Ac11, and the twelfth mono-like crystalline portion Am12 in the first embodiment. In other words, the eleventh intermediate portion Ac11 and the twelfth mono-like crystalline portion Am12 are eliminated in this example. The ninth intermediate portion Ac9A extends over an area corresponding to the total area of the ninth intermediate portion Ac9 and the twelfth intermediate portion Ac12 in the first embodiment. In other words, the twelfth intermediate portion Ac12 is eliminated in this example. The tenth intermediate portion Ac10 has one end in its longitudinal direction parallel to the positive X-direction as the second direction in contact with a middle portion of the ninth intermediate portion Ac9A in its longitudinal direction parallel to the positive Y-direction in the third direction. In other words, the ninth intermediate portion Ac9A and the tenth intermediate portion Ac10 together form a T-shape. In this example, the eleventh mono-like crystalline portion Am11, the ninth intermediate portion Ac9A, and the tenth mono-like crystalline portion Am10A are adjacent to one another in sequence in the positive X-direction as the second direction.

For the silicon substrate 1A according to the second embodiment, for example, the ninth intermediate portion Ac9A has a width (twenty-seventh width) W27 less than each of the width (twenty-fifth width) W25 of the ninth mono-like crystalline portion Am9 and the width (twenty-sixth width) W26 of the tenth mono-like crystalline portion Am10A in the positive X-direction as the second direction. In other words, each of the twenty-fifth width W25 and the twenty-sixth width W26 is greater than the twenty-seventh width W27 in the positive X-direction as the second direction. The tenth intermediate portion Ac10 has a width (thirtieth width) W30 less than each of the width (twenty-eighth width) W28 of the ninth mono-like crystalline portion Am9 and the width (twenty-ninth width) W29 of the eleventh mono-like crystalline portion Am11 in the positive Y-direction as the third direction. In other words, each of the twenty-eighth width W28 and the twenty-ninth width W29 is greater than the thirtieth width W30 in the positive Y-direction as the third direction. For example, each of the seventeenth boundary B17 between the ninth mono-like crystalline portion Am9 and the ninth intermediate portion Ac9A, the eighteenth boundary B18 between the ninth intermediate portion Ac9A and the tenth mono-like crystalline portion Am 10A, the nineteenth boundary B19 between the ninth mono-like crystalline portion Am9 and the tenth intermediate portion Ac10, and the twentieth boundary B20 between the tenth intermediate portion Ac10 and the eleventh mono-like crystalline portion Am11 includes a coincidence boundary. In this example, each of the boundaries between the eleventh mono-like crystalline portion Am11 and the ninth intermediate portion Ac9A and between the ninth intermediate portion Ac9A and the tenth mono-like crystalline portion Am10A may have a coincidence boundary.

The silicon substrate 1A according to the second embodiment may be manufactured by, for example, growing mono-like crystals from the seed crystal assembly 200sAand forming a coincidence boundary above each of the boundaries between the first seed crystal Sd1 and the first intermediate seed crystal Cs1A, between the second seed crystal Sd2A and the first intermediate seed crystal Cs1A, between the first seed crystal Sd1 and the second intermediate seed crystal Cs2, and between the third seed crystal Sd3 and the second intermediate seed crystal Cs2. While the coincidence boundary is forming, for example, distortions are reduced to cause fewer defects in the silicon ingot In1A. For example, the silicon substrate 1A with the structure suited to the manufacture of the silicon ingot In1A causing fewer defects may have higher quality with fewer defects.

### 3. Others

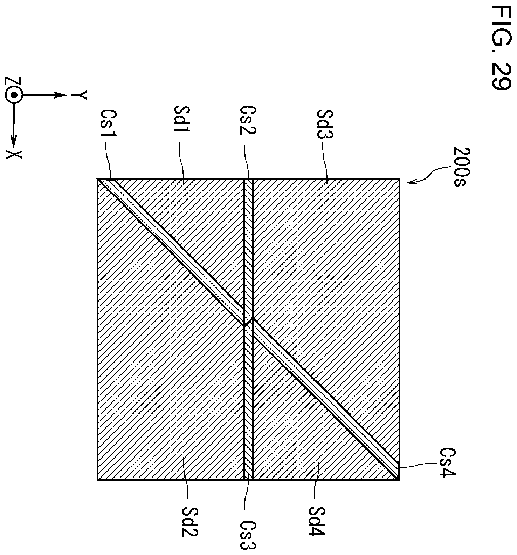

In the first and second embodiments, for example, the second direction and the third direction may cross each other at an angle other than 90 degrees. For example, the angle between the second direction and the third direction may be set to an angle included in a rotation angle relationship of silicon monocrystals corresponding to a coincidence boundary. For example, as shown in FIG. 29, the angle between the second direction and the third direction may be set to 42 to 45 degrees, which is the rotation angle relationship of silicon monocrystals corresponding to a Σ29 coincidence boundary. In the example in FIG. 29, each of the first rotation angle relationship between the first seed crystal Sd1 and the first intermediate seed crystal Cs1, the second rotation angle relationship between the second seed crystal Sd2 and the first intermediate seed crystal Cs1, the seventh rotation angle relationship between the third seed crystal Sd3 and the fourth intermediate seed crystal Cs4, and the eighth rotation angle relationship between the fourth seed crystal Sd4 and the fourth intermediate seed crystal Cs4 may easily be the rotation angle relationship of silicon monocrystals corresponding to a Σ29 coincidence boundary. For example, for the second direction and the third direction orthogonal to each other, the seed crystals and the intermediate seed crystals are easily produced, as well as easily arranged on the bottom 121b of the mold 121. This allows, for example, easy manufacture of high quality silicon ingots In1 and In1A, silicon blocks Bk1 and Bk1A, and silicon substrates In1 and In1A.

Being orthogonal to each other allows the second direction and the third direction to cross each other at an angle deviating from 90 degrees within an error margin of about 1 to 3 degrees. More specifically, the second direction and the third direction crossing each other orthogonally may cross each other at an angle of 87 to 93 degrees. The error in the angle between the second direction and the third direction deviating from 90 degrees may occur when, for example, preparing the seed crystals and the intermediate seed crystals by cutting and when arranging the seed crystals and the intermediate seed crystals.

In the first and second embodiments, for example, the first surface F1 and the second surface F2 of the silicon ingot In1 or In1A and the fourth surface F4 and the fifth surface F5 of the silicon block Bk1 or Bk1A may each be shaped variously in accordance with, for example, the shape of the silicon substrate 1 or 1A, rather than being rectangular.

The components described in the first and second embodiments and modifications may be entirely or partially combined as appropriate unless any contradiction arises. Reference Signs List

1, 1A silicon substrate
4 first electrode
5 second electrode
10 solar cell element
121 mold
121b bottom
121i internal space (second internal space)
121o upper opening (second upper opening)
1001 first manufacturing apparatus
1002 second manufacturing apparatus
200s, 200sA seed crystal assembly
Ac1, Ac1A first intermediate portion
Ac2, Ac3, Ac4 second to fourth intermediate portions
Ac5, Ac5A fifth intermediate portion
Ac6 to Ac8 sixth to eighth intermediate portions
Ac9, Ac9A ninth intermediate portion
Ac10 to Ac12 tenth to twelfth intermediate portions
Am1 first mono-like crystalline portion
Am2, Am2A second mono-like crystalline portion
Am3 to Am5third to fifth mono-like crystalline portions
Am6, Am6Asixth mono-like crystalline portion
Am7 to Am9seventh to ninth mono-like crystalline portions
Am10, Am10A tenth mono-like crystalline portion
Am11, Am12 eleventh and twelfth mono-like crystalline portions
B1 to B24 first to twenty-fourth boundaries
Bk1, Bk1A silicon block
Bkla, Bklb, Bklc, Bkld first to fourth silicon blocks
Cs1, Cs1A first intermediate seed crystal
Cs2 to Cs4 second to fourth intermediate seed crystals
F1 to F9 first to ninth surfaces
In1, In1A silicon ingot
MS1 silicon melt
PS0 silicon lump
Sd1 first seed crystal
Sd2, Sd2A second seed crystal
Sd3, Sd4 third and fourth seed crystals
W1 to W36 first to thirty-sixth widths
Ws1 to Ws12 first to twelfth seed widths

## Claims

1. A silicon ingot having a first surface, a second surface opposite to the first surface, and a third surface extending in a first direction and connecting the first surface and the second surface, the silicon ingot comprising:
a first mono-like crystalline portion;
a first intermediate portion including one or more mono-like crystalline sections;
a second mono-like crystalline portion;
a second intermediate portion including one or more mono-like crystalline sections; and
a third mono-like crystalline portion,
wherein the first mono-like crystalline portion, the first intermediate portion, and the second mono-like crystalline portion are adjacent to one another in sequence in a second direction perpendicular to the first direction,
the first mono-like crystalline portion, the second intermediate portion, and the third mono-like crystalline portion are adjacent to one another in sequence in a third direction perpendicular to the first direction and crossing the second direction,
a first width of the first mono-like crystalline portion and a second width of the second mono-like crystalline portion each are greater than a third width of the first intermediate portion in the second direction,
a fourth width of the first mono-like crystalline portion and a fifth width of the third mono-like crystalline portion each are greater than a sixth width of the second intermediate portion in the third direction, and
a boundary between the first mono-like crystalline portion and the first intermediate portion, a boundary between the second mono-like crystalline portion and the first intermediate portion, a boundary between the first mono-like crystalline portion and the second intermediate portion, and a boundary between the third mono-like crystalline portion and the second intermediate portion each include a coincidence boundary.

2. The silicon ingot according to claim 1, further comprising:
a third intermediate portion including one or more mono-like crystalline sections;
a fourth mono-like crystalline portion; and
a fourth intermediate portion including one or more mono-like crystalline sections,
wherein the second mono-like crystalline portion, the third intermediate portion, and the fourth mono-like crystalline portion are adjacent to one another in sequence in the third direction,
the third mono-like crystalline portion, the fourth intermediate portion, and the fourth mono-like crystalline portion are adjacent to one another in sequence in the second direction,
a seventh width of the second mono-like crystalline portion and an eighth width of the fourth mono-like crystalline portion each are greater than a ninth width of the third intermediate portion in the third direction,
a tenth width of the third mono-like crystalline portion and an eleventh width of the fourth mono-like crystalline portion each are greater than a twelfth width of the fourth intermediate portion in the second direction, and
a boundary between the second mono-like crystalline portion and the third intermediate portion, a boundary between the fourth mono-like crystalline portion and the third intermediate portion, a boundary between the third mono-like crystalline portion and the fourth intermediate portion, and a boundary between the fourth mono-like crystalline portion and the fourth intermediate portion each include a coincidence boundary.

3. The silicon ingot according to claim 1 or claim 2, wherein
the second direction and the third direction are orthogonal to each other.

4. The silicon ingot according to any one of claims 1 to 3, wherein
each of the first mono-like crystalline portion, the second mono-like crystalline portion, the third mono-like crystalline portion, the one or more mono-like crystalline sections included in the first intermediate portion, and the one or more mono-like crystalline sections included in the second intermediate portion has a crystal direction parallel to the first direction with Miller indices of <100>.

5. The silicon ingot according to claim 4, wherein
the coincidence boundary includes a Σ29 coincidence boundary.

6. The silicon ingot according to any one of claims 1 to 5, wherein
the silicon ingot has at least one of a width relationship in which the first width is different from the second width or a width relationship in which the fourth width is different from the fifth width.

7. The silicon ingot according to any one of claims 1 to 6, further comprising:
a first portion including a first end; and
a second portion including a second end opposite to the first end,
wherein the first portion has a higher ratio of Σ29 coincidence boundaries than the second portion, and
the second portion has a higher ratio of Σ5 coincidence boundaries than the first portion.

8. A silicon block having a fourth surface, a fifth surface opposite to the fourth surface, and a sixth surface extending in a first direction and connecting the fourth surface and the fifth surface, the silicon block comprising:
a fifth mono-like crystalline portion;
a fifth intermediate portion including one or more mono-like crystalline sections;
a sixth mono-like crystalline portion;
a sixth intermediate portion including one or more mono-like crystalline sections; and
a seventh mono-like crystalline portion,
wherein the fifth mono-like crystalline portion, the fifth intermediate portion, and the sixth mono-like crystalline portion are adjacent to one another in sequence in a second direction perpendicular to the first direction,
the fifth mono-like crystalline portion, the sixth intermediate portion, and the seventh mono-like crystalline portion are adjacent to one another in sequence in a third direction perpendicular to the first direction and crossing the second direction,
a thirteenth width of the fifth mono-like crystalline portion and a fourteenth width of the sixth mono-like crystalline portion each are greater than a fifteenth width of the fifth intermediate portion in the second direction,
a sixteenth width of the fifth mono-like crystalline portion and a seventeenth width of the seventh mono-like crystalline portion each are greater than an eighteenth width of the sixth intermediate portion in the third direction, and
a boundary between the fifth mono-like crystalline portion and the fifth intermediate portion, a boundary between the sixth mono-like crystalline portion and the fifth intermediate portion, a boundary between the fifth mono-like crystalline portion and the sixth intermediate portion, and a boundary between the seventh mono-like crystalline portion and the sixth intermediate portion each include a coincidence boundary.

9. The silicon block according to claim 8, further comprising:
a seventh intermediate portion including one or more mono-like crystalline sections;
an eighth mono-like crystalline portion; and
an eighth intermediate portion including one or more mono-like crystalline sections,
wherein the sixth mono-like crystalline portion, the seventh intermediate portion, and the eighth mono-like crystalline portion are adjacent to one another in sequence in the third direction,
the seventh mono-like crystalline portion, the eighth intermediate portion, and the eighth mono-like crystalline portion are adjacent to one another in sequence in the second direction,
a nineteenth width of the sixth mono-like crystalline portion and a twentieth width of the eighth mono-like crystalline portion each are greater than a twenty-first width of the seventh intermediate portion in the third direction,
a twenty-second width of the seventh mono-like crystalline portion and a twenty-third width of the eighth mono-like crystalline portion each are greater than a twenty-fourth width of the eighth intermediate portion in the second direction, and
a boundary between the sixth mono-like crystalline portion and the seventh intermediate portion, a boundary between the eighth mono-like crystalline portion and the seventh intermediate portion, a boundary between the seventh mono-like crystalline portion and the eighth intermediate portion, and a boundary between the eighth mono-like crystalline portion and the eighth intermediate portion each include a coincidence boundary.

10. The silicon block according to claim 8 or claim 9, wherein
the second direction and the third direction are orthogonal to each other.

11. The silicon block according to any one of claims 8 to 10, wherein
each of the fifth mono-like crystalline portion, the sixth mono-like crystalline portion, the seventh mono-like crystalline portion, the one or more mono-like crystalline sections included in the fifth intermediate portion, and the one or more mono-like crystalline sections included in the sixth intermediate portion has a crystal direction parallel to the first direction with Miller indices of <100>.

12. The silicon block according to claim 11, wherein
the coincidence boundary includes a Σ29 coincidence boundary.

13. The silicon block according to any one of claims 8 to 12, wherein
the silicon block has at least one of a width relationship in which the thirteenth width is different from the fourteenth width or a width relationship in which the sixteenth width is different from the seventeenth width.

14. The silicon block according to any one of claims 8 to 13, further comprising:
a third portion including a third end; and
a fourth portion including a fourth end opposite to the third end,
wherein the third portion has a higher ratio of Σ29 coincidence boundaries than the fourth portion, and
the fourth portion has a higher ratio of Σ5 coincidence boundaries than the third portion.

15. A silicon substrate having a seventh surface, an eighth surface opposite to the seventh surface, and a ninth surface extending in a first direction and connecting the seventh surface and the eighth surface, the silicon substrate comprising:
a ninth mono-like crystalline portion;
a ninth intermediate portion including one or more mono-like crystalline sections;
a tenth mono-like crystalline portion;
a tenth intermediate portion including one or more mono-like crystalline sections; and
an eleventh mono-like crystalline portion,
wherein the ninth mono-like crystalline portion, the ninth intermediate portion, and the tenth mono-like crystalline portion are adjacent to one another in sequence in a second direction perpendicular to the first direction,
the ninth mono-like crystalline portion, the tenth intermediate portion, and the eleventh mono-like crystalline portion are adjacent to one another in sequence in a third direction perpendicular to the first direction and crossing the second direction,
a twenty-fifth width of the ninth mono-like crystalline portion and a twenty-sixth width of the tenth mono-like crystalline portion each are greater than a twenty-seventh width of the ninth intermediate portion in the second direction,
a twenty-eighth width of the ninth mono-like crystalline portion and a twenty-ninth width of the eleventh mono-like crystalline portion each are greater than a thirtieth width of the tenth intermediate portion in the third direction, and
a boundary between the ninth mono-like crystalline portion and the ninth intermediate portion, a boundary between the tenth mono-like crystalline portion and the ninth intermediate portion, a boundary between the ninth mono-like crystalline portion and the tenth intermediate portion, and a boundary between the eleventh mono-like crystalline portion and the tenth intermediate portion each include a coincidence boundary.

16. The silicon substrate according to claim 15, further comprising:
an eleventh intermediate portion including one or more mono-like crystalline sections;
a twelfth mono-like crystalline portion; and
a twelfth intermediate portion including one or more mono-like crystalline sections,
wherein the tenth mono-like crystalline portion, the eleventh intermediate portion, and the twelfth mono-like crystalline portion are adjacent to one another in sequence in the third direction,
the eleventh mono-like crystalline portion, the twelfth intermediate portion, and the twelfth mono-like crystalline portion are adjacent to one another in sequence in the second direction,
a thirty-first width of the tenth mono-like crystalline portion and a thirty-second width of the twelfth mono-like crystalline portion each are greater than a thirty-third width of the eleventh intermediate portion in the third direction,
a thirty-fourth width of the eleventh mono-like crystalline portion and a thirty-fifth width of the twelfth mono-like crystalline portion each are greater than a thirty-sixth width of the twelfth intermediate portion in the second direction, and
a boundary between the tenth mono-like crystalline portion and the eleventh intermediate portion, a boundary between the twelfth mono-like crystalline portion and the eleventh intermediate portion, a boundary between the eleventh mono-like crystalline portion and the twelfth intermediate portion, and a boundary between the twelfth mono-like crystalline portion and the twelfth intermediate portion each include a coincidence boundary.

17. The silicon substrate according to claim 15 or claim 16, wherein
the second direction and the third direction are orthogonal to each other.

18. The silicon substrate according to any one of claims 15 to 17, wherein
each of the ninth mono-like crystalline portion, the tenth mono-like crystalline portion, the eleventh mono-like crystalline portion, the one or more mono-like crystalline sections included in the ninth intermediate portion, and the one or more mono-like crystalline sections included in the tenth intermediate portion has a crystal direction parallel to the first direction with Miller indices of <100>.

19. The silicon substrate according to claim 18, wherein
the coincidence boundary includes a Σ29 coincidence boundary.

20. A manufacturing method for a silicon ingot, the method comprising:
preparing a mold having an opening being open in a first direction;
arranging, on a bottom of the mold, a first seed crystal of monocrystalline silicon, a first intermediate seed crystal including one or more silicon monocrystals and having a less width than the first seed crystal in a second direction perpendicular to the first direction, and a second seed crystal of monocrystalline silicon having a greater width than the first intermediate seed crystal in the second direction adjacent to one another in sequence in the second direction, and arranging, on the bottom of the mold, the first seed crystal, a second intermediate seed crystal including one or more silicon monocrystals and having a less width than the first seed crystal in a third direction perpendicular to the first direction and crossing the second direction, and a third seed crystal of monocrystalline silicon having a greater width than the second intermediate seed crystal in the third direction adjacent to one another in sequence in the third direction;
pouring silicon melt into the mold containing the first seed crystal, the second seed crystal, the third seed crystal, the first intermediate seed crystal, and the second intermediate seed crystal heated to a temperature around a melting point of silicon, or melting, in the mold, a silicon lump into silicon melt on the first seed crystal, the second seed crystal, the third seed crystal, the first intermediate seed crystal, and the second intermediate seed crystal; and
unidirectionally solidifying the silicon melt upward from the bottom of the mold,
wherein the first seed crystal, the second seed crystal, the third seed crystal, the first intermediate seed crystal, and the second intermediate seed crystal are arranged to allow each of a first rotation angle relationship of silicon monocrystals between the first seed crystal and the first intermediate seed crystal about an imaginary axis parallel to the first direction, a second rotation angle relationship of silicon monocrystals between the second seed crystal and the first intermediate seed crystal about an imaginary axis parallel to the first direction, a third rotation angle relationship of silicon monocrystals between the first seed crystal and the second intermediate seed crystal about an imaginary axis parallel to the first direction, and a fourth rotation angle relationship of silicon monocrystals between the third seed crystal and the second intermediate seed crystal about an imaginary axis parallel to the first direction to be a rotation angle relationship of silicon monocrystals corresponding to a coincidence boundary.

21. The manufacturing method according to claim 20, wherein
the arranging includes arranging the second crystal, a third intermediate seed crystal including one or more silicon monocrystals and having a less width than the second seed crystal in the third direction, and a fourth seed crystal of monocrystalline silicon having a greater width than the third intermediate seed crystal in the third direction adjacent to one another in sequence in the third direction, and arranging the third seed crystal, a fourth intermediate seed crystal including one or more silicon monocrystals and having a less width than the third seed crystal in the second direction, and the fourth seed crystal of monocrystalline silicon having a greater width than the fourth intermediate seed crystal in the second direction adjacent to one another in sequence in the second direction,
the pouring includes pouring silicon melt into the mold containing the first seed crystal, the second seed crystal, the third seed crystal, the fourth seed crystal, the first intermediate seed crystal, the second intermediate seed crystal, the third intermediate seed crystal, and the fourth intermediate seed crystal heated to a temperature around the melting point of silicon, or the melting includes melting, in the mold, a silicon lump into silicon melt on the first seed crystal, the second seed crystal, the third seed crystal, the fourth seed crystal, the first intermediate seed crystal, the second intermediate seed crystal, the third intermediate seed crystal, and the fourth intermediate seed crystal, and
the second seed crystal, the third seed crystal, the fourth seed crystal, the third intermediate seed crystal, and the fourth intermediate seed crystal are arranged to allow each of a fifth rotation angle relationship of silicon monocrystals between the second seed crystal and the third intermediate seed crystal about an imaginary axis parallel to the first direction, a sixth rotation angle relationship of silicon monocrystals between the fourth seed crystal and the third intermediate seed crystal about an imaginary axis parallel to the first direction, a seventh rotation angle relationship of silicon monocrystals between the third seed crystal and the fourth intermediate seed crystal about an imaginary axis parallel to the first direction, and an eighth rotation angle relationship of silicon monocrystals between the fourth seed crystal and the fourth intermediate seed crystal about an imaginary axis parallel to the first direction to be a rotation angle relationship of silicon monocrystals corresponding to a coincidence boundary.

22. The manufacturing method according to claim 20 or claim 21, wherein
the second direction and the third direction are orthogonal to each other.

23. The manufacturing method according to claim 22, wherein
the first seed crystal, the second seed crystal, the third seed crystal, the first intermediate seed crystal, and the second intermediate seed crystal are arranged with upper surfaces of the seed crystals having Miller indices of (100) facing in the first direction.

24. The manufacturing method according to claim 23, wherein
the first seed crystal, the second seed crystal, the third seed crystal, the first intermediate seed crystal, and the second intermediate seed crystal are arranged to allow each of the first rotation angle relationship, the second rotation angle relationship, the third rotation angle relationship, and the fourth rotation angle relationship to be a rotation angle relationship of silicon monocrystals corresponding to a Σ29 coincidence boundary about an imaginary rotation axis parallel to a direction having Miller indices of <100>.

25. The manufacturing method according to any one of claims 20 to 24, wherein
the arranging includes arranging the first seed crystal, the second seed crystal, and the third seed crystal to satisfy at least one of a state in which the first seed crystal has a width different from a width of the second seed crystal in the second direction or a state in which the first seed crystal has a width different from a width of the third seed crystal in the third direction.

26. A solar cell, comprising:
the silicon substrate according to any one of claims 15 to 19; and
an electrode on the silicon substrate.
